# EUROPEAN PATENT APPLICATION

(11) **EP 4 059 942 A1**
(43) Date of publication of application: **21.09.2022**
(21) Application number: 22161706.1
(22) Date of filing: 11.03.2022
(51) Int. Cl.: C07F 15/00, C09K 11/06, H01L 51/00, H01L 51/50

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**

(30) Priority: 15.03.2021 KR 20210033629
(71) Applicant: Samsung Electronics Co., Ltd., Gyeonggi-do, 16677 (KR)
(72) Inventor: KANG, Byungjoon, 16678 Suwon-si (KR); KIM, Sangdong, 16678 Suwon-si (KR); LEE, Kum Hee, 16678 Suwon-si (KR); LEE, Banglin, 16678 Suwon-si (KR); CHO, Hwayoung, 16678 Suwon-si (KR); CHOI, Byoungki, 16678 Suwon-si (KR); HWANG, Kyuyoung, 16678 Suwon-si (KR)
(74) Representative: Elkington and Fife LLP

(57) **Abstract**

An organometallic compound represented by Formula 1:

Formula 1 M(L₁)ₙ₁(L₂)ₙ₂.

wherein M is a transition metal, L₁ is a ligand represented by Formula 2-1, L₂ is a ligand represented by Formula 2-2, n1 and n2 are each independently 1 or 2, a sum of n1 and n2 is 2 or 3, and L₁ and L₂ are different from each other: 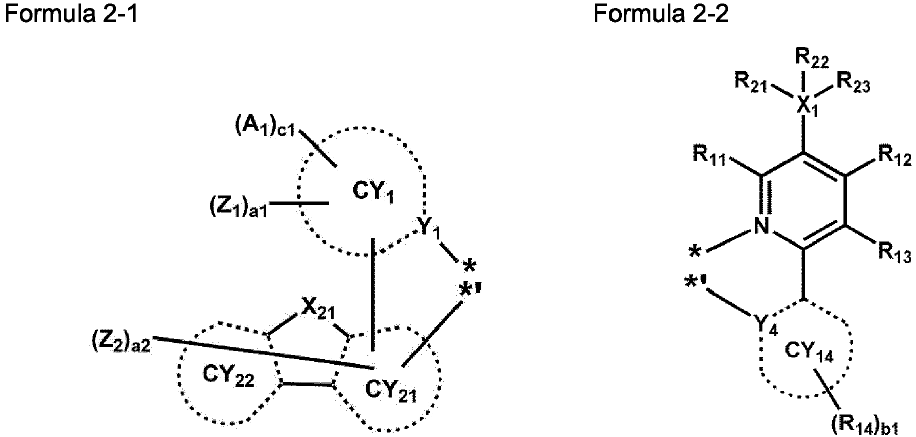 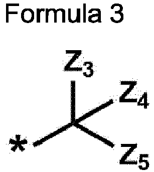 wherein Y₁, Y₄, X₁, X₂₁, ring CY₁, ring CY₂₁, ring CY₂₂, ring CY₁₄,A₁, a1, a2, b1, c1, R₁₁ to R₁₄, R₂₁ to R₂₃, and Z₁ to Z₅ are as defined in the specification, * and *' in Formulae 2-1 and 2-2 each indicates a binding site to M, and * in Formula 3 indicates a binding site to ring CY₁ in Formula 2-1.

## Description

### FIELD OF THE INVENTION

One or more embodiments relate to an organometallic compound, an organic light-emitting device including the same, and an electronic apparatus including the organic light-emitting device.

### BACKGROUND OF THE INVENTION

Organic light-emitting devices (OLEDs) are self-emissive devices, which have improved characteristics in terms of viewing angles, response time, brightness, driving voltage, and response speed, and produce full-color images.

In an example, an organic light-emitting device includes an anode, a cathode, and an organic layer located between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. The excitons may transition from an excited state to a ground state, thus generating light.

### SUMMARY OF THE INVENTION

One or more embodiments relate to an organometallic compound, an organic light-emitting device including the same, and an electronic apparatus including the organic light-emitting device.

Additional aspects will be set forth in part in the description which follows and, in part, will be apparent from the description, or may be learned by practice of the presented embodiments of the disclosure.

According to an aspect, an organometallic compound represented by Formula 1 is provided:

Formula 1 M(L₁)ₙ₁(L₂)ₙ₂

wherein, in Formula 1,
M is a transition metal,
L₁ is a ligand represented by Formula 2-1,
L₂ is a ligand represented by Formula 2-2,
n1 and n2 are each independently 1 or 2, wherein, when n1 is 2, each L₁ is identical to or different from another, and when n2 is 2, each L₂ is identical to or different from another,
a sum of n1 and n2 is 2 or 3,
L₁ and L₂ are different from each other, 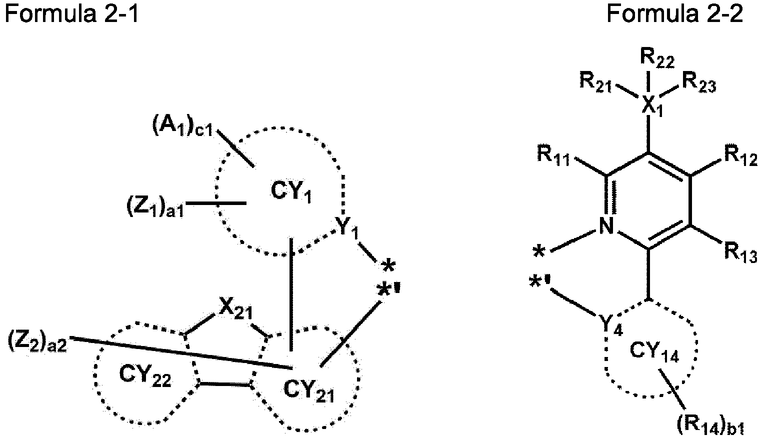 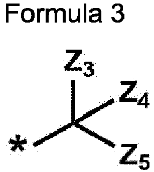
wherein, in Formulae 2-1, 2-2, and 3,
Y₁ and Y₄ are each independently C or N,
X₁ is Si or Ge,
X₂₁ is O, S, S(=O), N(Z₂₉), C(Z₂₉)(Z₃₀), or Si(Z₂₉)(Z₃₀),
ring CY₁, ring CY₂₁, ring CY₂₂, and ring CY₁₄ are each independently a C₅-C₃₀ carbocyclic group or a C₁-C₃₀ heterocyclic group,
A₁ is a group represented by Formula 3, and A₁ is not -CD₃, c1 is an integer from 1 to 20,
R₂₁ to R₂₃ are each independently a C₁-C₆₀ alkyl group or a C₆-C₆₀ aryl group, unsubstituted or substituted with at least one of deuterium, -F, -CI, -Br, -I, - SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or a combination thereof,
Z₁ to Z₅, R₁₁ to R₁₄, Z₂₉, and Z₃₀ are each independently hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₅₀ alkyl aryl group, a substituted or unsubstituted C₇-C₅₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, - N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
provided that at least one of Z₃ to Z₅ of Formula 3 is deuterium or a deuterated group,
provided that in Formula 2-2,
R₁₂ is hydrogen, deuterium, a methyl group, or a deuterated methyl group; or
R₁₂ and R₁₃ are linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
a1, a2, and b1 are each independently an integer from 0 to 20, and when a1 is 2 or more, two or more of Z₁(s) are identical to or different from each other, when a2 is 2 or more, two or more of Z₂(s) are identical to or different from each other, and when b1 is 2 or more, two or more of R₁₄(s) are identical to or different from each other,
two or more of R₂₁ to R₂₃ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of Z₁(s) are optionally linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
two or more of a plurality of Z₂(s) are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of Z₃ to Z₅ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₁₄(s) are optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of Z₁, Z₂ and R₁₁ to R₁₄ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
R₁₀ₐ is as defined in connection with R₁₄,
   * and *' in Formulae 2-1 and 2-2 each indicates a binding site to M in Formula 1,
   * in Formula 3 indicates a binding site to ring CY₁ in Formula 2-1, and
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₅₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
   deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
   a C₁-C₆₀ alkyl group, a C₂-C₆₀ alkenyl group, a C₂-C₆₀ alkynyl group, a C₁-C₅₀ alkoxy group, or a C₁-C₆₀ alkylthio group, each substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₅₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₅₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -CI, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₅₀ alkyl aryl group, a C₇-C₅₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), - B(Q₂₆)(Q₂₇), -P(=O)(Q₂₈)(Q₂₉), -P(Q₂₈)(Q₂₉), or a combination thereof;
   -N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
   a combination thereof,
wherein Q₁ to Q₉, Q₁₁ to Q₁₉, Q₂₁ to Q₂₉, and Q₃₁ to Q₃₉ are each independently: hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₅₀ alkyl aryl group, a substituted or unsubstituted C₇-C₅₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

According to another aspect, provided is an organic light-emitting device including a first electrode, a second electrode, and an organic layer located between the first electrode and the second electrode and including an emission layer, wherein the organic layer includes at least one organometallic compound represented by Formula 1.

The organometallic compound may be included in the emission layer of the organic layer, and the organometallic compound included in the emission layer may act as a dopant.

Another aspect provides an electronic apparatus including the organic light-emitting device.

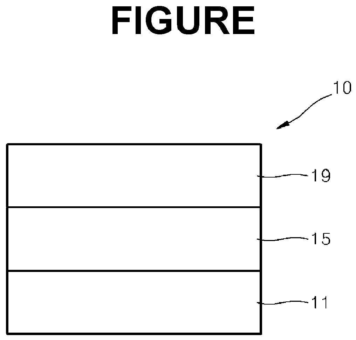

### BRIEF DESCRIPTION OF THE DRAWING

The above and other aspects, features, and advantages of certain exemplary embodiments of the disclosure will be more apparent from the following detailed description taken in conjunction with the FIGURE, which is a schematic view of an organic light-emitting device according to one or more embodiments.

### DETAILED DESCRIPTION OF THE EMBODIMENTS

Reference will now be made in further detail to exemplary embodiments, examples of which are illustrated in the accompanying drawing, wherein like reference numerals refer to like elements throughout. In this regard, the present exemplary embodiments may have different forms and should not be construed as being limited to the descriptions set forth herein. Accordingly, the exemplary embodiments are merely described in detail below, by referring to the figure, to explain aspects.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Hereinafter, a work function or a highest occupied molecular orbital (HOMO) energy level is expressed as an absolute value from a vacuum level. In addition, when the work function or the HOMO energy level is referred to be "deep," "high" or "large," the work function or the HOMO energy level has a large absolute value based on "0 eV" of the vacuum level, while when the work function or the HOMO energy level is referred to be "shallow," "low," or "small," the work function or HOMO energy level has a small absolute value based on "0 eV" of the vacuum level.

The organometallic compound is represented by Formula 1:

Formula 1 M(L₁)ₙ₁(L₂)ₙ₂

M in Formula 1 is a transition metal.

For example, M may be a Period 1 transition metal of the Periodic Table of the Elements, a Period 2 transition metal of the Periodic Table of the Elements, or a Period 3 transition metal of the Periodic Table of the Elements.

In one or more embodiments, M may be iridium (Ir), platinum (Pt), osmium (Os), titanium (Ti), zirconium (Zr), hafnium (Hf), europium (Eu), terbium (Tb), thulium (Tm), or rhodium (Rh).

In one or more embodiments, M may be Ir, Pt, Os, or Rh.

L₁ in Formula 1 is a ligand represented by Formula 2-1, and n1 in Formula 1 indicates the number of L₁ in Formula 1 and is 1 or 2. When n1 is 2, two L₁(s) are identical to or different from each other.

L₂ in Formula 1 is a ligand represented by Formula 2-2, and n2 in Formula 1 indicates the number of L₂ in Formula 1 and is 1 or 2. When n2 is 2, two L₂(s) are identical to or different from each other.

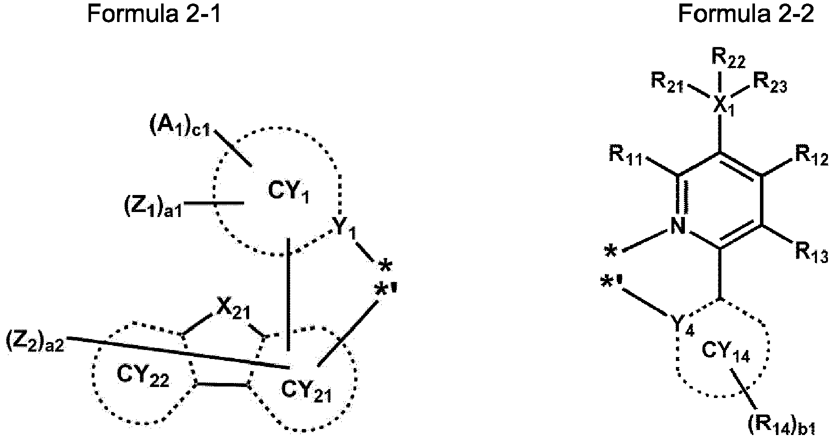

Formulae 2-1 and 2-2 are as described herein.

L₁ and L₂ in Formula 1 are different from each other. That is, the organometallic compound represented by Formula 1 is a heteroleptic complex.

The sum of n1 and n2 is 2 or 3.

In one or more embodiments, M may be Ir, and the sum of n1 and n2 may be 3; or M may be Pt, and the sum of n1 and n2 may be 2.

Y₁ and Y₄ in Formula 2-2 are each independently C or N.

For example, Y₁ in Formula 2-1 may be N, and Y₄ in Formula 2-2 may be C.

X₁ in Formula 2-2 is Si or Ge.

X21 in Formula 2-1 is O, S, S(=O), N(Z29), C(Z₂₉)(Z₃₀), or Si(Z₂₉)(Z₃₀). Z₂₉ and Z₃₀ are each as described in the present specification.

For example, X₂₁ in Formula 2-1 may be O or S.

In one or more embodiments, X₂₁ in Formula 2-1 may be O.

In one or more embodiments, X₂₁ in Formula 2-1 may be S.

Ring CY₁, ring CY₂₁, ring CY₂₂, and ring CY₁₄ in Formulae 2-1 and 2-2 are each independently a C₅-C₃₀ carbocyclic group or a C₁-C₃₀ heterocyclic group.

For example, ring CY₁, ring CY₂₁, ring CY₂₂, and ring CY₁₄ in Formulae 1-1 and 1-2 may each independently be i) a first ring, ii) a second ring, iii) a condensed ring in which two or more first rings are condensed with each other, iv) a condensed ring in which two or more second rings are condensed with each other, or v) a condensed ring in which one or more first rings and one or more second rings are condensed with each other,
the first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In one or more embodiments, ring CY₁, ring CY₂₁, ring CY₂₂, and ring CY₁₄ in Formulae 2-1 and 2-2 may each independently be a cyclopentane group, a cyclohexane group, a cycloheptane group, a cyclopentene group, a cyclohexene group, a cycloheptene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, a norbornene group, a benzene group condensed with an adamantane group, a benzene group condensed with a norbornane group, a pyridine group condensed with an adamantane group, or a pyridine group condensed with a norbornane group.

In one or more embodiments, ring CY₁, ring CY₂₁, ring CY₂₂, and ring CY₁₄ in Formulae 2-1 and 2-2 may each independently be a benzene group, a naphthalene group, a 1, 2, 3, 4-tetrahydronaphthalene group, a phenanthrene group, an anthracene group, a pyridine group, a pyrimidine group, a pyrazine group, a triazine group, a benzofuran group, a benzothiophene group, a fluorene group, a carbazole group, a dibenzofuran group, a dibenzothiophene group, a dibenzosilole group, an azafluorene group, an azacarbazole group, an azadibenzofuran group, an azadibenzothiophene group, an azadibenzosilole group, a quinoline group, an isoquinoline group, a quinoxaline group, a quinazoline group, a benzoquinoline group, a benzoisoquinoline group, a benzoquinoxaline group, or a benzoquinazoline group.

In one or more embodiments, ring CY₁ in Formula 2-1 may be a pyridine group, a 5,6,7,8-tetrahydroisoquinoline group, or a 5,6,7,8-tetrahydroquinoline group.

In one or more embodiments, ring CY₂₁ in Formula 2-1 may be a benzene group, a naphthalene group, a 1,2,3,4-tetrahydronaphthalene group, a pyridine group, or a pyrimidine group.

In one or more embodiments, ring CY₂₂ in Formula 2-1 may be a benzene group, a naphthalene group, a 1,2,3,4-tetrahydronaphthalene group, a phenanthrene group, an anthracene group, a pyridine group, a pyrimidine group, a benzofuran group, a benzothiophene group, a dibenzofuran group, a dibenzothiophene group, an azadibenzofuran group, an azadibenzothiophene group, a quinoline group, an isoquinoline group, a quinoxaline group, a quinazoline group, a benzoquinoline group, a benzoisoquinoline group, a benzoquinoxaline group, or a benzoquinazoline group.

In one or more embodiments, ring CY₁₄ in Formulae 2-2 may be a benzene group, a naphthalene group, a 1,2,3,4-tetrahydronaphthalene group, a dibenzothiophene group, a dibenzofuran group, or a pyridine group.

M of Formula 1 may be bonded to carbon of ring CY₂₁ of Formula 2-1.

A₁ in Formula 2-1 is a group represented by Formula 3, provided that A₁ is not - CD3:

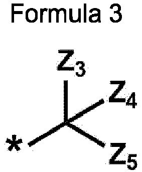

That is, a case in which all of Z₃ to Z₅ in Formula 3 are deuterium simultaneously, is excluded. In other words, at least one of Z₃ to Z₅ is not deuterium.

Details for Formula 3 are as described herein.

c1 in Formula 2-1 indicates the number of A₁(s), and is an integer from 1 to 20, for example, 1, 2, or 3. When c1 is 2 or more, two or more of A₁(s) are identical to or different from each other. In one or more embodiments, c1 may be 1.

R₂₁ to R₂₃ in Formula 2-2 are each independently a C₁-C₆₀ alkyl group or a C₆-C₆₀ aryl group, unsubstituted or substituted with at least one of deuterium, -F, -CI, -Br, -I, - SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or a combination thereof.

For example, R₂₁ to R₂₃ in Formula 2-2 may each independently be a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a phenyl group, a biphenyl group, or a naphthyl group, each unsubstituted or substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or a combination thereof.

In one or more embodiments, R₂₁ to R₂₃ in Formula 2-2 may each independently be -CH₃, -CH₂CH₃, -CD₃, -CD₂H, -CDH₂, -CH₂CD₃, or -CD₂CH₃.

In one or more embodiments, R₂₁ to R₂₃ in Formula 2-2 may be identical to each other.

In one or more embodiments, two or more of R₂₁ to R₂₃ in Formula 2-2 may be different from each other.

Z₁ to Z5, R₁₁ to R₁₄, Z₂₉, and Z₃₀ in Formulae 2-1, 2-2, and 3 are each independently hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉), provided that at least one of Z₃ to Z₅ of Formula 3 is deuterium or a deuterated group, and provided that in Formula 2-2, R₁₂ is hydrogen, deuterium, a methyl group, or a deuterated methyl group, or R₁₂ and R₁₃ are linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ. Q₁ to Q₉ are as described in the present specification.

For example, Z₁, Z₂, R₁₁, R₁₃, R₁₄, Z₂₉, and Z₃₀ in Formulae 2-1 and 2-2 may each independently be:
hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₁-C₂₀ alkoxy group, a C₁-C₂₀ alkylthio group, or a C₂-C₂₀ alkenyl group;
a C₁-C₂₀ alkyl group, a C₁-C₂₀ alkoxy group, a C₁-C₂₀ alkylthio group, or a C₂-C₂₀ alkenyl group, each substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopropyl group, a cyclobutyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopropyl group, a (C₁-C₂₀ alkyl)cyclobutyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or a combination thereof;
a cyclopropyl group, a cyclobutyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or an azadibenzothiophenyl group, each unsubstituted or substituted with at least one of deuterium, -F, -CI, - Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopropyl group, a cyclobutyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopropyl group, a (C₁-C₂₀ alkyl)cyclobutyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-Si(Q₃)(Q₄)(Q₅), or -Ge(Q₃)(Q₄)(Q₅).
a1, a2 and b1 in Formulae 2-1 and 2-2 indicate the number of Z₁(s), the number of Z₂(s), and the number of R₁₄(s), respectively, and are each independently an integer from 0 to 20. When a1 is 2 or more, two or more of Z₁(s) are identical to or different from each other, when a2 is 2 or more, two or more of Z₂(s) are identical to or different from each other, and when b1 is 2 or more, two or more of R₁₄(s) are identical to or different from each other. For example, a1, a2, and b1 may each independently be an integer from 0 to 10. In one or more embodiments, a1, a2, and b1 may each independently be 0, 1, or 2.

In one or more embodiments, Z₁ to Z₅, R₁₁, R₁₃, R₁₄, Z₂₉ and Z₃₀ in Formulae 2-1 and 2-2 may each independently be:
hydrogen, deuterium, -F, or a cyano group;
a C₁-C₂₀ alkyl group, a C₁-C₂₀ alkoxy group, a C₁-C₂₀ alkylthio group, a C₂-C₂₀ alkenyl group, a phenyl group, a naphthyl group, a pyridinyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), - Ge(Q₃₃)(Q₃₄)(Q₃₅), or a combination thereof; or
-Si(Q₃)(Q₄)(Q₅) or -Ge(Q₃)(Q₄)(Q₅).

In one or more embodiments, R₁₂ in Formula 2-2 may be hydrogen, deuterium, a methyl group, -CDH₂, -CD₂H, or -CD₃.

In one or more embodiments, R₁₂ in Formula 2-2 may be hydrogen or a methyl group.

In one or more embodiments, in relation to Formula 3,
i) Z₃ may be deuterium or a deuterated group, and each of Z₄ and Z₅ may be a deuterium-free group;
ii) each of Z₃ and Z₄ may be deuterium or a deuterated group, and Z₅ may be a deuterium-free group; or
iii) each of Z₃ to Z₅ may be deuterium or a deuterated group, provided that a case in which all of Z₃ to Z₅ are deuterium simultaneously, may be excluded. In other words, each of Z₃ to Z₅ is deuterium or a deuterated group, provided that at least one of Z₃ to Z₅ is not deuterium.

In one or more embodiments, at least one of Z₃ to Z₅ of Formula 3 may each independently be:
deuterium; or
a deuterated C₁-C₂₀ alkyl group, a deuterated C₁-C₂₀ alkoxy group, a deuterated C₁-C₂₀ alkylthio group, a deuterated C₂-C₂₀ alkenyl group, a deuterated phenyl group, a deuterated naphthyl group, a deuterated pyridinyl group, a deuterated dibenzofuranyl group, or a deuterated dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl) biphenyl group, - Si(Q₃₃)(Q₃₄)(Q₃₅), -Ge(Q₃₃)(Q₃₄)(Q₃₅), or a combination thereof; or
-Si(Q₃)(Q₄)(Q₅) or -Ge(Q₃)(Q₄)(Q₅).

In one or more embodiments, Z₃ and Z₄ in Formula 3 may each independently be:
deuterium; or
a deuterated C₁-C₂₀ alkyl group, a deuterated C₁-C₂₀ alkoxy group, a deuterated C₁-C₂₀ alkylthio group, a deuterated C₂-C₂₀ alkenyl group, a deuterated phenyl group, a deuterated naphthyl group, a deuterated pyridinyl group, a deuterated dibenzofuranyl group, or a deuterated dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl) biphenyl group, - Si(Q₃₃)(Q₃₄)(Q₃₅), -Ge(Q₃₃)(Q₃₄)(Q₃₅), or a combination thereof, and
Z5 may be:
   -F or a cyano group;
   a C₁-C₂₀ alkyl group, a C₁-C₂₀ alkoxy group, a C₁-C₂₀ alkylthio group, a C₂-C₂₀ alkenyl group, a phenyl group, a naphthyl group, a pyridinyl group, a dibenzofuranyl group, or a dibenzothiophenyl group, each unsubstituted or substituted with at least one of -F, a cyano group, a C₁-C₂₀ alkyl group, a fluorinated C₁-C₂₀ alkyl group, a C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a fluorinated phenyl group, a (C₁-C₂₀ alkyl) phenyl group, a biphenyl group, a fluorinated biphenyl group, a (C₁-C₂₀ alkyl) biphenyl group, -Si(Q₃₃)(Q₃₄)(Q₃₅), -Ge(Q₃₃)(Q₃₄)(Q₃₅) (where each of Q₃₃ to Q₃₅ may not include deuterium), or a combination thereof; or
   -Si(Q₃)(Q₄)(Q₅) or -Ge(Q₃)(Q₄)(Q₅) (wherein each of Q₃ to Q₅ may not include deuterium).

In one or more embodiments, the organometallic compound represented by Formula 1 may satisfy at least one of Condition (1) to Condition (3):
Condition (1)
   Z₁ in Formula 2-1 is not hydrogen, and a1 is an integer from 1 to 20
Condition (2)
   R₁₄ in Formula 2-2 is not hydrogen, and b1 is an integer from 1 to 20
Condition (3)
   in Formula 2-1, Z₂ is not hydrogen and a2 is an integer from 1 to 6.

In one or more embodiments, the organometallic compound represented by Formula 1 may include at least one fluoro group (-F), at least one cyano group (-CN), or a combination thereof.

In one or more embodiments, the organometallic compound represented by Formula 1 may satisfy at least one of Condition A to Condition H:
Condition A
   Z₁ in Formula 2-1 is not hydrogen, a1 is an integer from 1 to 20, and at least one of Z₁(s) in the number of a1 includes deuterium
Condition B
   Z₂ in Formula 2-1 is not hydrogen, a2 is an integer from 1 to 6, and at least one of Z₂(s) in the number of 2 includes deuterium
Condition C
   Z₂ in Formula 2-1 is not hydrogen, a2 is an integer from 1 to 6, and at least one of Z₂(s) in the number of 2 includes a fluoro group (-F)
Condition D
   Z₂ in Formula 2-1 is not hydrogen, a2 is an integer from 1 to 6, and at least one of Z₂(s) in the number of 2 includes a cyano group (-CN)
Condition E
   Z₂ in Formula 2-1 is not hydrogen, a2 is an integer from 1 to 6, and at least one of Z₂(s) in the number of a2 is a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group
Condition F
   at least one of R₂₁ to R₂₃ in Formula 2-2 includes deuterium
Condition G
   R₁₄ in Formula 2-2 is not hydrogen, b1 is an integer from 1 to 20, and at least one of R₁₄(s) in the number of b1 includes deuterium
Condition H
   R₁₄ in Formula 2-2 is not hydrogen, b1 is an integer from 1 to 20, and at least one of R₁₄(s) in the number of b1 includes a fluoro group (-F)

In one or more embodiments, in relation to Formula 2-1, Z₂ may not be hydrogen, a2 may be an integer from 1 to 3, and at least one of Z₂(s) in the number of a2 may each independently be a substituted or unsubstituted C₁-C₆₀ alkyl group, a substituted or unsubstituted C₁-C₆₀ alkoxy group, a substituted or unsubstituted C₁-C₆₀ alkylthio group, a substituted or unsubstituted C₂-C₂₀ alkenyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₇-C₅₀ alkyl aryl group, a substituted or unsubstituted C₇-C₅₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

In one or more embodiments, in relation to Formula 2-1, Z₂ is not hydrogen, a2 is an integer from 1 to 3, and at least one of Z₂(s) in the number of a2 is a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, Z₁, Z₂, R₁₁, R₁₃, R₁₄, Z₂₉, and Z₃₀ in Formulae 2-1 and 2-2 may each independently be hydrogen, deuterium, -F, a cyano group, a nitro group, -SF₅, -CH₃, -CD₃, -CD₂H, -CDH₂, -CF₃, -CF₂H, -CFH₂, -OCH₃, -OCDH₂, -OCD₂H, -OCD₃, -SCH₃, -SCDH₂, -SCD₂H, -SCD₃, a C₂-C₁₀ alkenyl group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-233, a group represented by one of Formulae 9-201 to 9-233 in which at least one hydrogen is substituted with deuterium, a group represented by one of Formulae 9-201 to 9-233 in which at least one hydrogen is substituted with -F, a group represented by one of Formulae 10-1 to 10-132, a group represented by one of Formulae 10-1 to 10-132 in which at least one hydrogen is substituted with deuterium, a group represented by one of Formulae 10-1 to 10-132 in which at least one hydrogen is substituted with -F, a group represented by one of Formulae 10-201 to 10-353, a group represented by one of Formulae 10-201 to 10-353 in which at least one hydrogen is substituted with deuterium, a group represented by one of Formulae 10-201 to 10-353 in which at least one hydrogen is substituted with -F, - Si(Q₃)(Q₄)(Q₅), or -Ge(Q₃)(Q₄)(Q₅).

In one or more embodiments, in relation to Formula 3, Z₃ may be deuterium, - CD₃, -CD₂H, -CDH₂, -OCDH₂, -OCD₂H, -OCD₃, -SCDH₂, -SCD₂H, -SCD₃, a group represented by one of Formulae 9-1 to 9-39 in which at least one hydrogen is substituted with deuterium, a group represented by one of Formulae 9-201 to 9-233 in which at least one hydrogen is substituted with deuterium, a group represented by one of Formulae 10-1 to 10-132 in which at least one hydrogen is substituted with deuterium, or a group represented by one of Formulae 10-201 to 10-353 in which at least one hydrogen is substituted with deuterium, and each of Z₄ and Z₅ may be hydrogen, -F, a cyano group, -CH₃, -CF₃, -CF₂H, -CFH₂, -OCH₃, -SCH₃, a C₂-C₁₀ alkenyl group, a group represented by one of Formulae 9-1 to 9-39, a group represented by one of Formulae 9-1 to 9-39 in which at least one hydrogen is substituted with -F, a group represented by one of Formulae 9-201 to 9-233, a group represented by one of Formulae 9-201 to 9-233 in which at least one hydrogen is substituted with -F, a group represented by one of Formulae 10-1 to 10-132, a group represented by one of Formulae 10-1 to 10-132 in which at least one hydrogen is substituted with -F, a group represented by one of Formulae 10-201 to 10-353, a group represented by one of Formulae 10-201 to 10-353 in which at least one hydrogen is substituted with -F, -Si(Q₃)(Q₄)(Q), or -Ge(Q₃)(Q₄)(Q₅).

In one or more embodiments, in relation to Formula 3, Z₃ and Z₄ may be each independently be deuterium, -CD₃, -CD₂H, -CDH₂, -OCDH₂, -OCD₂H, -OCD₃, -SCDH₂, - SCD₂H, -SCD₃, a group represented by one of Formulae 9-1 to 9-39 in which at least one hydrogen is substituted with deuterium, a group represented by one of Formulae 9-201 to 9-233 in which at least one hydrogen is substituted with deuterium, a group represented by one of Formulae 10-1 to 10-132 in which at least one hydrogen is substituted with deuterium, or a group represented by one of Formulae 10-201 to 10-353 in which at least one hydrogen is substituted with deuterium, and Z₅ may be hydrogen, - F, a cyano group, -CH₃, -CF₃, -CF₂H, -CFH₂, -OCH₃, -SCH₃, a C₂-C₁₀ alkenyl group, a group represented by one of Formulae 9-1 to 9-39, a group represented by one of Formulae 9-1 to 9-39 in which at least one hydrogen is substituted with -F, a group represented by one of Formulae 9-201 to 9-233, a group represented by one of Formulae 9-201 to 9-233 in which at least one hydrogen is substituted with -F, a group represented by one of Formulae 10-1 to 10-132, a group represented by one of Formulae 10-1 to 10-132 in which at least one hydrogen is substituted with -F, a group represented by one of Formulae 10-201 to 10-353, a group represented by one of Formulae 10-201 to 10-353 in which at least one hydrogen is substituted with -F, -Si(Q₃)(Q₄)(Q₅), or -Ge(Q₃)(Q₄)(Q₅).

In one or more embodiments, Z₃ to Z₅ in Formula 3 may each independently be deuterium, -CD₃, -CD₂H, -CDH₂, -OCDH₂, -OCD₂H, -OCD₃, -SCDH₂, -SCD₂H, -SCD₃, a group represented by one of Formulae 9-1 to 9-39 in which at least one hydrogen is substituted with deuterium, a group represented by one of Formulae 9-201 to 9-233 in which at least one hydrogen is substituted with deuterium, a group represented by one of Formulae 10-1 to 10-132 in which at least one hydrogen is substituted with deuterium, or a group represented by one of Formulae 10-201 to 10-353 in which at least one hydrogen is substituted with deuterium, provided that a case in which all of Z₃ to Z₅ are deuterium simultaneously, may be excluded:

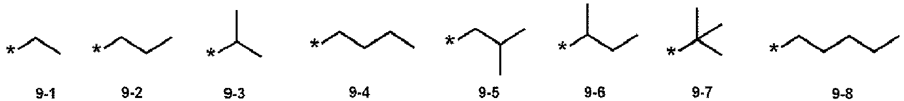

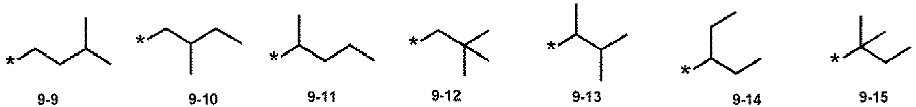

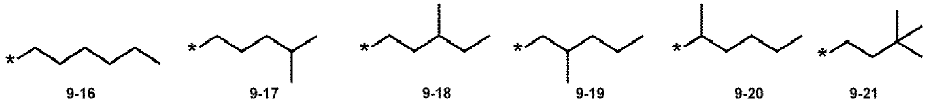

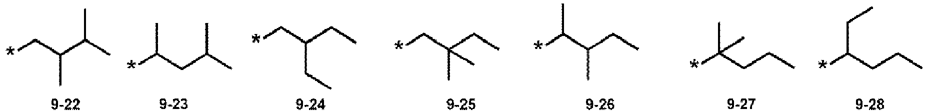

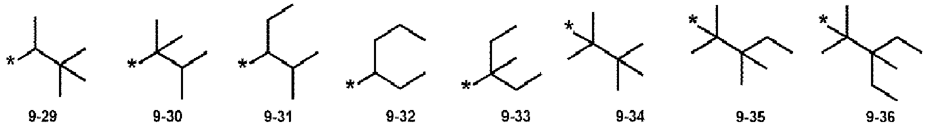

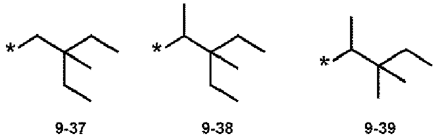

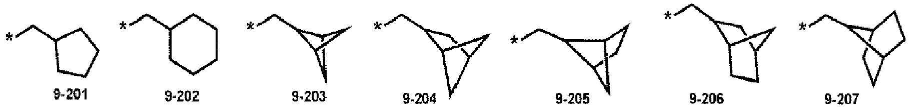

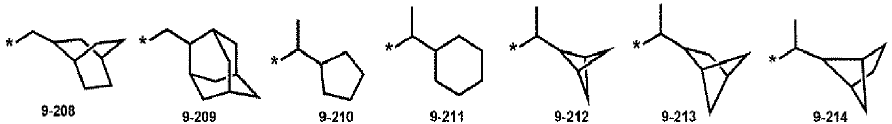

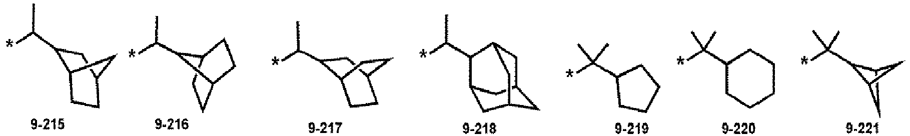

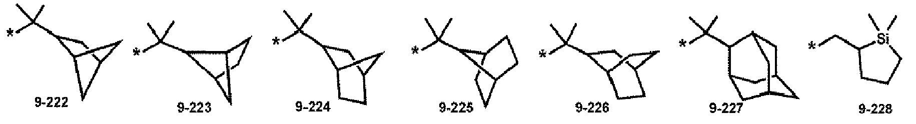

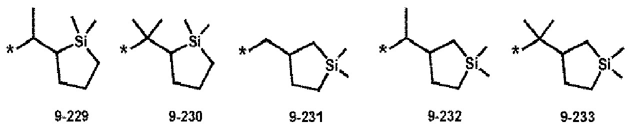

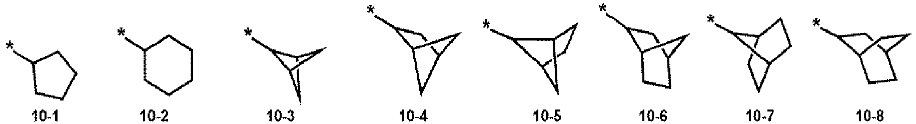

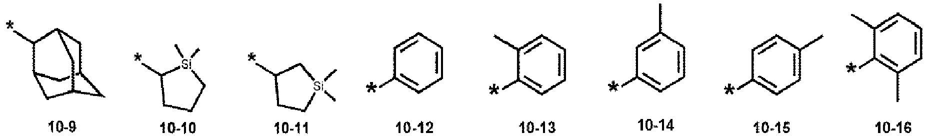

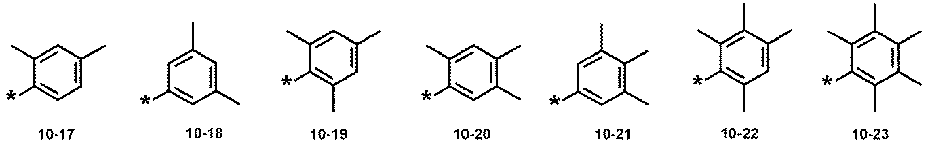

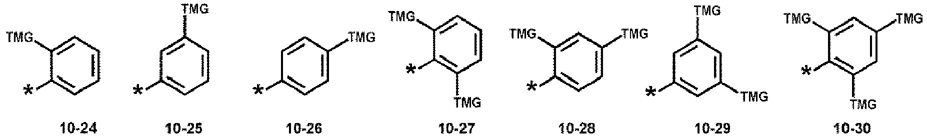

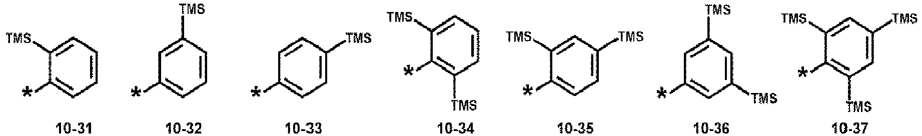

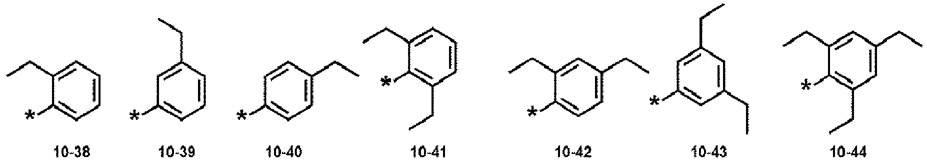

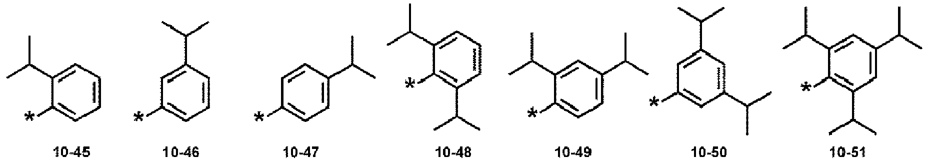

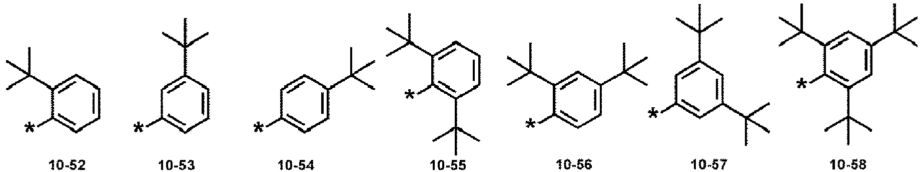

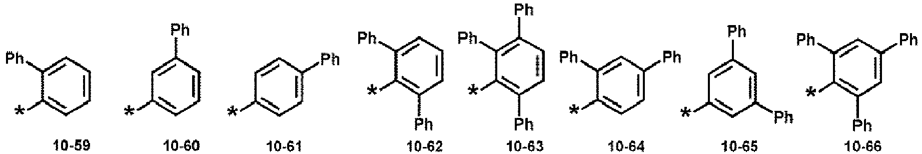

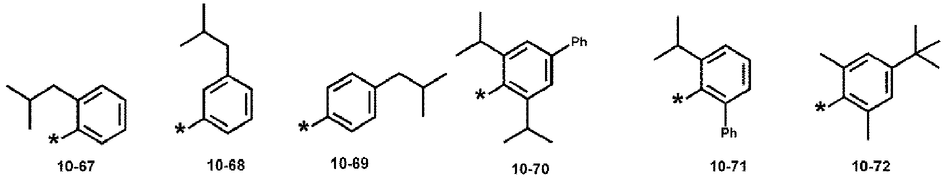

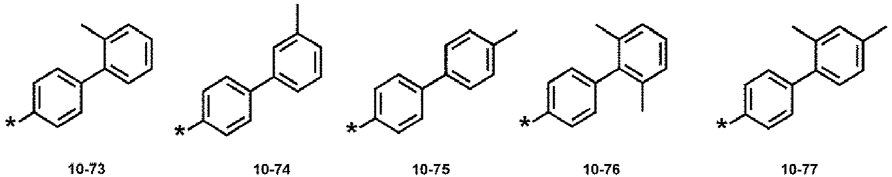

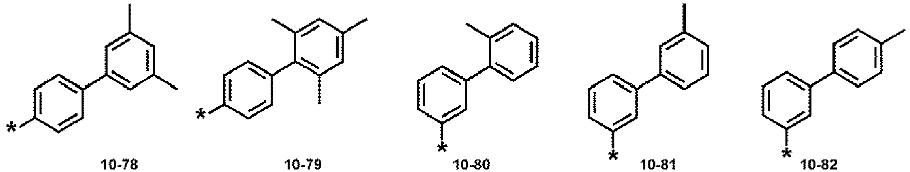

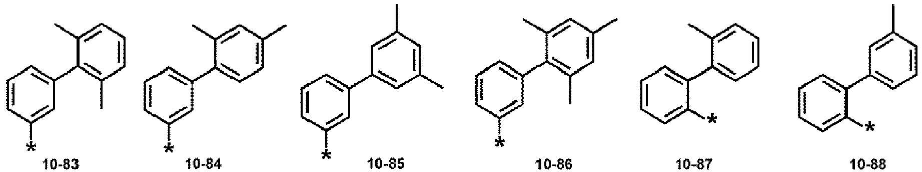

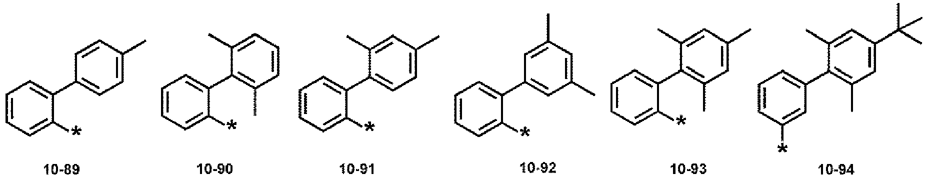

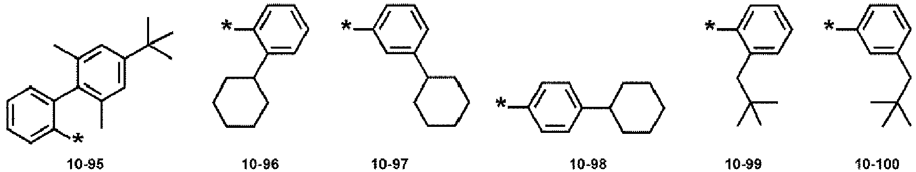

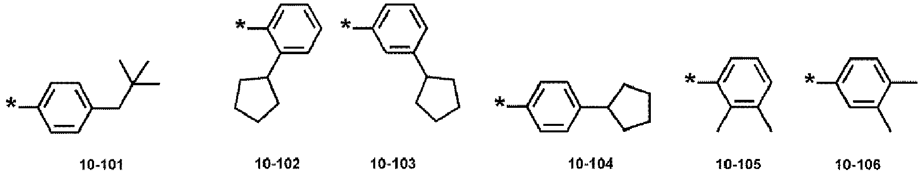

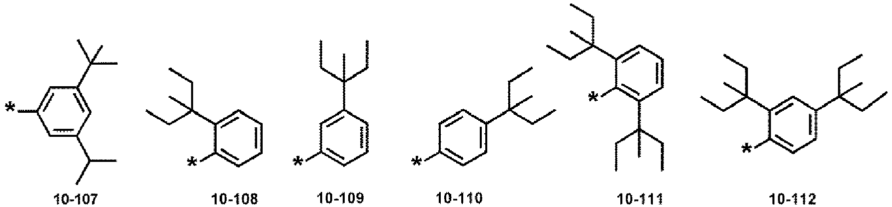

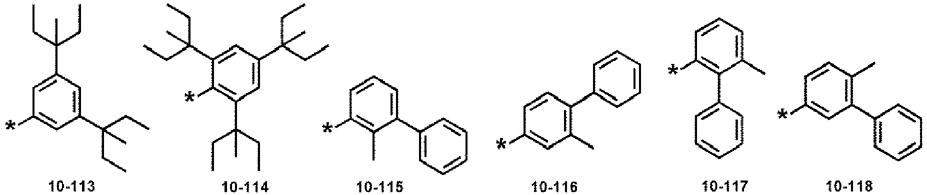

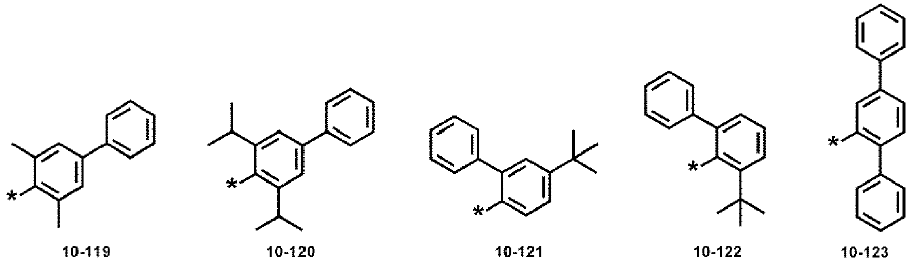

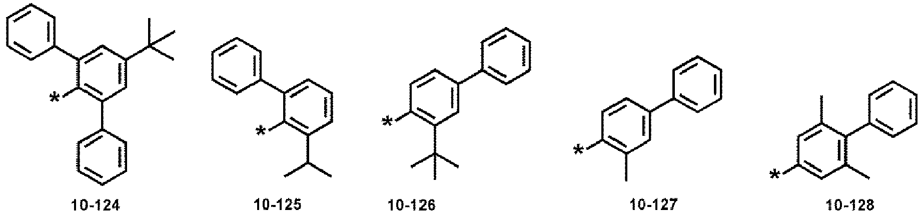

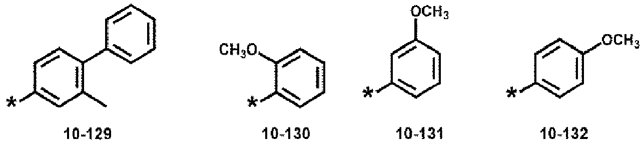

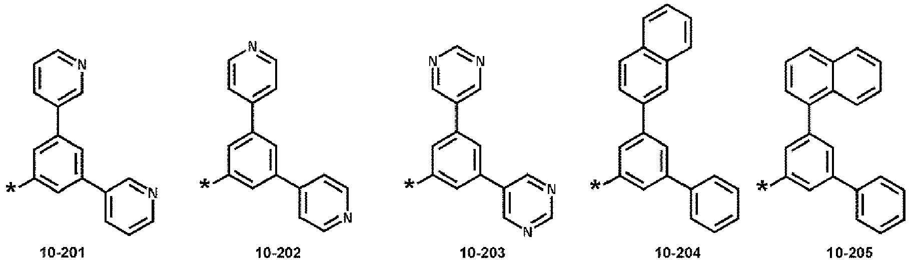

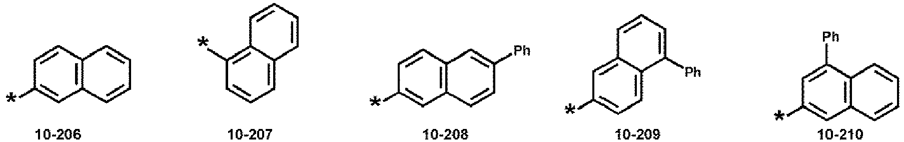

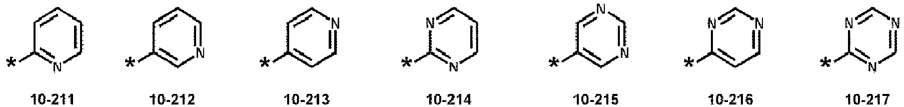

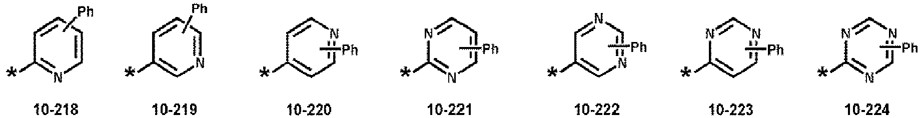

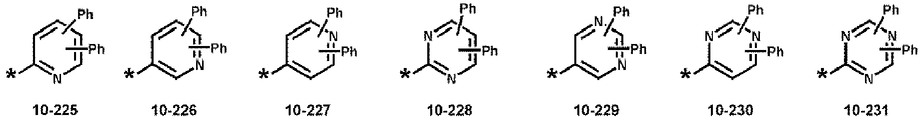

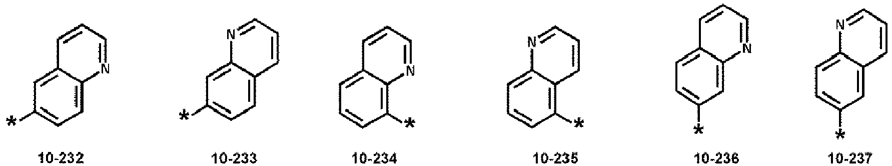

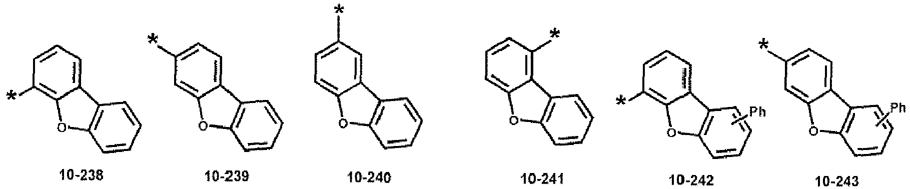

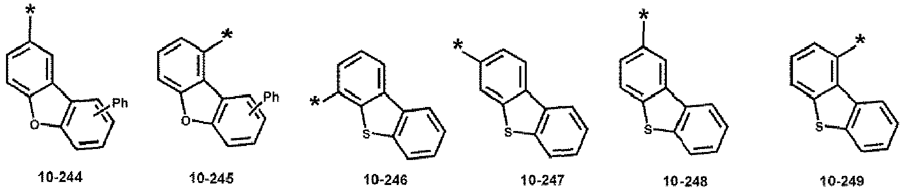

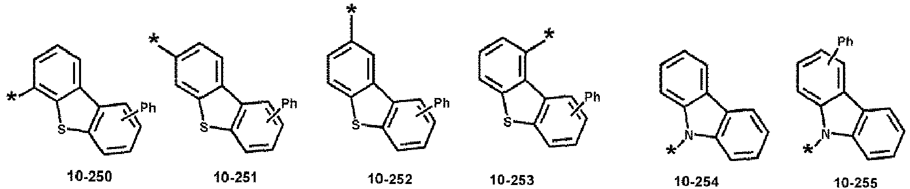

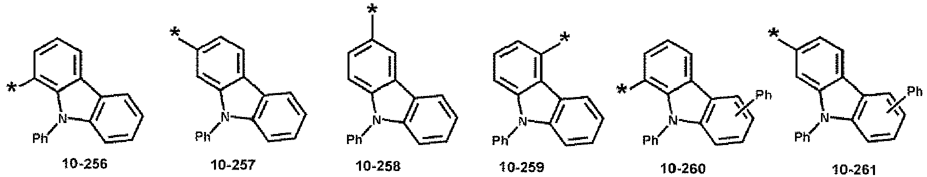

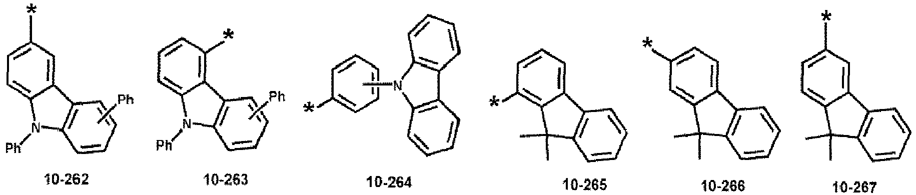

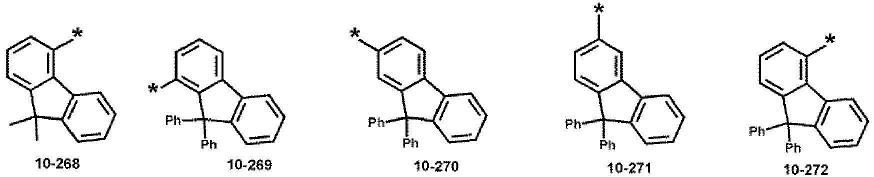

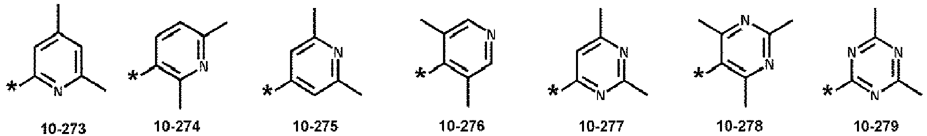

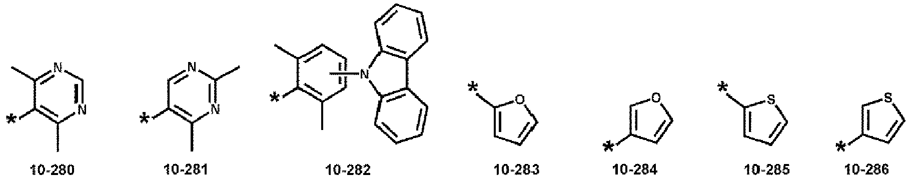

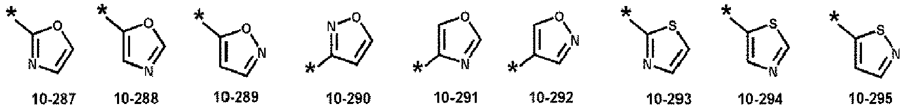

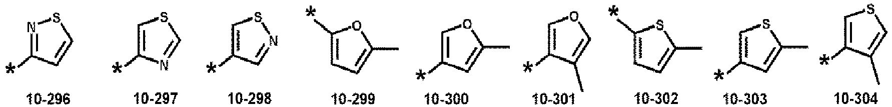

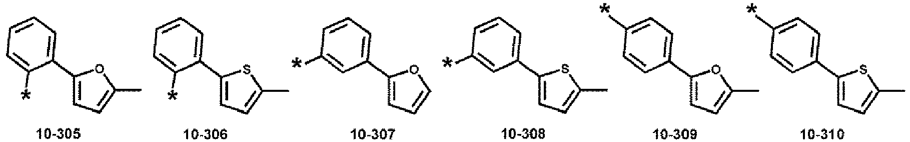

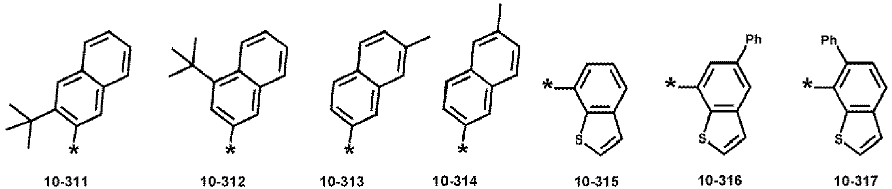

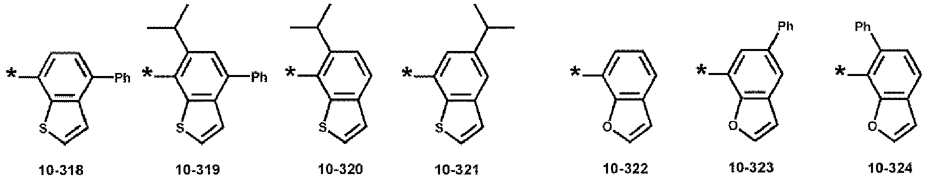

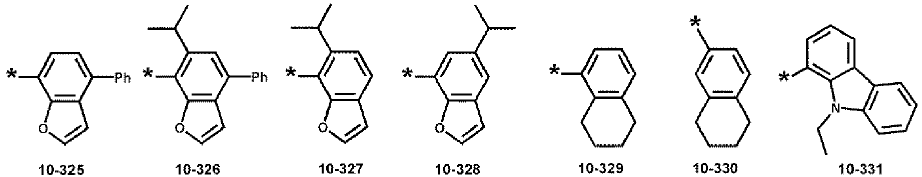

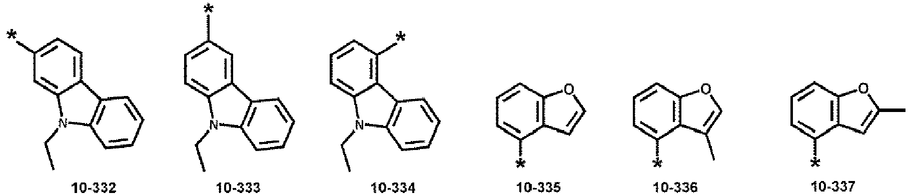

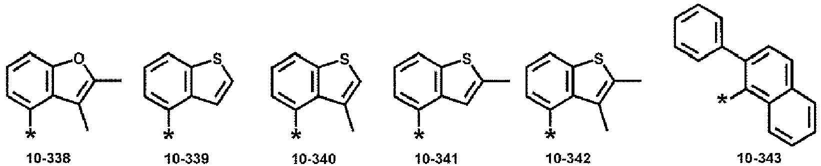

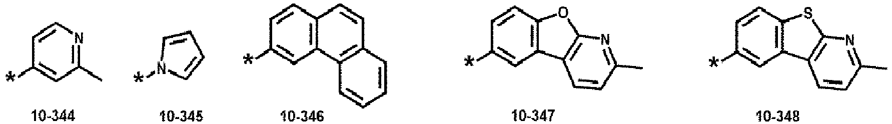

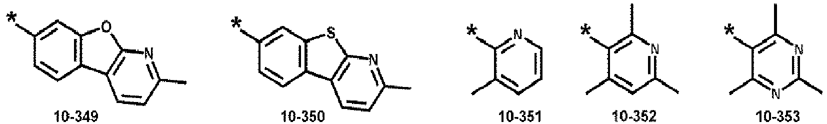

In Formulae 9-1 to 9-39, 9-201 to 9-233, 10-1 to 10-132, and 10-201 to 10-353, * indicates a binding site to a neighboring atom, "Ph" is a phenyl group, "TMS" is a trimethylsilyl group, "TMG" is a trimethylgermyl group, and "OMe" is a methoxy group.

The "group represented by one of Formulae 9-1 to 9-39 in which at least one hydrogen is substituted with deuterium" and the "group represented by one of Formulae 9-201 to 9-233 in which at least one hydrogen is substituted with deuterium" may be, for example, a group represented by one of Formulae 9-501 to 9-514 or 9-601 to 9-635:

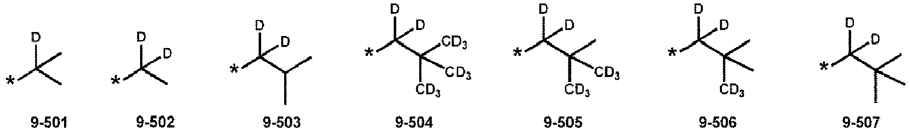

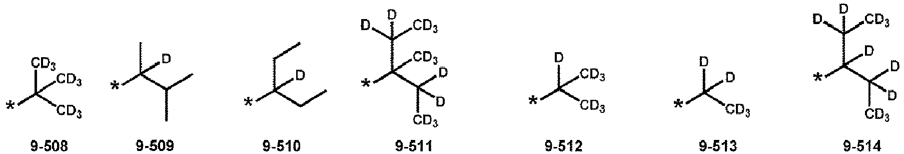

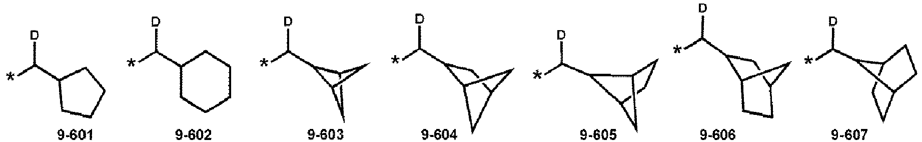

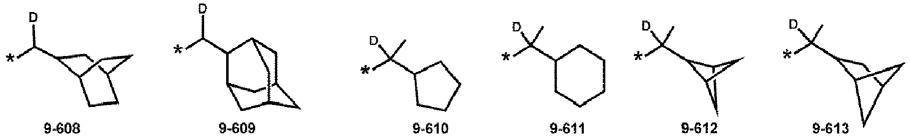

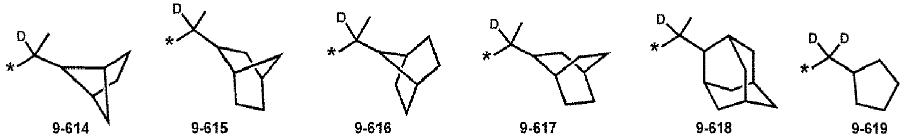

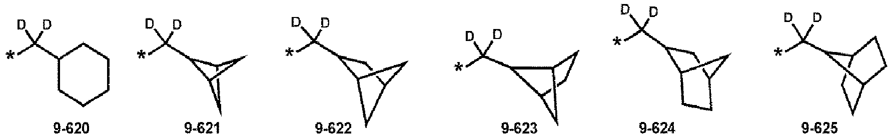

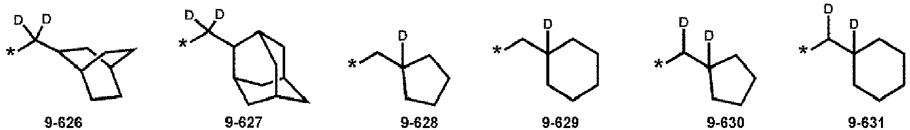

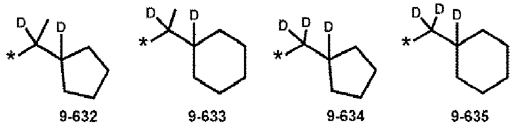

In one or more embodiments, A₁ in Formula 2-1 may be a group represented by one of Formulae 9-501 to 9-514 or 9-601 to 9-635.

The "group represented by one of Formulae 9-1 to 9-39 in which at least one hydrogen is substituted with -F" and the "group represented by one of Formulae 9-201 to 9-233 in which at least one hydrogen is substituted with -F" may each be, for example, a group represented by one of Formulae 9-701 to 9-710:

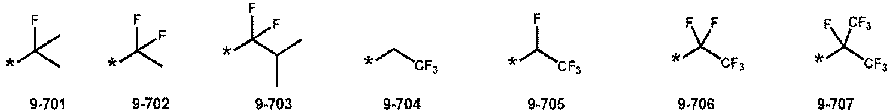

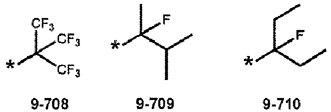

The "group represented by one of Formulae 10-1 to 10-132 in which at least one hydrogen is substituted with deuterium" and "the group represented by one of Formulae 10-201 to 10-353 in which at least one hydrogen is substituted with deuterium" may be, for example, a group represented by one of Formulae 10-501 to 10-553:

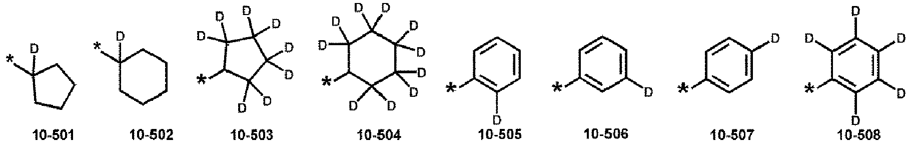

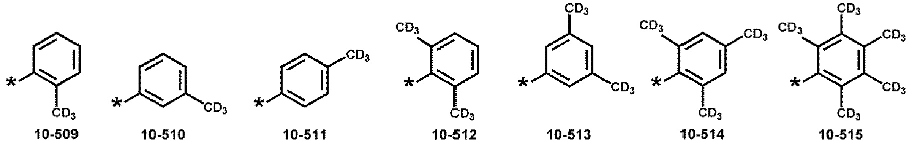

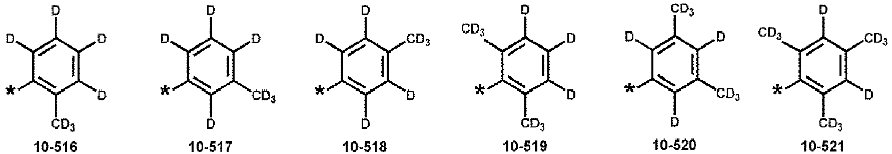

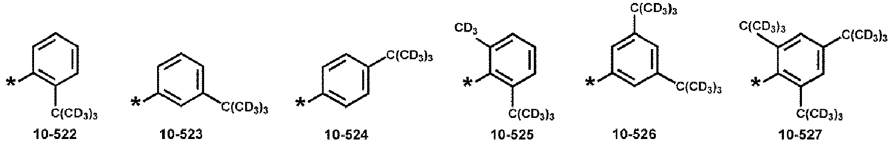

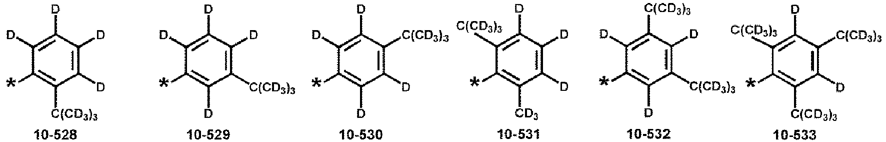

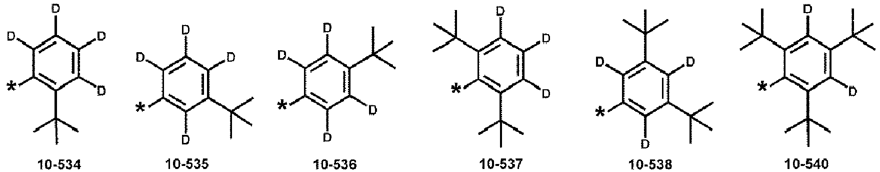

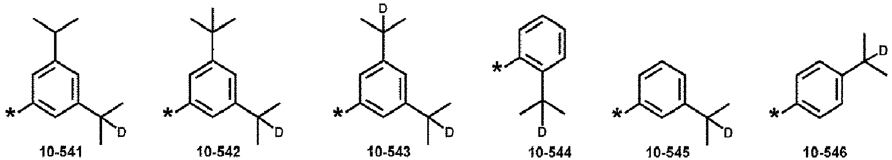

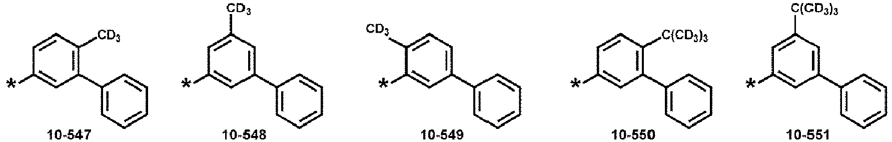

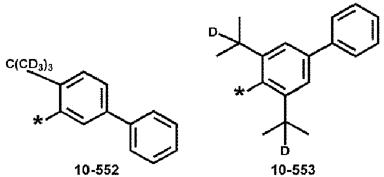

The "group represented by one of Formulae 10-1 to 10-132 in which at least one hydrogen is substituted with -F" and the "group represented by one of Formulae 10-201 to 10-353 in which at least one hydrogen is substituted with -F" may be, for example, a group represented by one of Formulae 10-601 to 10-620:

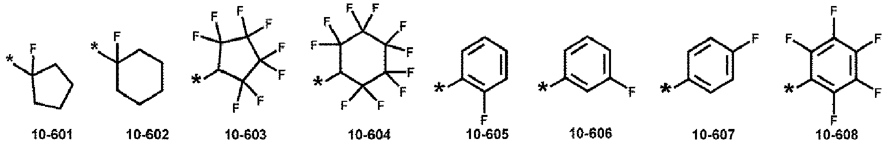

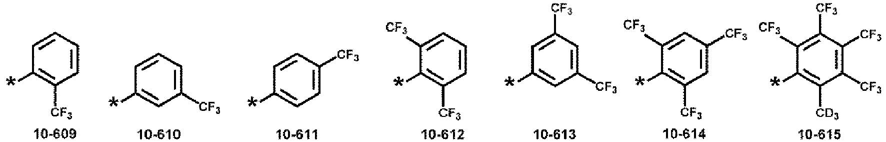

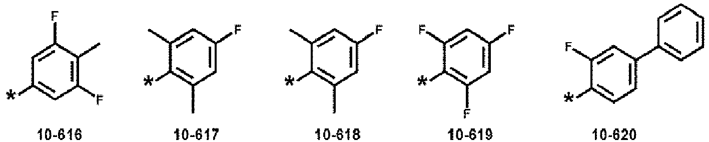

In relation to Formulae 2-1 and 2-2, i) two or more of R₂₁ to R₂₃ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, ii) two or more of a plurality of Z₁(s) are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, iii) two or more of a plurality of Z₂(s) are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, iv) two or more of Z₃ to Z₅ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ (for example, see Compound 161, etc.), v) two or more of a plurality of R₁₄(s) are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, and vi) two or more of a plurality of Z₁, Z₂, and R₁₁ to R₁₄ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

Two or more of Z₃ to Z₅ of Formula 3 are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ (for example, a cyclopropane group, a cyclobutane group, a cyclopentane group, a cyclohexane group, or the like, each unsubstituted or substituted with at least one R₁₀ₐ) (for example, see Compound 161, or the like).

R₁₀ₐ is as described in connection with R₁₄.
* and *' in Formulae 2-1 and 2-2 each indicates a binding site to M in Formula 1.
* in Formula 3 is a binding site to ring CY₁ in Formula 2-1.

In one or more embodiments, a group represented by 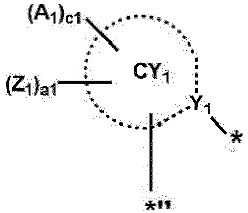 in Formula 2-1 may be a group represented by one of Formulae CY1-1 to CY1-10: 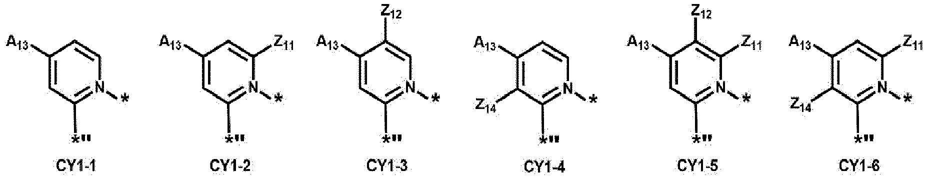 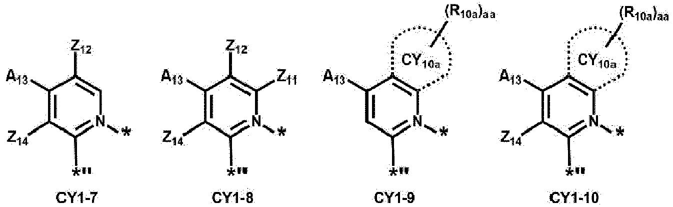 wherein, in Formulae CY1-1 to CY1-10,
Z₁₁, Z₁₂ and Z₁₄ are as described in connection with Z₁, and each of Z₁₁, Z12, and Z₁₄ may not be hydrogen,
A₁₃ is as described in connection with A₁,
ring CY₁₀ₐ may be a C₅-C₃₀ carbocyclic group or a C₁-C₃₀ heterocyclic group,
R₁₀ₐ may be understood by referring to the description of R₁₀ₐ provided herein,
aa may be an integer from 0 to 10,
* indicates a binding site to M in Formula 1, and
*" indicates a binding site to ring CY₂₁ in Formula 2-1.

In one or more embodiments, a group represented by 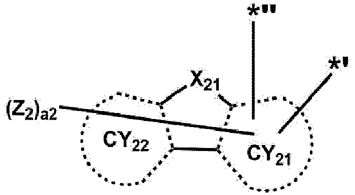 in Formula 2-1 may be a group represented by one of Formulae CY2-1 to CY2-6: 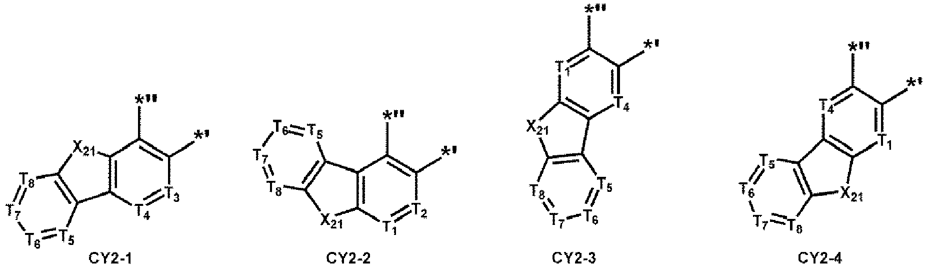 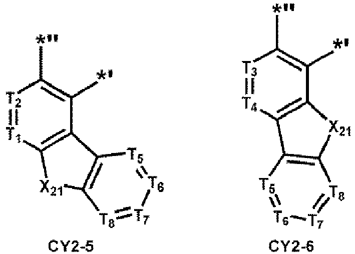 wherein, in Formulae CY2-1 to CY2-6,
T₁ to T₈ may each independently be C or N,
X₂₁ is as described in the present specification,
*" indicates a binding site to ring CY₁ in Formula 2-1, and
*' indicates a binding site to M in Formula 1.

For example,
a) T₁ to T₈ of Formulae CY2-1 to CY2-6 may each be C, and/or
b) at least one of T₃ to T₈ of Formulae CY2-1 and CY2-6 (for example, one or two of T₃ to T₈) may be N, and/or
c) at least one of T₁, T₂ and T₅ to T₈ of Formulae CY2-2 and CY2-5 (for example, one or two of T₁, T₂, and T₅ to T₈) may be N, and/or
d) at least one of T₁ and T₄ to T₈ of Formulae CY2-3 and CY2-4 (for example, one or two of T₁ and T₄ to T₈) may be N.

In one or more embodiments,
1) T₁ to T₈ in Formulae CY2-1 to CY2-6 may be C;
2) in relation to Formula CY2-1, one of T₃ to T₈ may be N, and the others of T₃ to T₈ which are not N, may be C;
3) in relation to Formula CY2-1, T₃ and T₈ may be N, and T₄ to T₇ may each be C;
4) in relation to Formula CY2-1, T₆ and T₈ may be N, and T₃ to T₅ and T₇ may each be C;
5) in relation to Formula CY2-2, one of T₁, T₂ and T₈ may be N, and the others of T₁, T₂ and T₅ to T₈ which are not N, may be C;
6) in relation to Formula CY2-2, T₁ and T₈ may be N, and T₂ and T₅ to T₇ may each be C;
7) in relation to Formula CY2-2, T₂ and T₈ may each be N, and each of T₁ and T₅ to T₇ may be C;
8) in relation to Formulae CY2-3 and CY2-4, one of T₁, T₄ and T₈ may be N, and the others of T₁, T₄ and T₅ to T₈, which are not N, may be C;
9) in relation to Formulae CY2-3 and CY2-4, T₁ and T₈ may be N, and T₄ and T₅ to T₇ may be C;
10) in relation to Formula CY2-3 and CY2-4, T₄ and T₈ may be N, and T₁ and T₅ to T₇ may each be C;
11) in relation to Formula CY2-5, one of T₁ and T₈ may be N, and the others of T₁, T₂ and T₅ to T₈ which are not N, may be C;
12) in relation to Formula CY2-5, T₁ and T₈ may be N, and T₂ and T₅ to T₇ may each be C;
13) in relation to Formula CY2-6, one of T₄ and T₈ may be N, and the others of T₃ to T₈ which are not N, may be C; or
14) in relation to Formula CY2-6, T₄ and T₈ may each be N, and T₃ and T₅ to T₇ may each be C.

In one or more embodiments, a group represented by 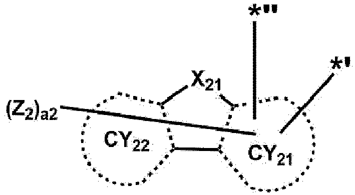 in Formula 2-1 may be a group represented by one of Formulae CY2-1001 to CY2-1141, CY2-2001 to CY2-2092, CY2-3001 to CY2-3092, CY2-4001 to CY2-4092, CY2-5001 to CY2-5065, or CY2-6001 to CY2-6065: 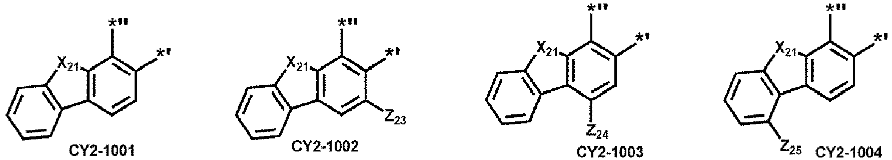 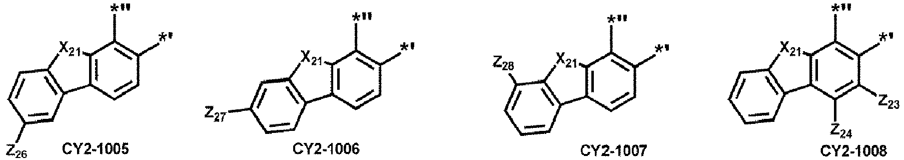 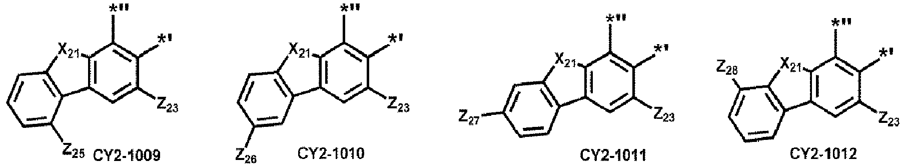 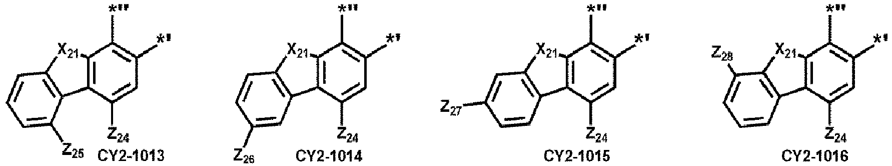 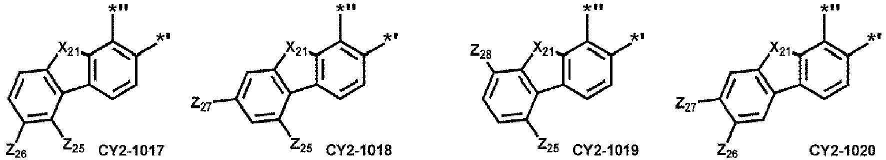 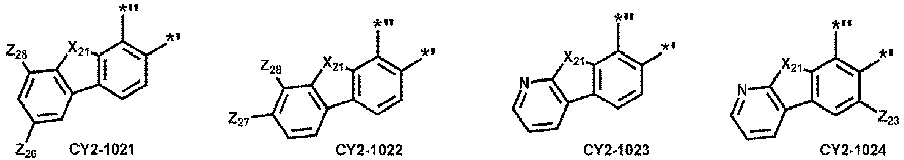 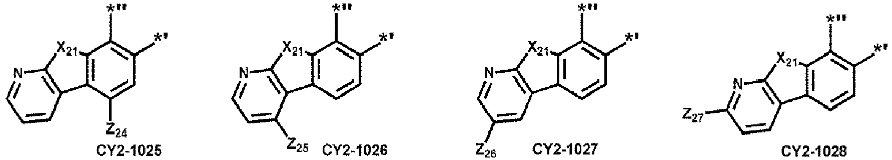 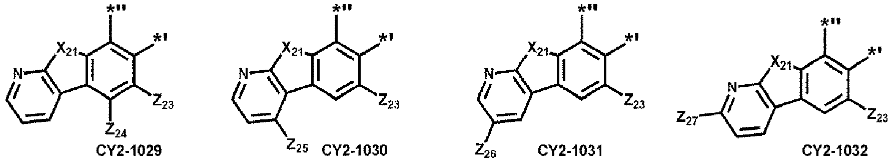 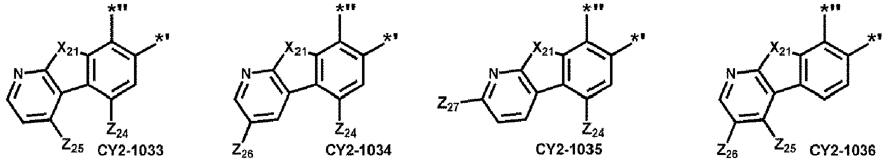 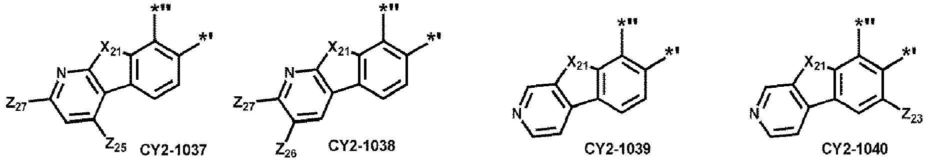 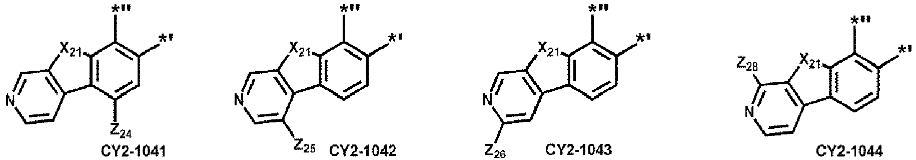 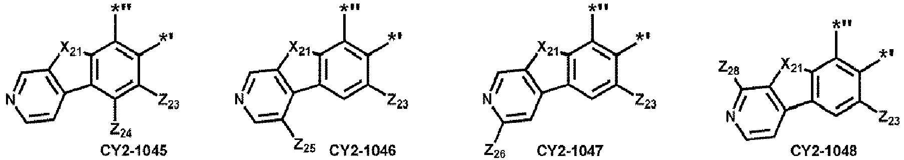 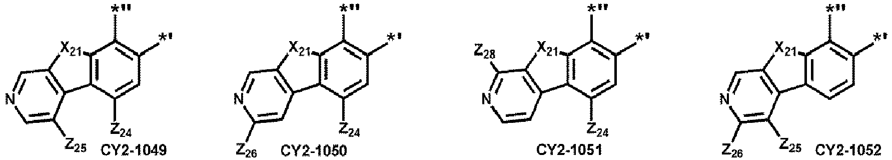 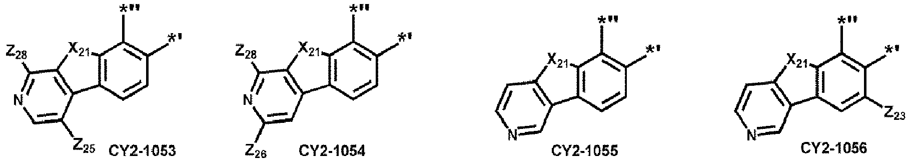 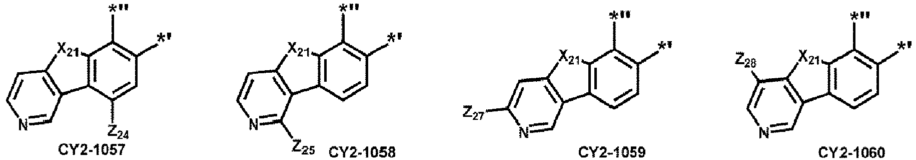 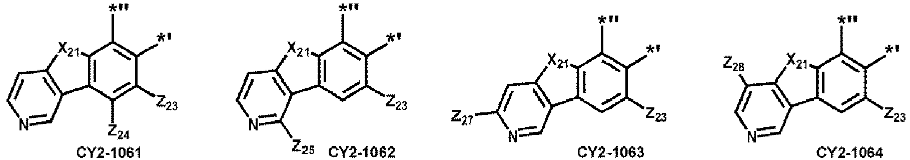 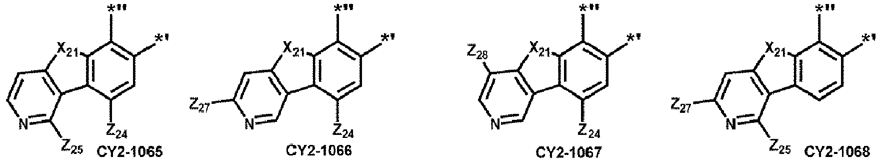 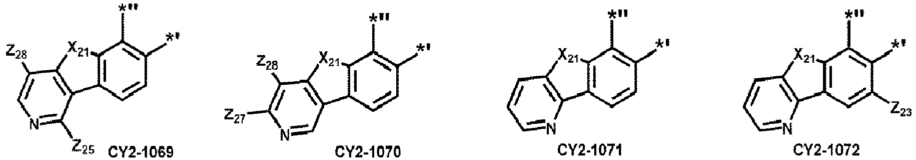 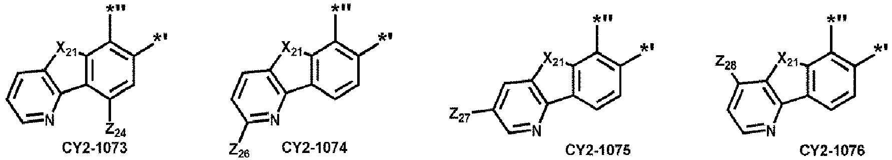 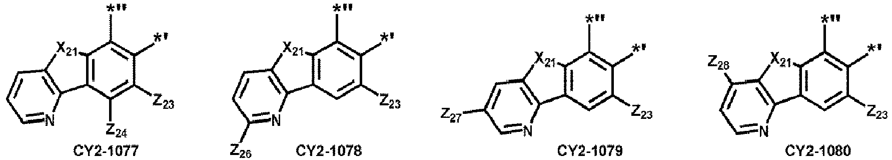 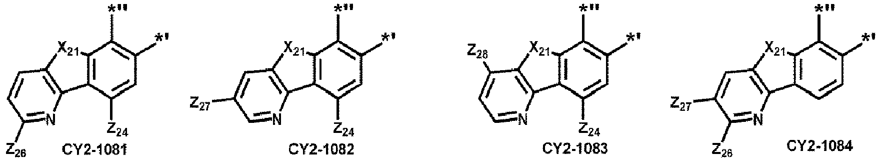 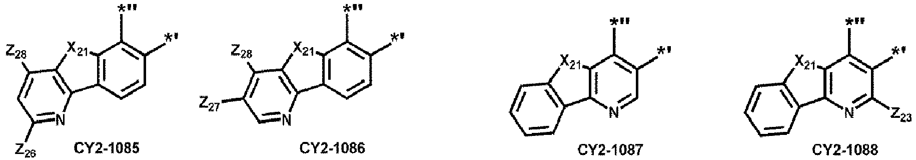 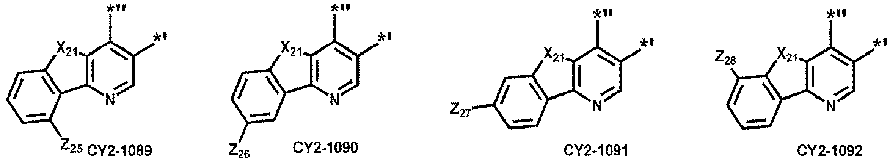 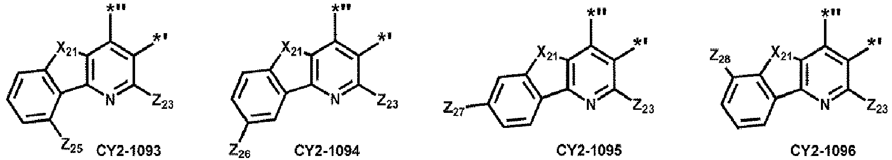 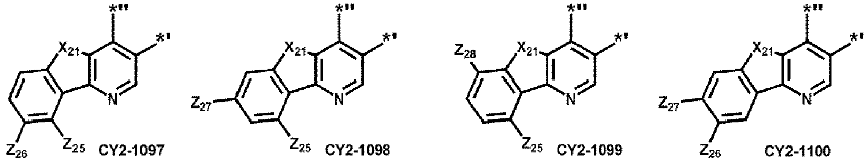 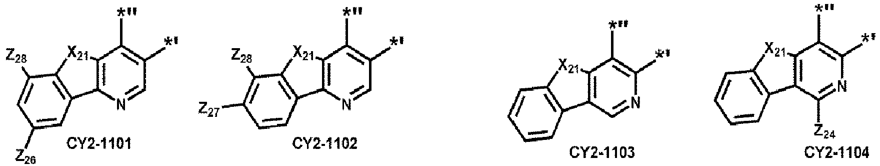 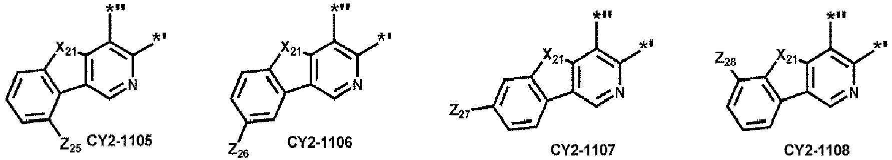 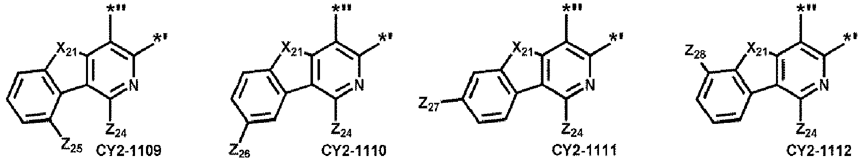 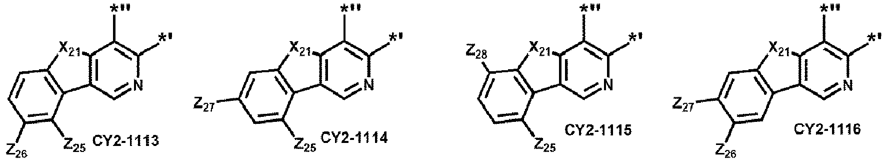 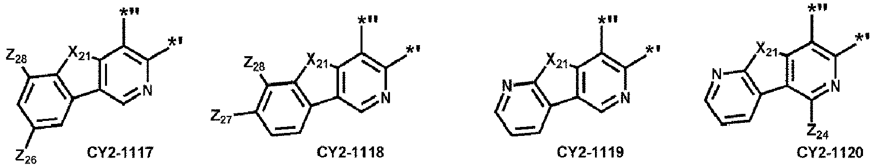 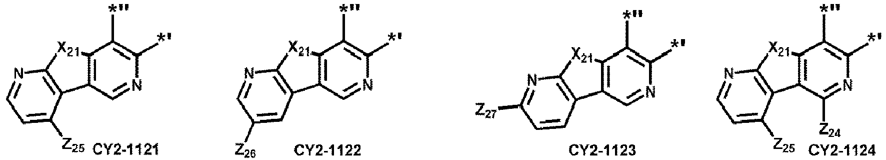 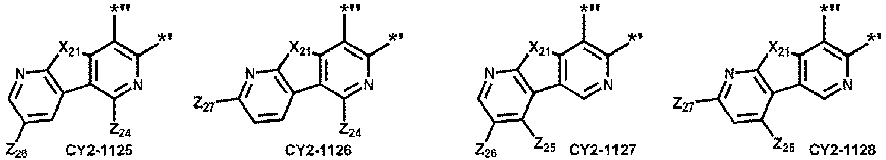 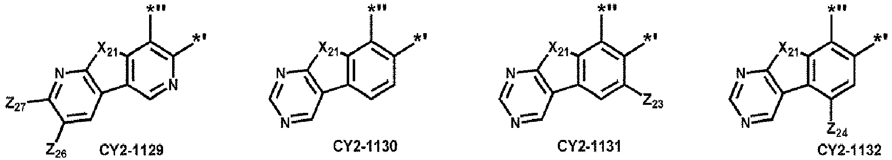 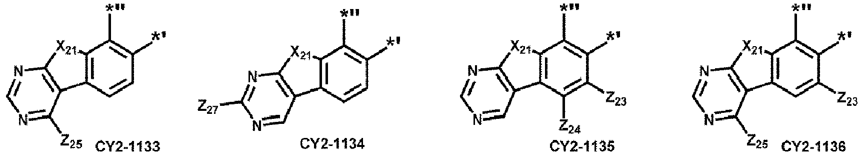 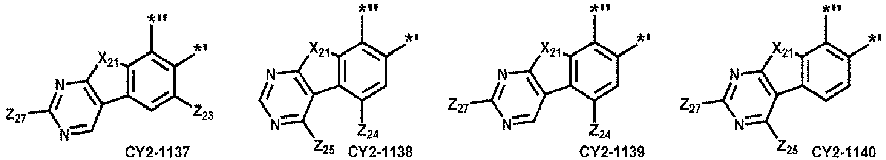 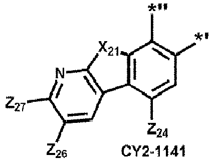 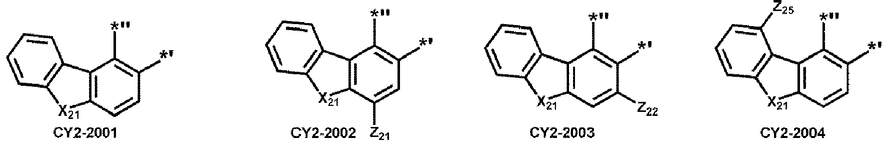 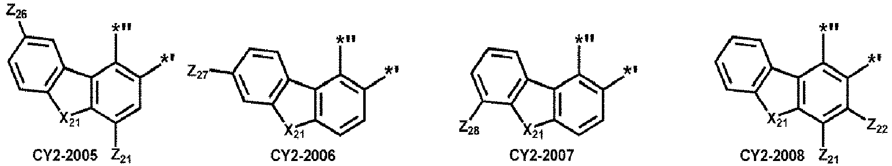 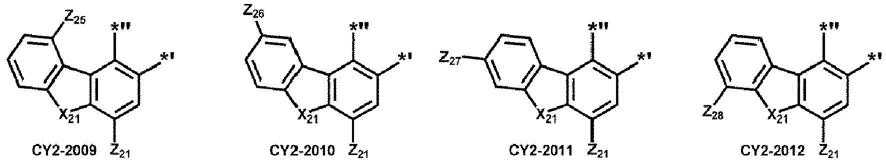 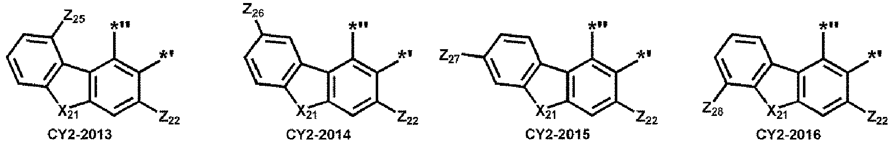 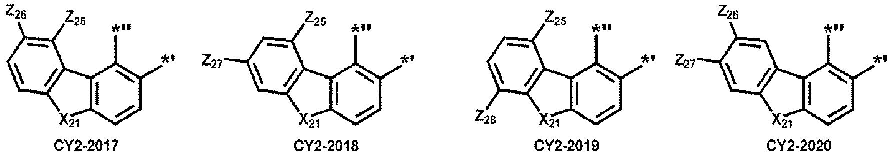 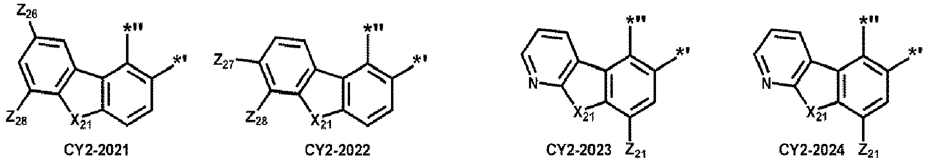 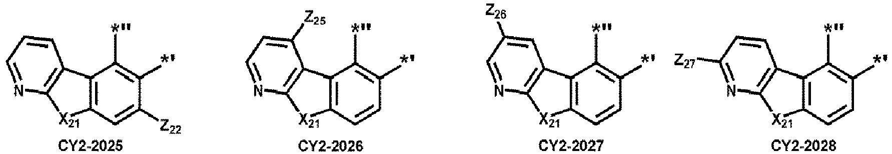 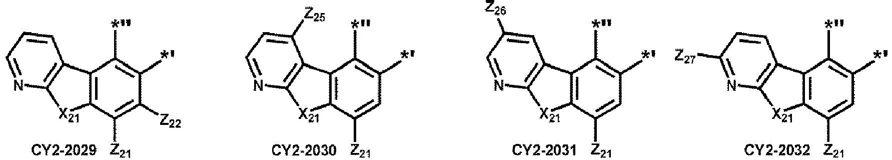 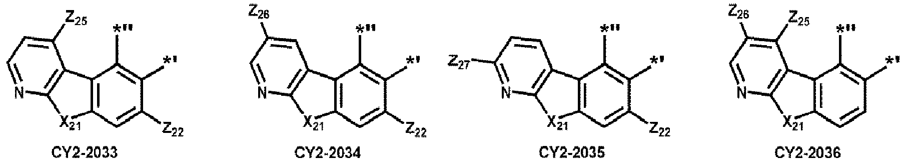 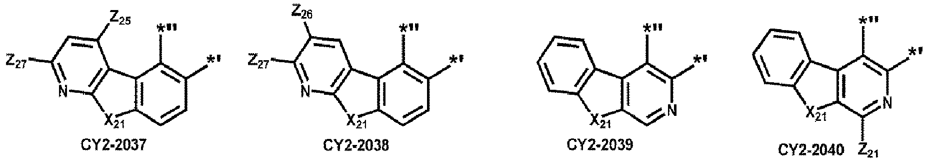 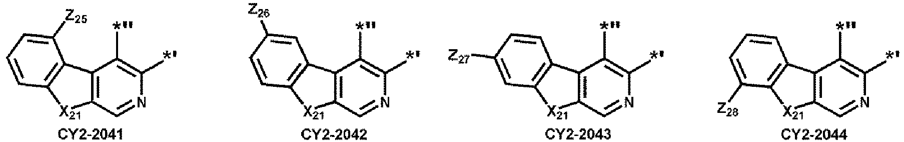 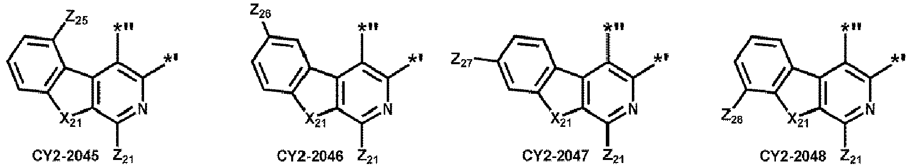 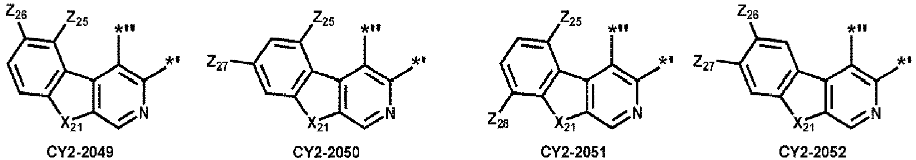 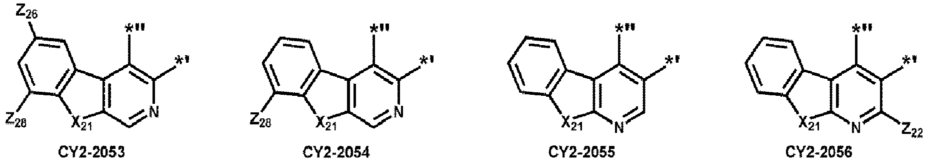 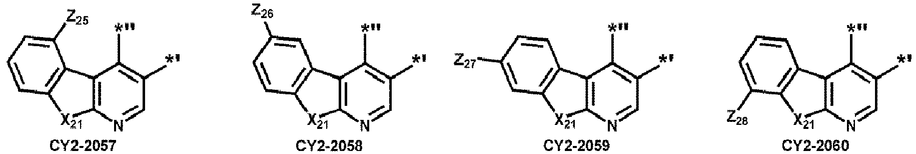 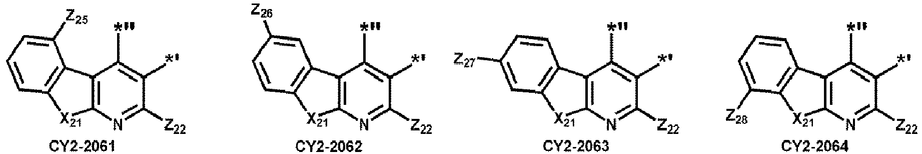 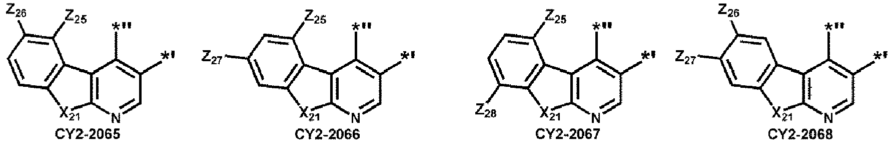 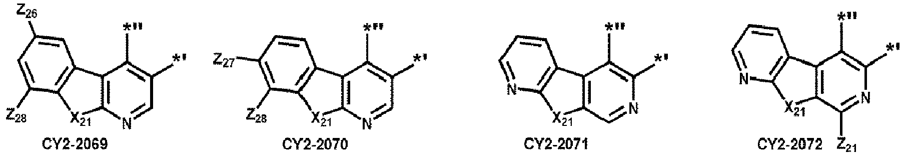 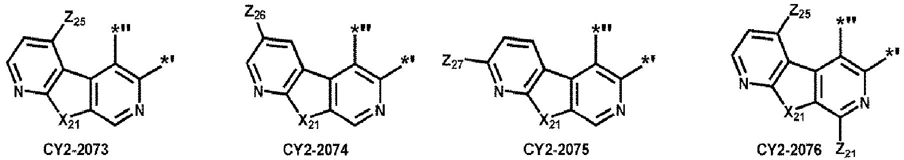 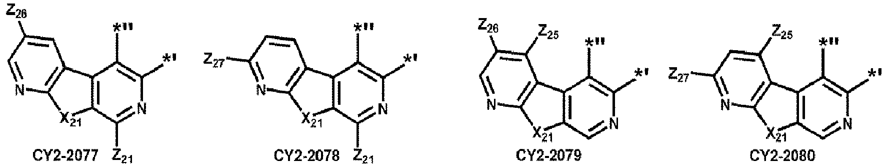 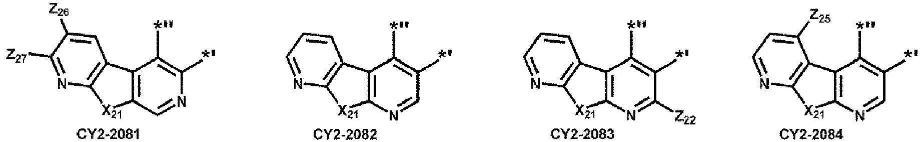 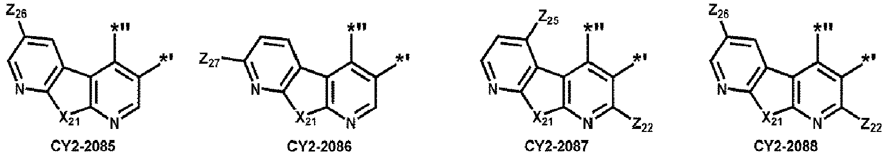 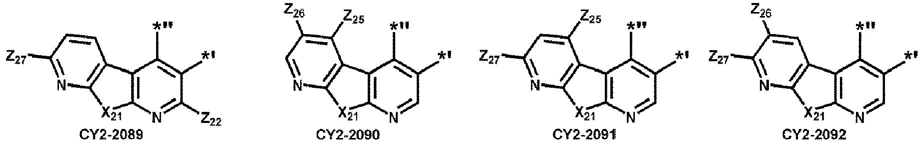 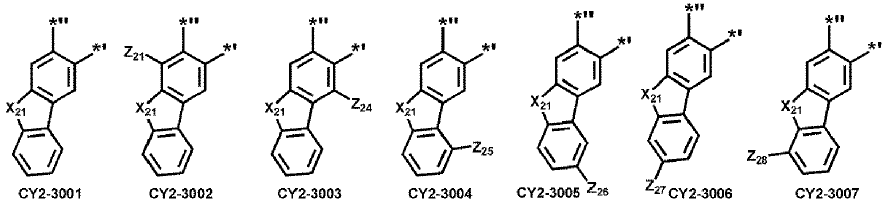 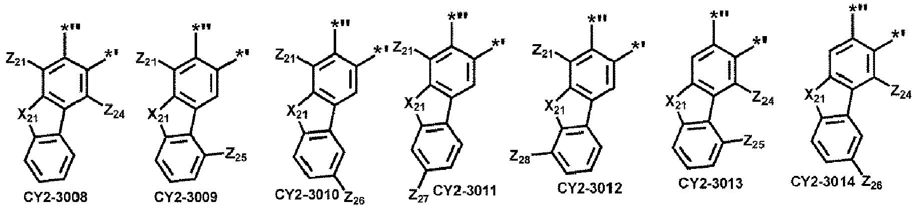 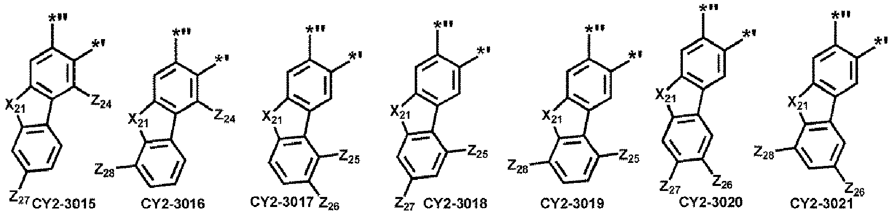 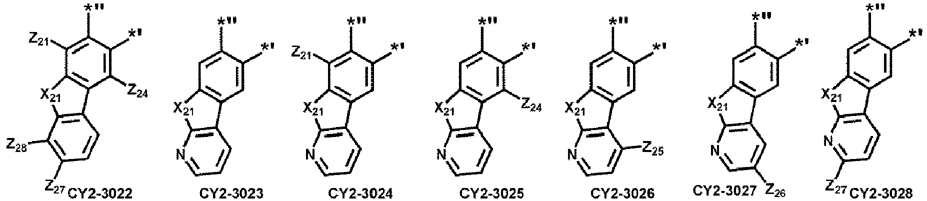 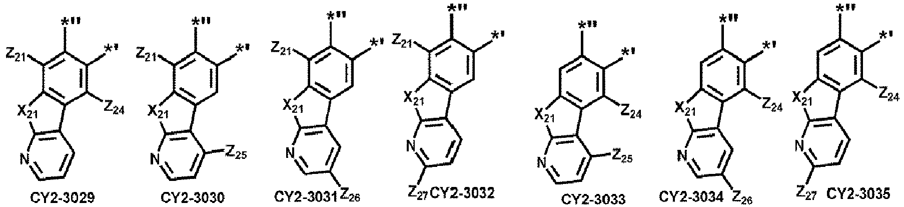 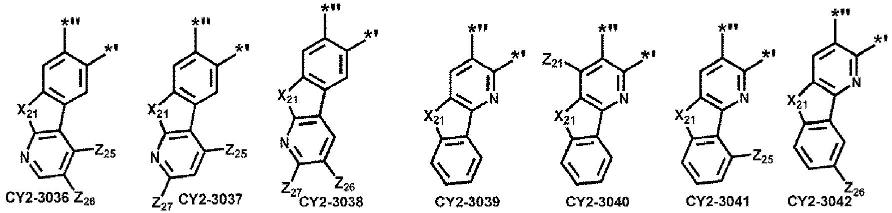 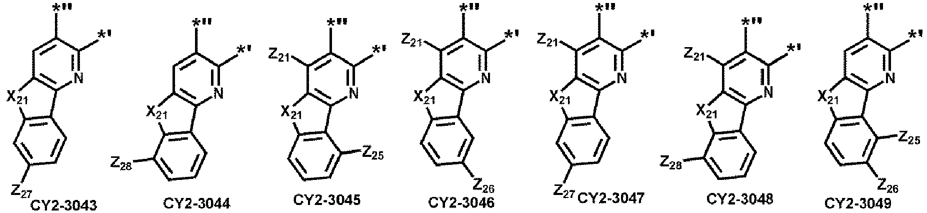 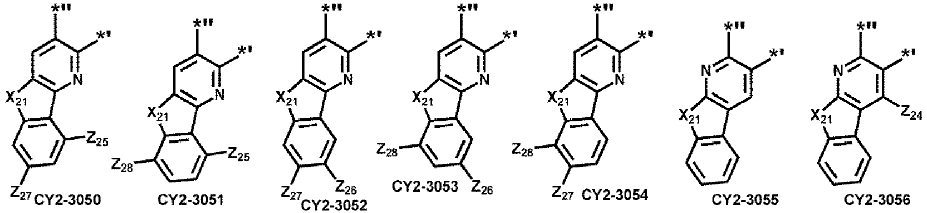 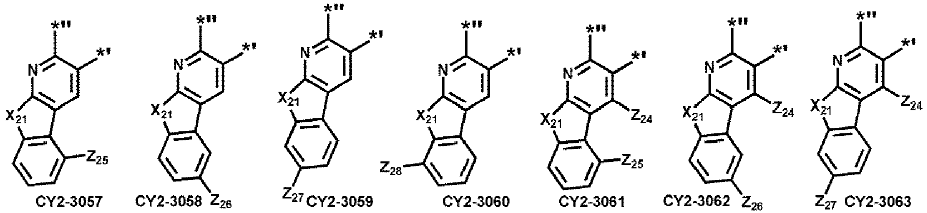 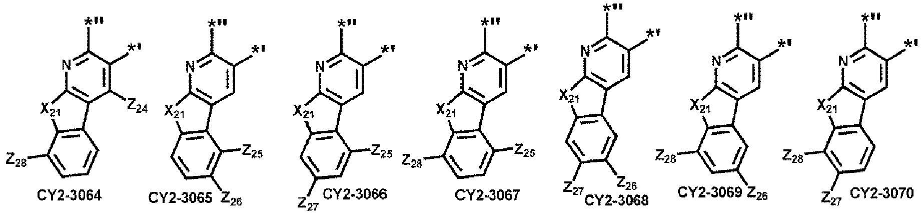 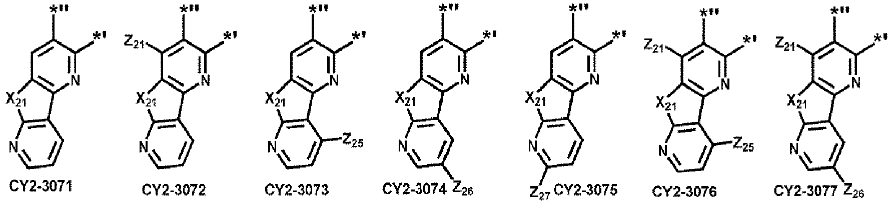 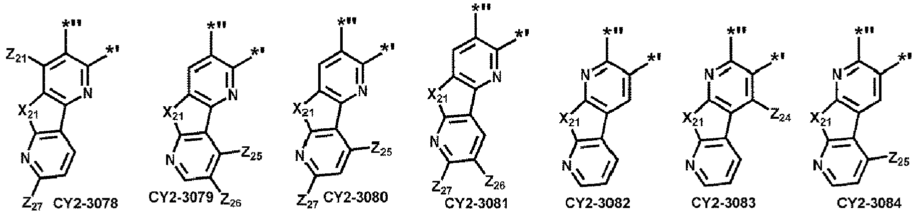 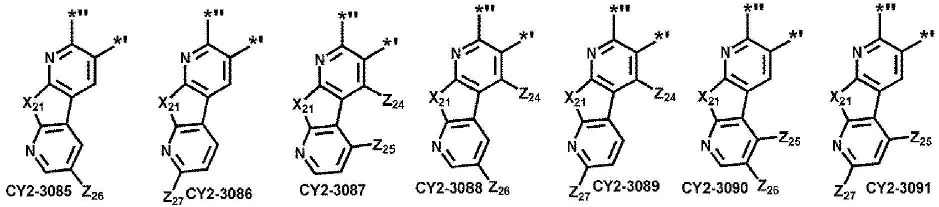 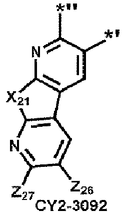 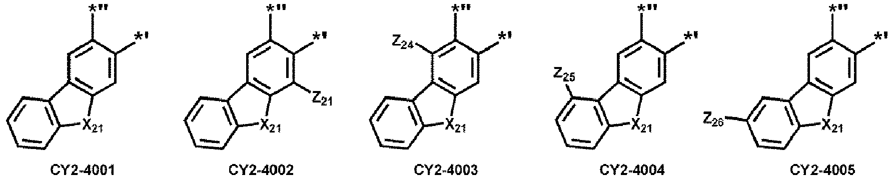 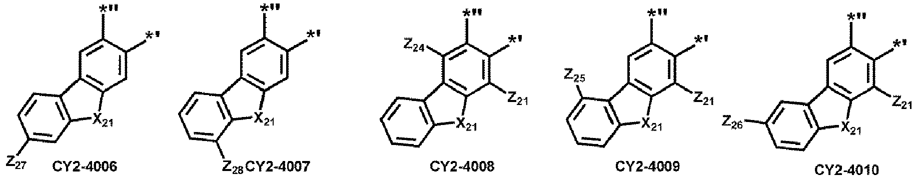 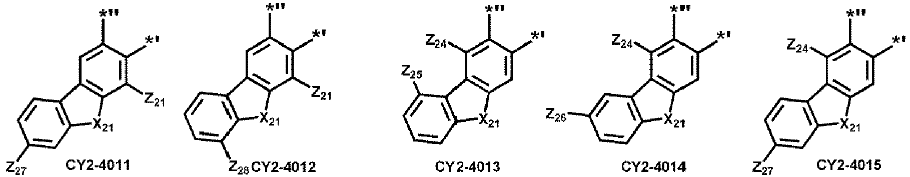 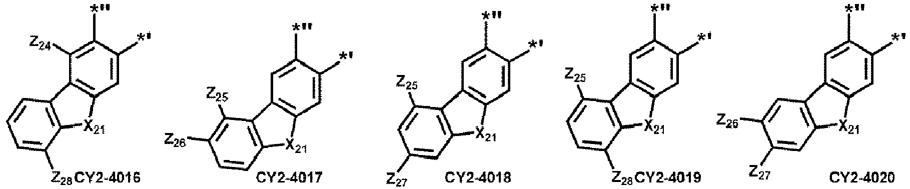 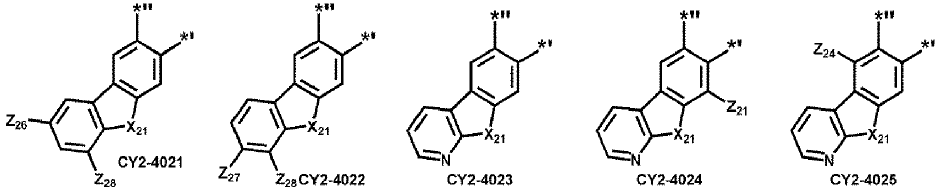 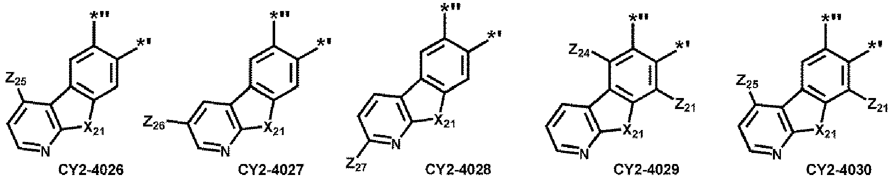 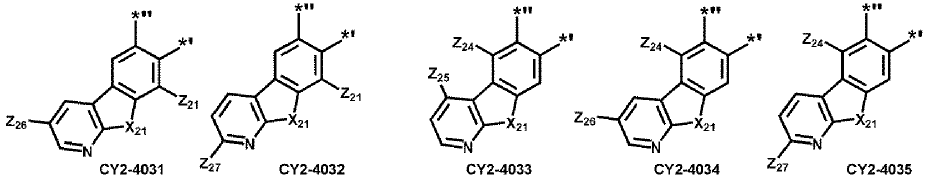 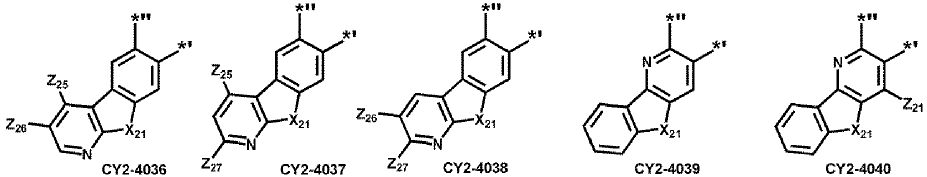 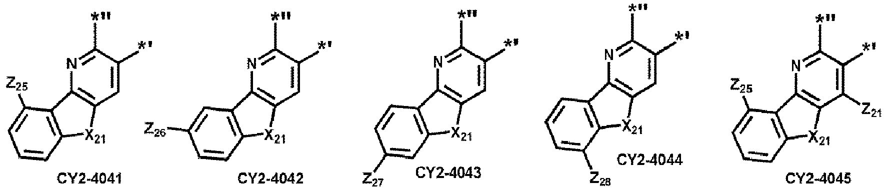 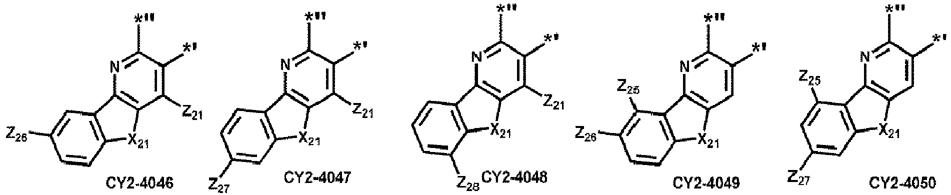 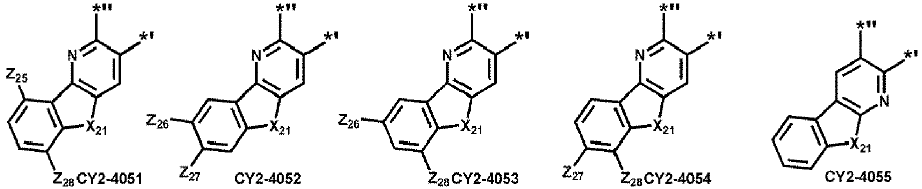 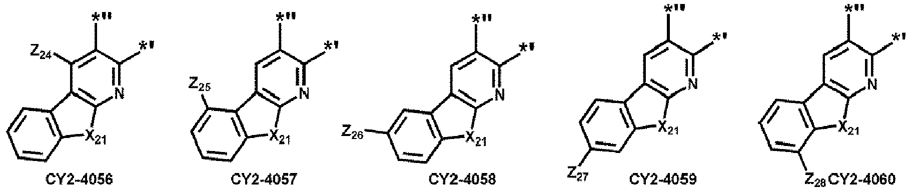 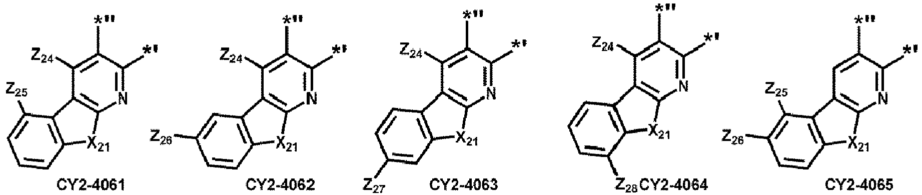 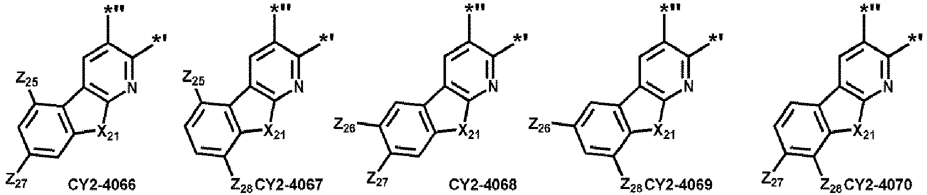 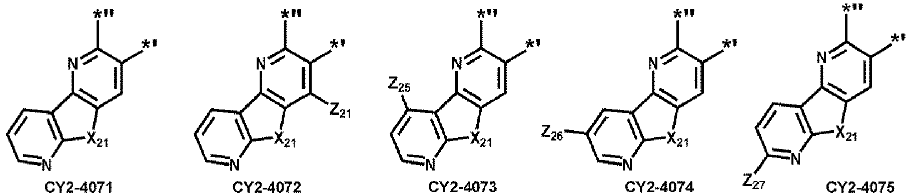 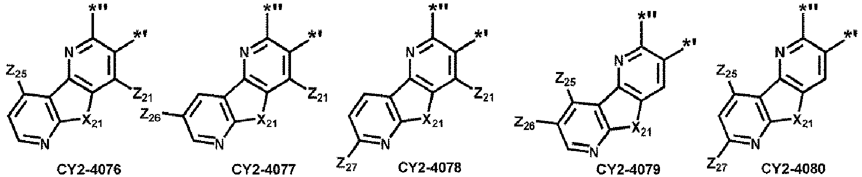 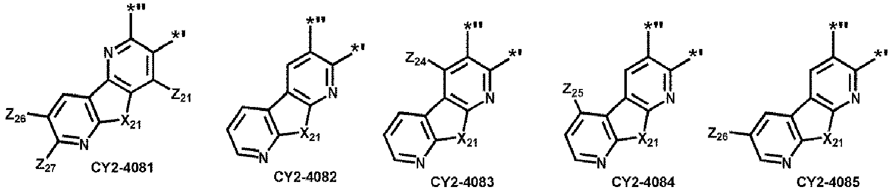 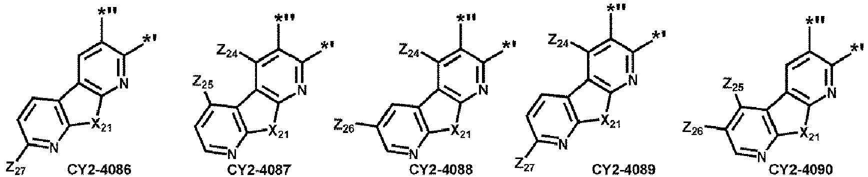 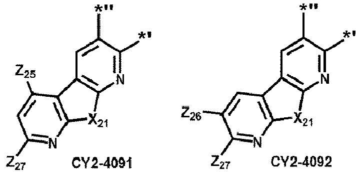 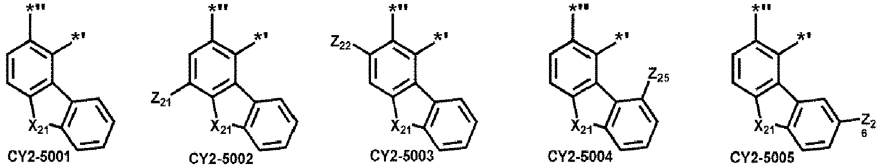 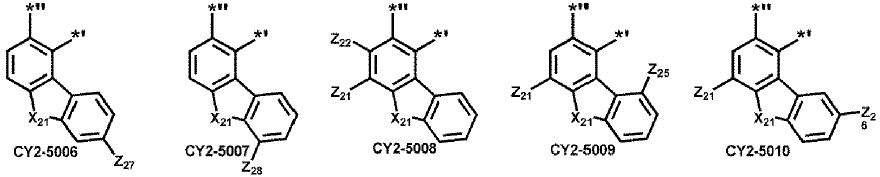 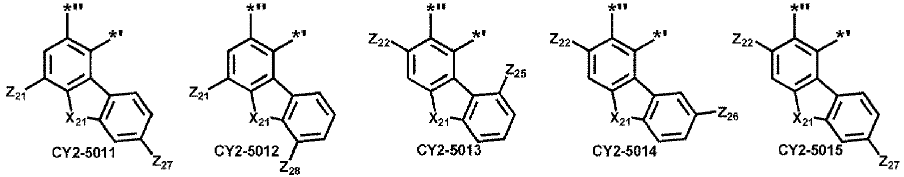 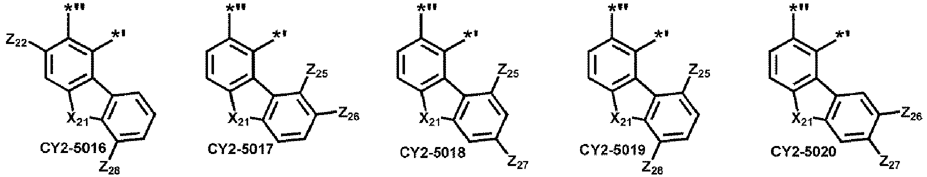 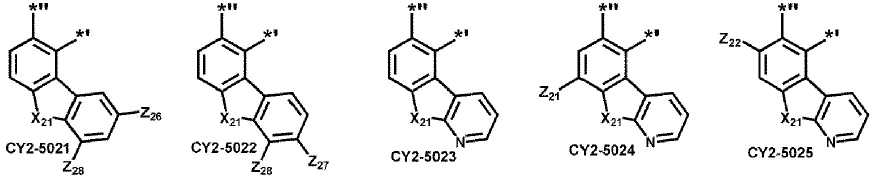 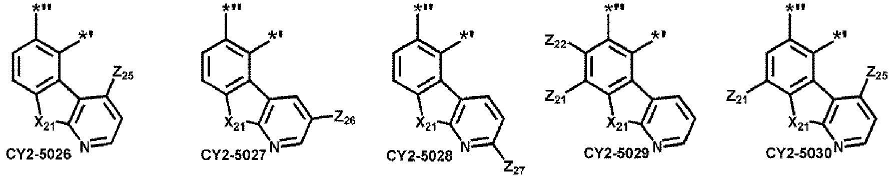 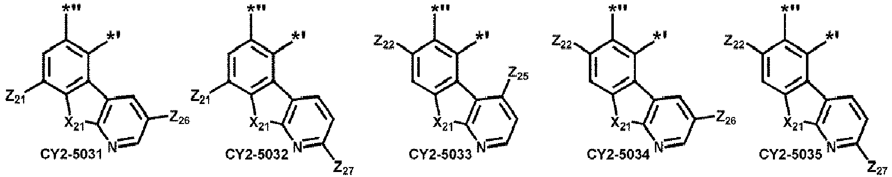 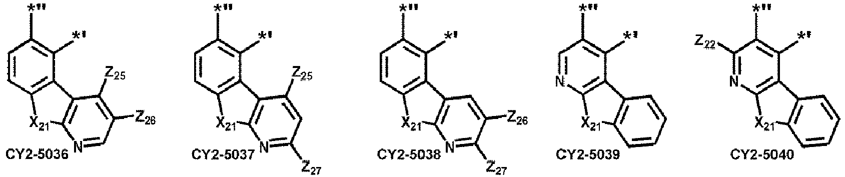 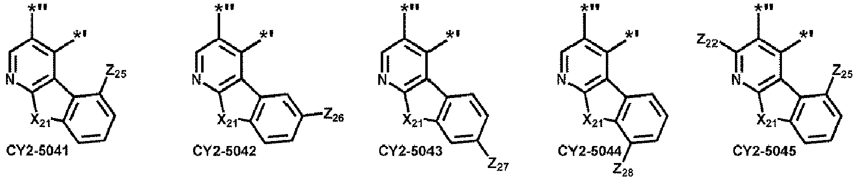 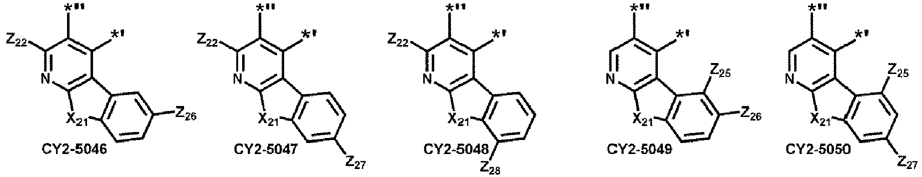 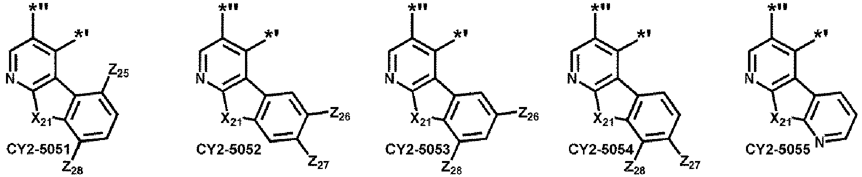 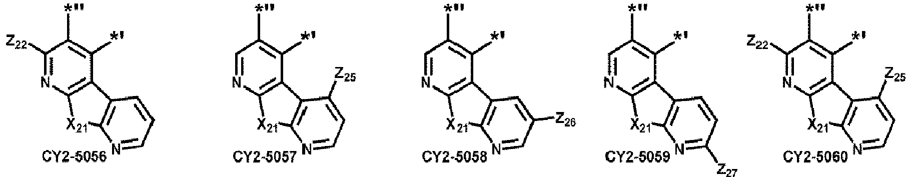 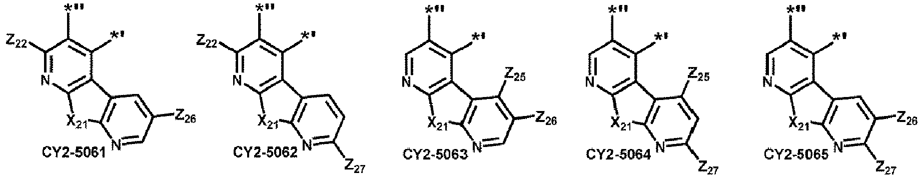 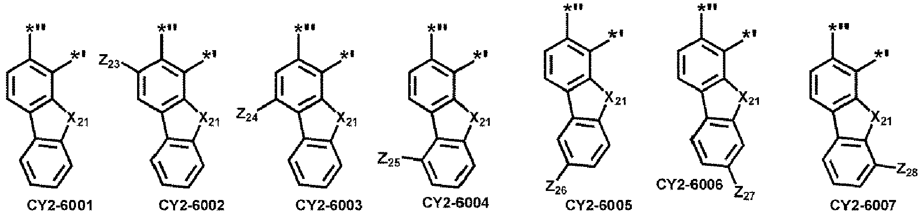 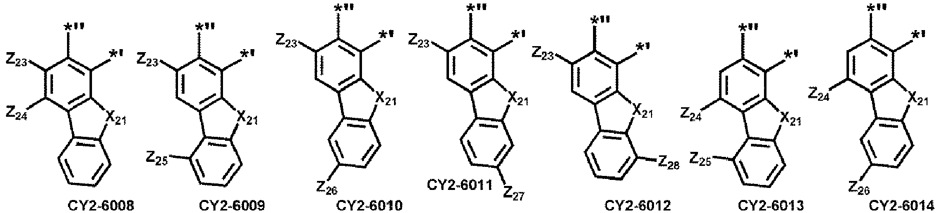 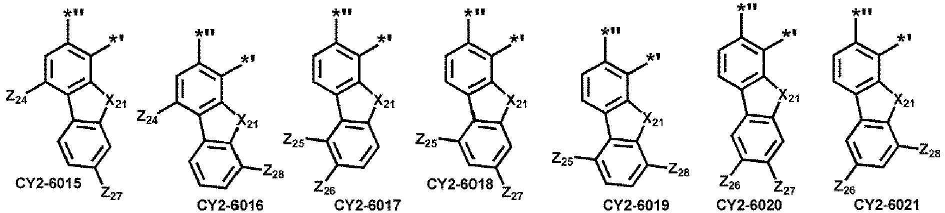 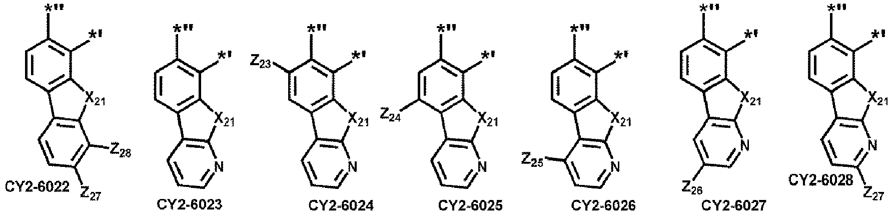 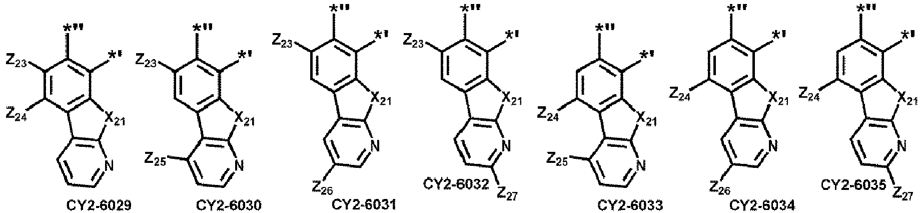 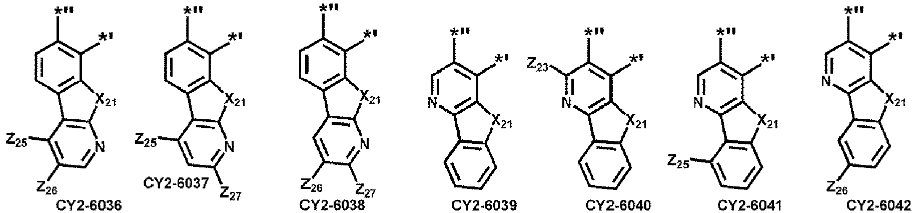 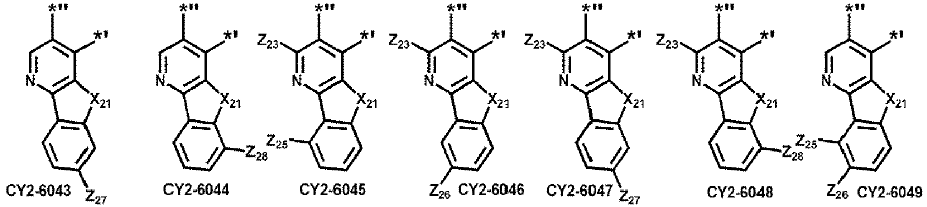 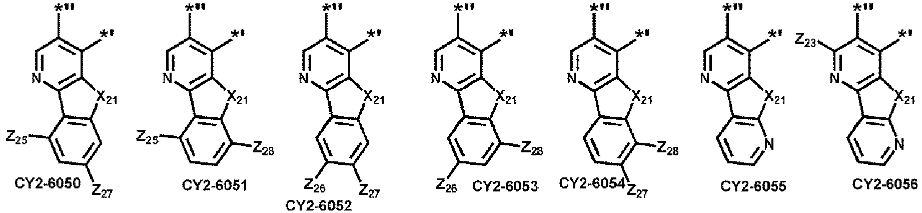 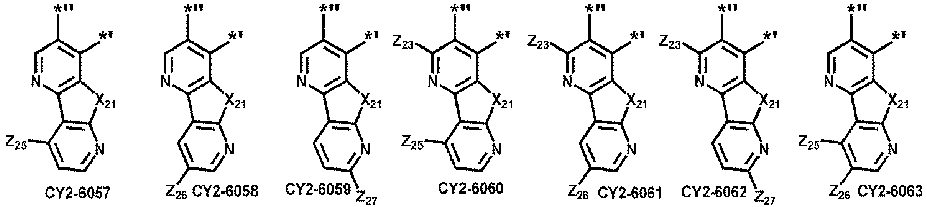 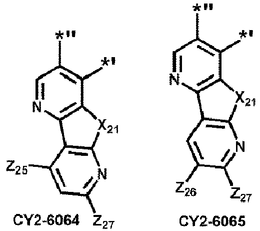 wherein, in Formulae CY2-1001 to CY2-1141, CY2-2001 to CY2-2092, CY2-3001 to CY2-3092, CY2-4001 to CY2-4092, CY2-5001 to CY2-5065, and CY2-6001 to CY2-6065,
X₂₁ is as described in the present specification,
Z₂₁ to Z₂₈ are as described in connection with Z₂, and each of Z₂₁ to Z₂₈ is not hydrogen,
*" indicates a binding site to ring CY₁ in Formula 2-1, and
*' indicates a binding site to M in Formula 1.

In one or more embodiments, a group represented by 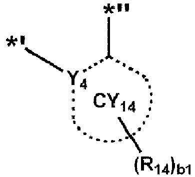 in Formula 2-2 may be a group represented by one of Formulae CY14-1 to CY14-64: 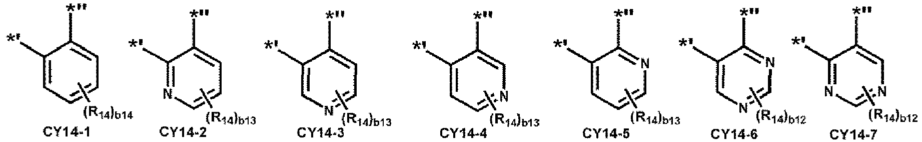 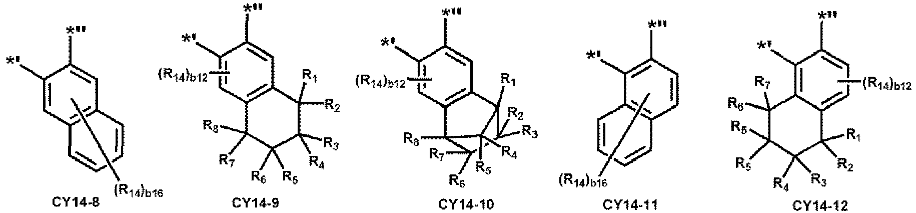 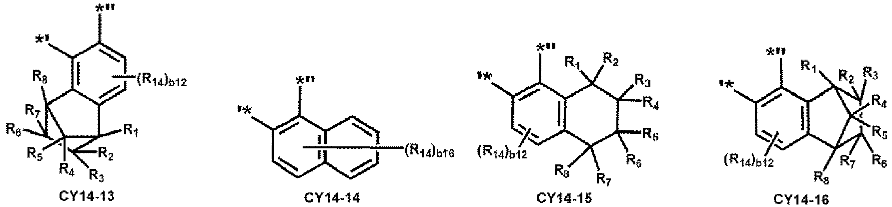 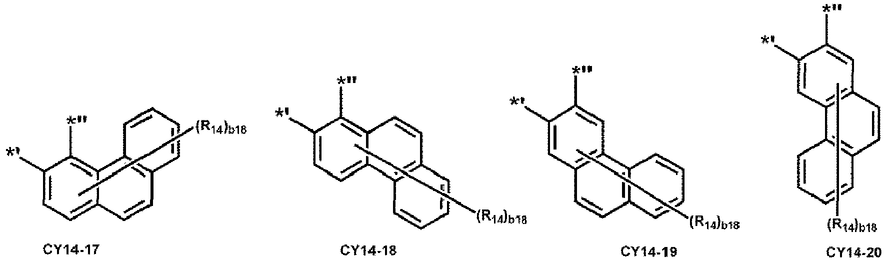 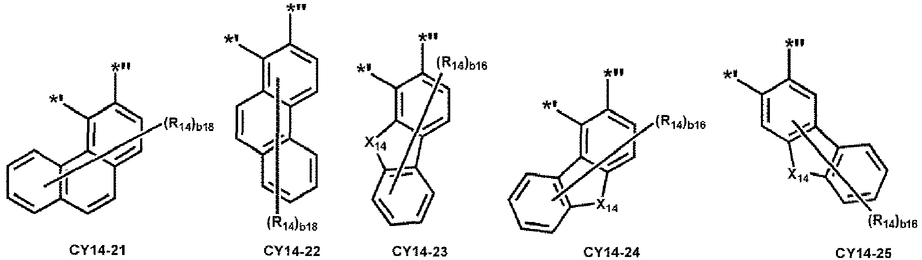 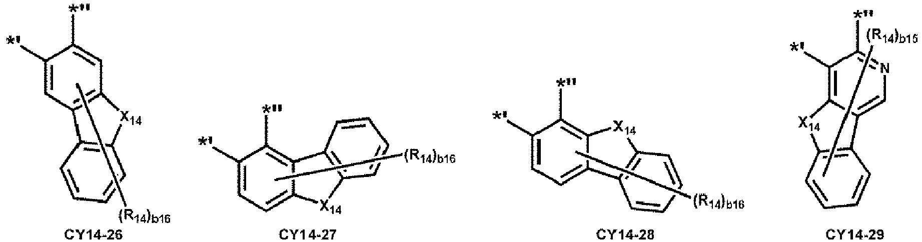 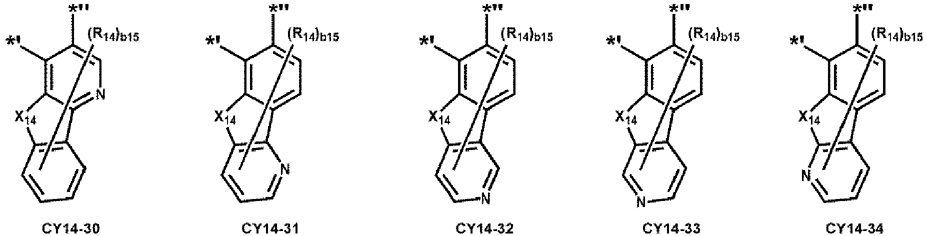 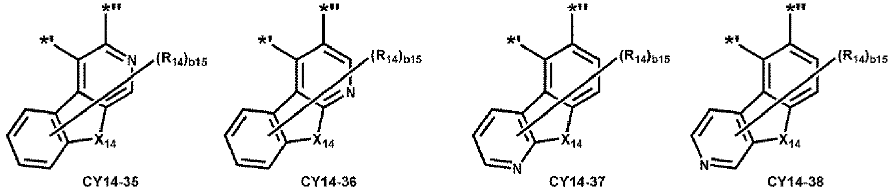 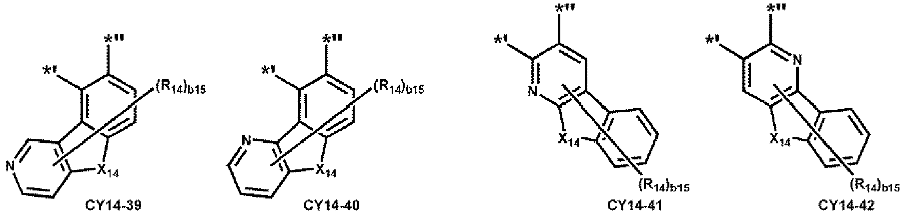 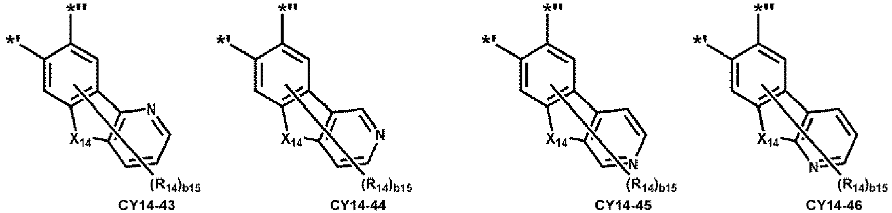 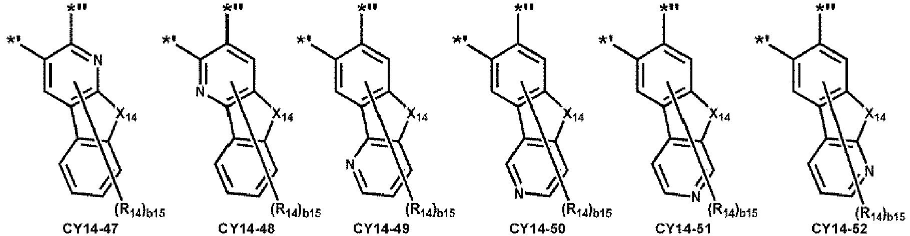 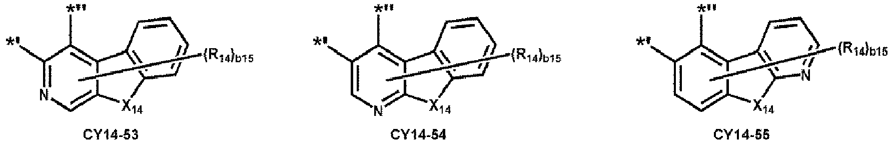 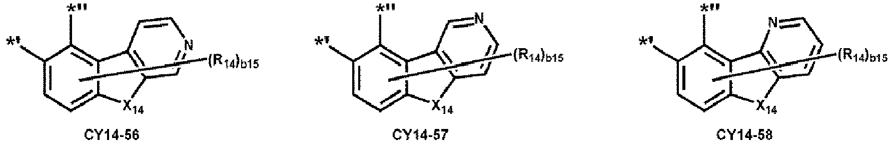 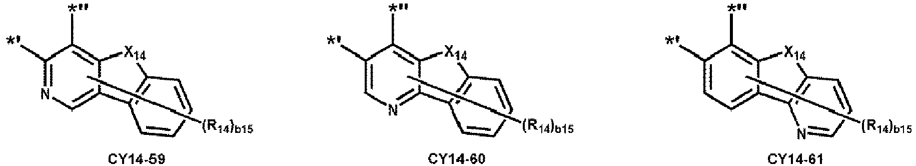 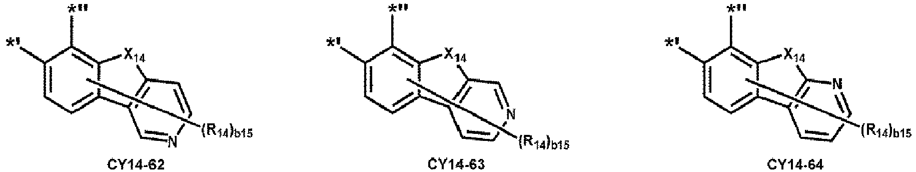 wherein, in Formulae CY14-1 to CY14-64,
R₁₄ are as described in the present specification, and
X₁₄ may be C(R₁)(R₂), N(R₁), O, S, or Si(R₁)(R₂),
R₁ to R₈ are as described in connection with R₁₄,
b18 may be an integer from 0 to 8,
b16 may be an integer from 0 to 6,
b15 may be an integer from 0 to 5,
b14 may be an integer from 0 to 4,
b13 may be an integer from 0 to 3,
b12 may be an integer from 0 to 2,
*" indicates a binding site to a carbon atom of a neighboring pyridine ring in Formula 2-2, and
*' indicates a binding site to M in Formula 1.

In one or more embodiments, a group represented by 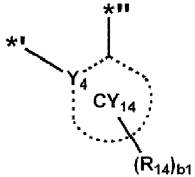 in Formula 2-2 may be a group represented by one of Formulae CY14(1) to CY14(63): 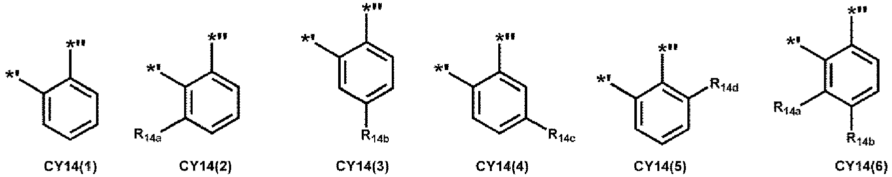 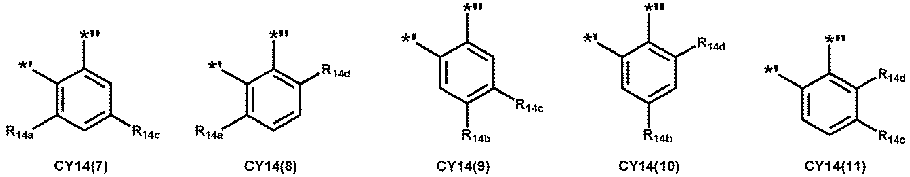 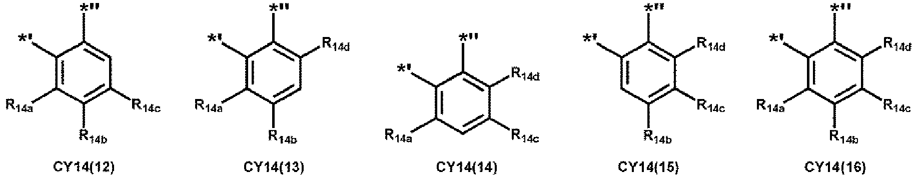 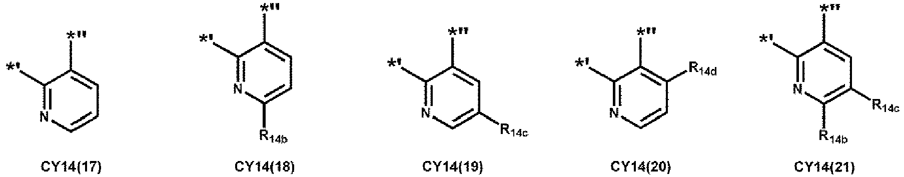 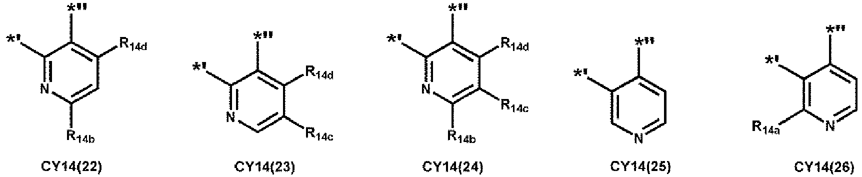 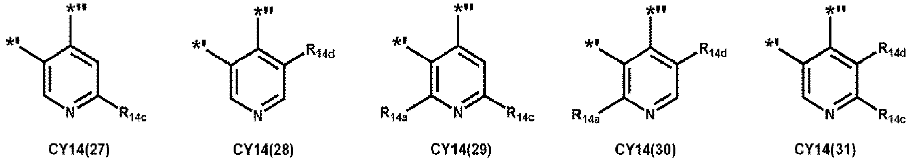 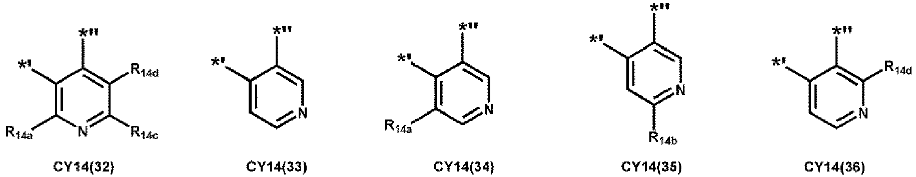 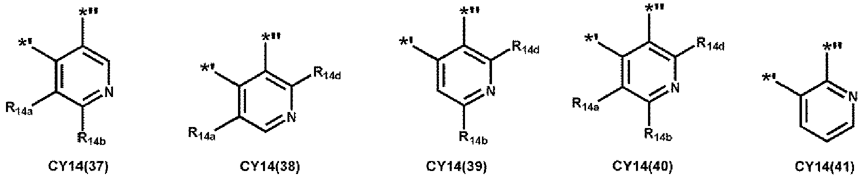 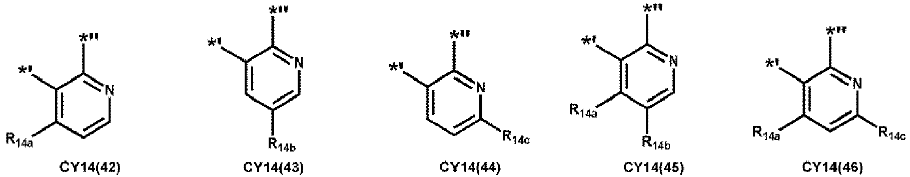 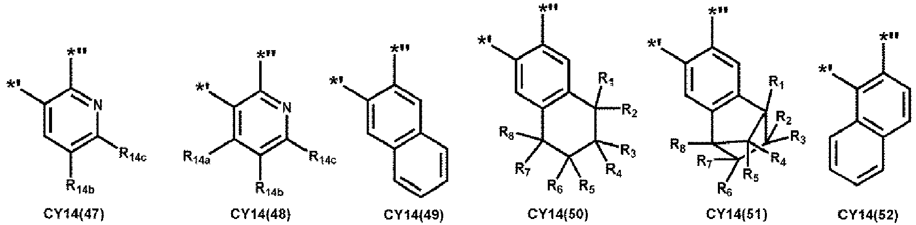 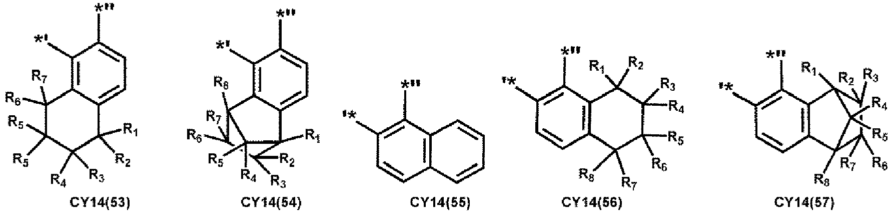 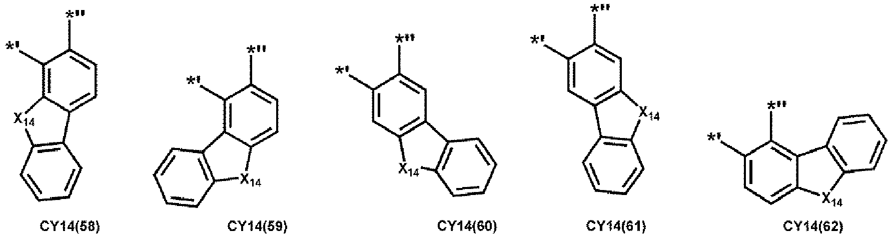 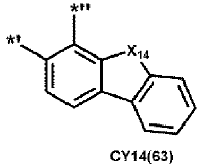 wherein, in Formulae CY14(1) to CY14(63),
R₁₄ₐ to R_{14d} are each as described in connection with R₁₄, and each of R₁₄ₐ to R_{14d} is not hydrogen,
X₁₄ may be C(R₁)(R₂), N(R₁), O, S, or Si(R₁)(R₂),
R₁ to R₈ are as described in connection with R₁₄,
*" indicates a binding site to a carbon atom of a neighboring pyridine ring in Formula 2-2, and
*' indicates a binding site to M in Formula 1.

In one or more embodiments, the organometallic compound may be represented by Formula 1A: 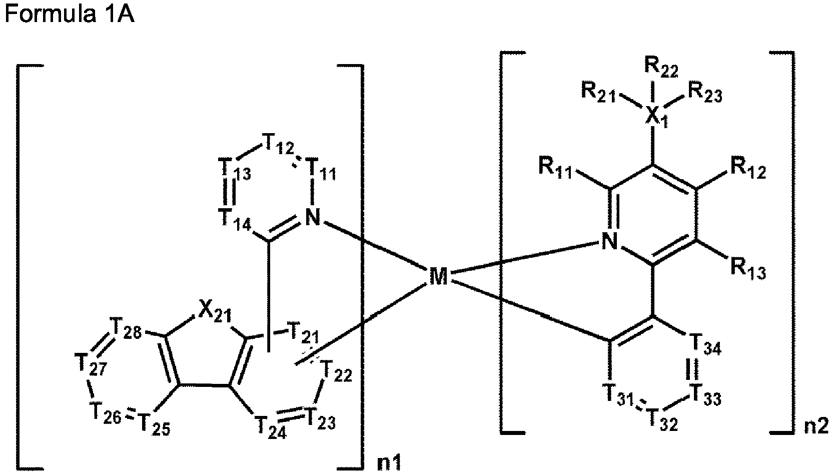 wherein, in Formula 1A,
M, n1, n2, X₁, X₂₁, R₂₁ to R₂₃, and R₁₁ to R₁₃ are each as described in the present specification,
T₁₁ may be N, C(A₁₁), or C(Z₁₁), T₁₂ may be N, C(A₁₂), or C(Z₁₂), T₁₃ may be N, C(A₁₃), or C(Z₁₃), T₁₄ may be N, C(A₁₄), or C(Z₁₄), Z₁₁ to Z₁₄ are as described in connection with Z₁, and A₁₁ to A₁₄ are as described in connection with A₁. In one or more exemplary embodiment, i) T₁₁ may be C(A₁₁), or ii) T₁₂ may be C(A₁₂), or iii) T₁₃ may be C(A₁₃), or iv) T₁₄ may be C(A₁₄),
T₂₁ may be N, C(Z₂₁), carbon bonded to a neighboring 6-membered ring (i.e., the ring containing N and T₁₂ to T₁₄), or carbon bonded to M in Formula 1, T₂₂ may be N, C(Z₂₂), carbon bonded to a neighboring 6-membered ring, or carbon bonded to M in Formula 1, T₂₃ may be N, C(Z₂₃), carbon bonded to a neighboring 6-membered ring, or carbon bonded to M in Formula 1, T₂₄ may be N, C(Z₂₄), carbon bonded to a neighboring 6-membered ring, or carbon bonded to M in Formula 1, T₂₅ may be N or C(Z₂₅), T₂₆ may be N or C(Z₂₆), T₂₇ may be N or C(Z₂₇), T₂₈ may be N or C(Z₂₈), and one of T₂₁ to T₂₄ is carbon bonded to M in Formula 1, one of the others of T₂₁ to T₂₄ which are not bonded to M, may be carbon bonded to a neighboring 6-membered ring, and Z₂₁ to Z₂₄ are as described in connection with Z₂,
i) R₁₂ may be hydrogen, deuterium, a methyl group, or deuterated methyl group, or ii) R₁₂ and R₁₃ may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
T₃₁ may be N or C(R₁₄ₐ), T₃₂ may be N or C(R_{14b}), T₃₃ may be N or C(R_{14c}), T34 may be N or C(R_{14d}), and R₁₄ₐ to R_{14d} are as described in connection with R₁₄,
two or more of Z₁₁ to Z₁₄ may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of Z₂₁ to Z₂₈ may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of R₁₄ₐ to R_{14d} may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, and
R₁₀ₐ is as described in connection with R₁₄.

Further description of Formula 1A is as described in connection with Formula 1.

For example, T₁₃ in Formula 1A may be C(A₁₃).

In one or more embodiments, the organometallic compound may be one of Compounds 1 to 1204:

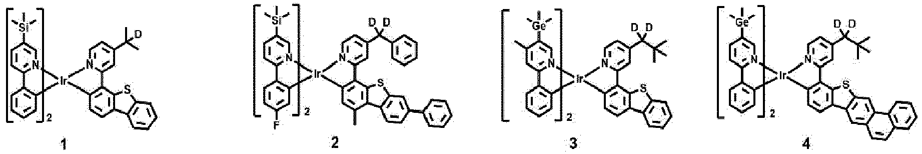

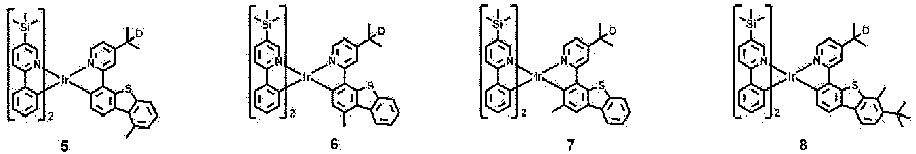

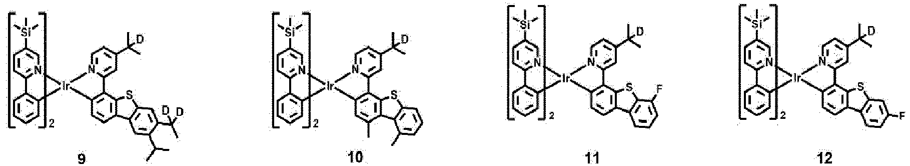

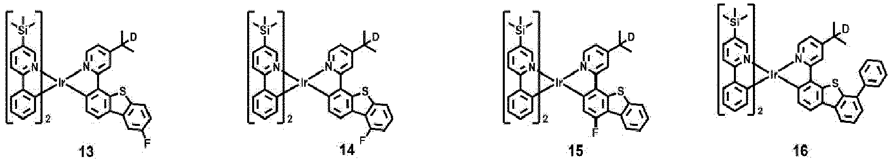

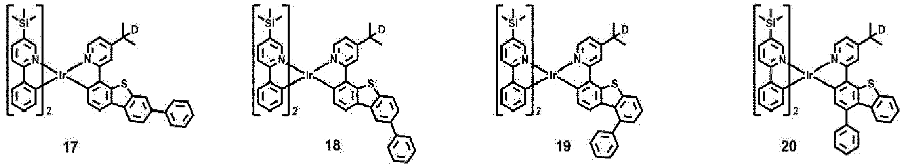

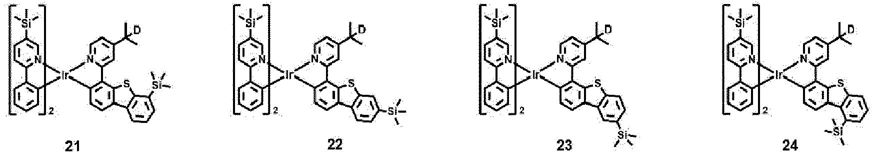

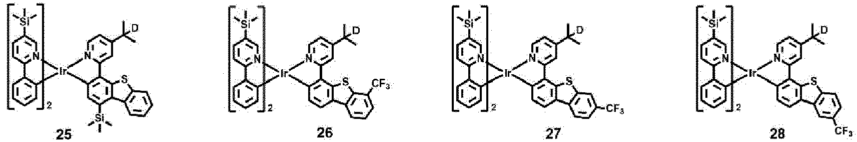

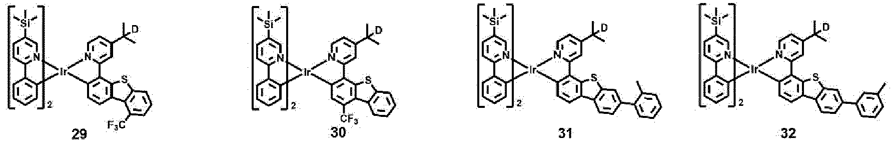

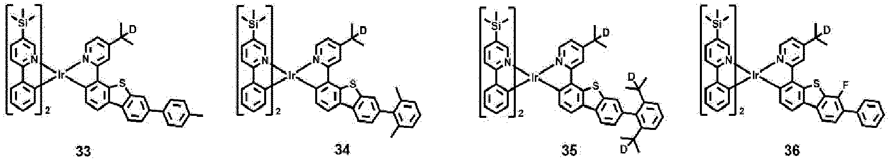

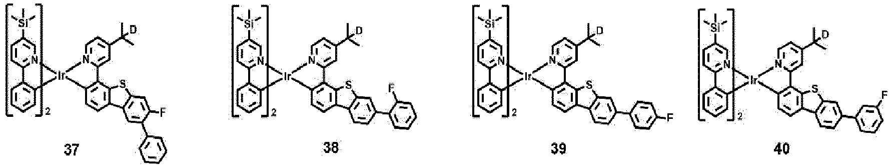

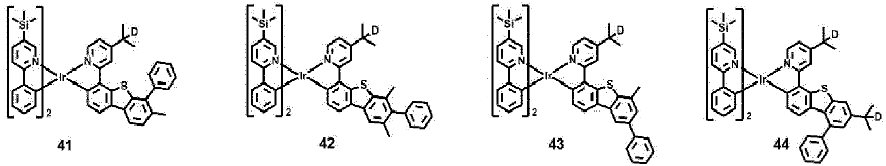

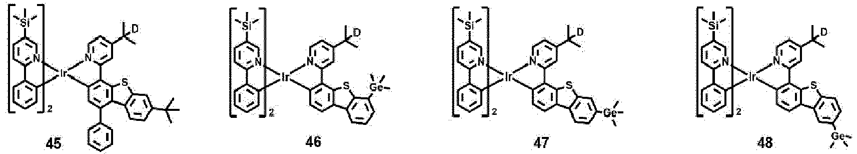

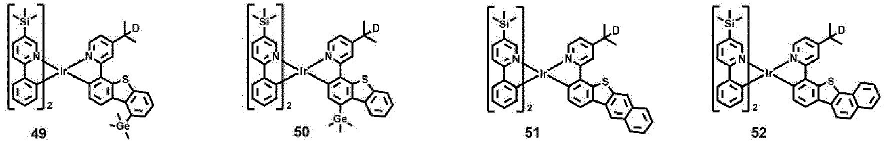

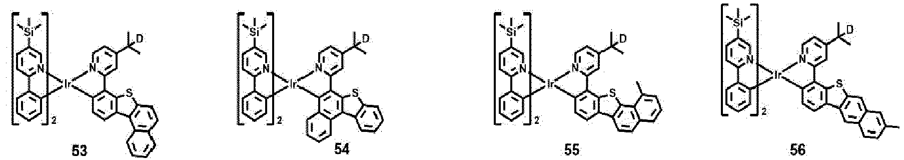

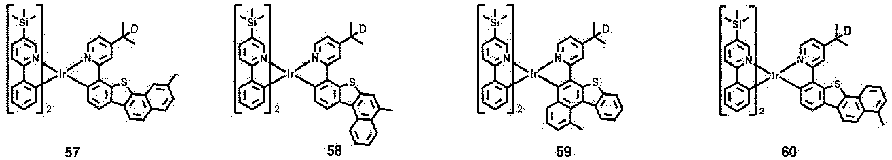

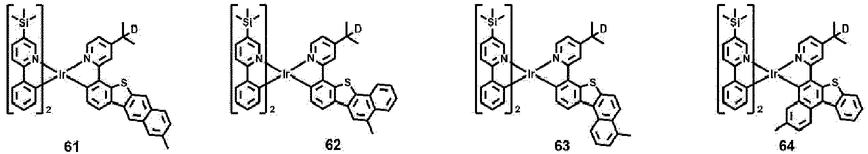

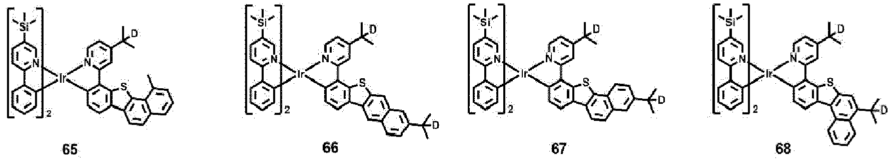

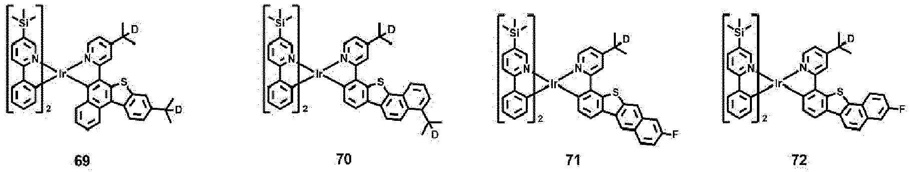

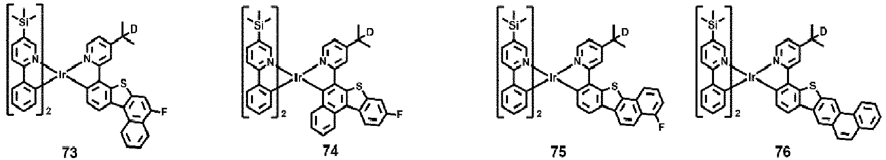

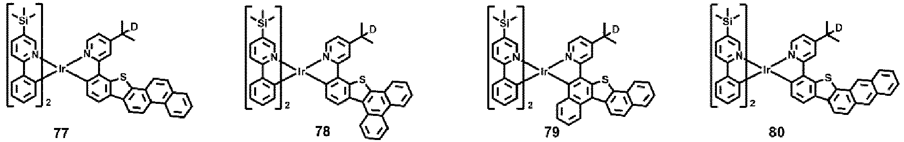

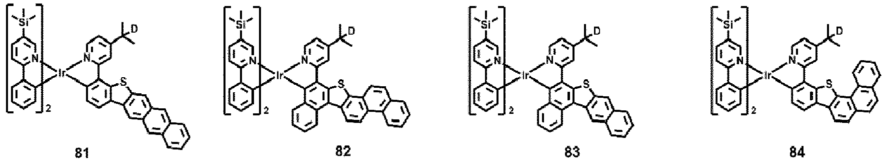

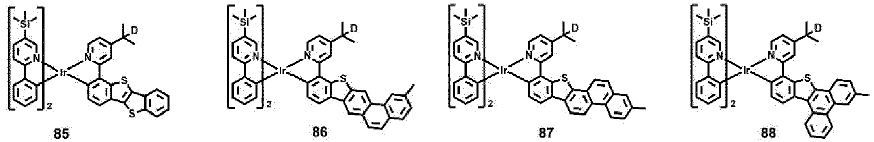

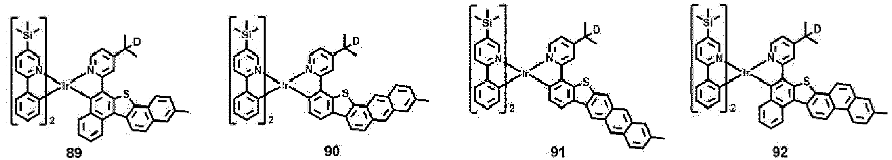

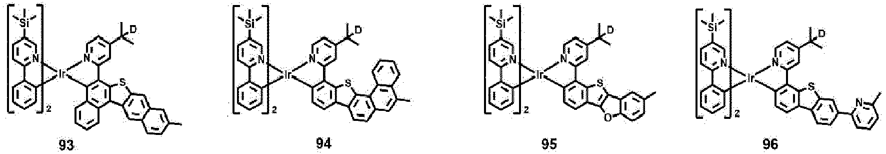

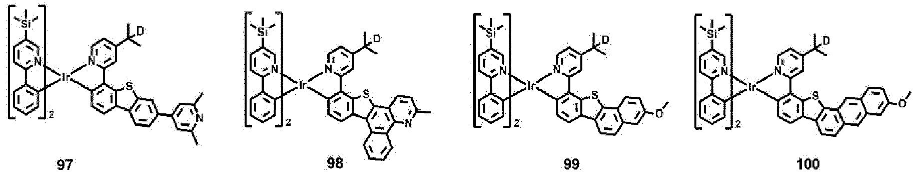

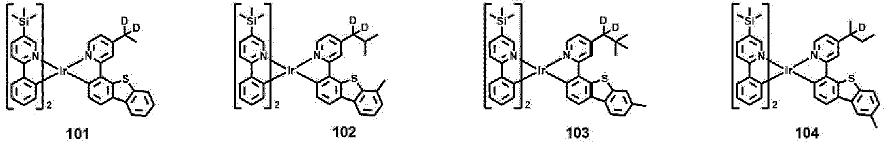

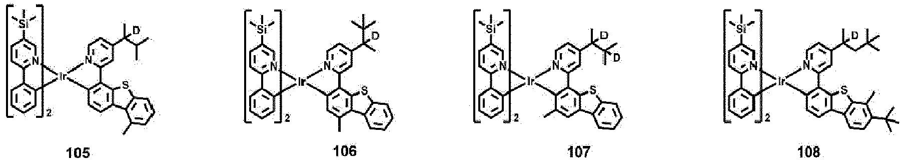

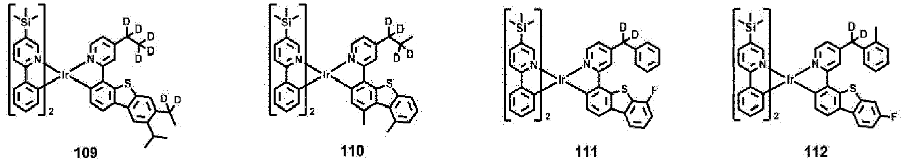

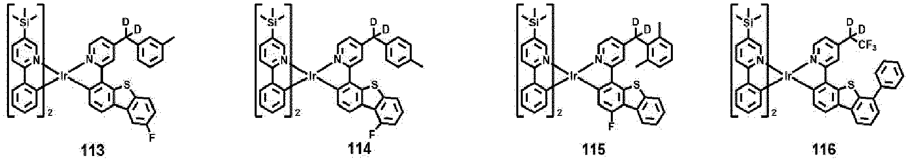

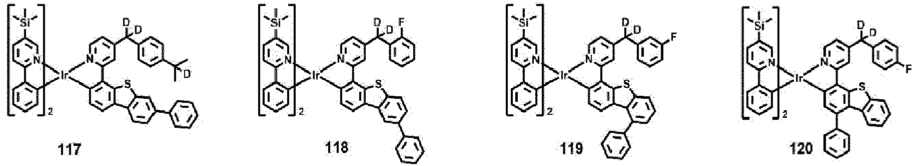

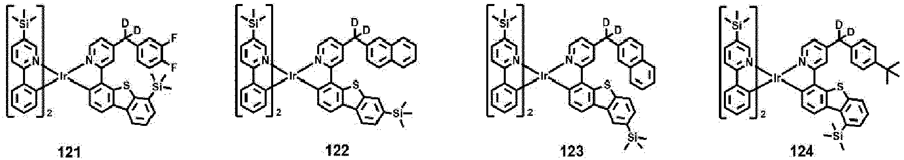

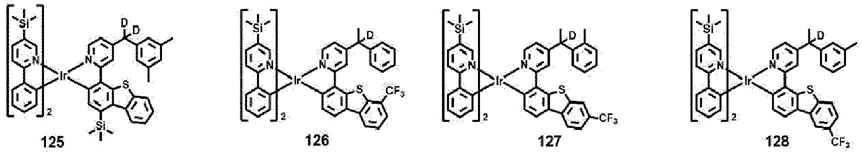

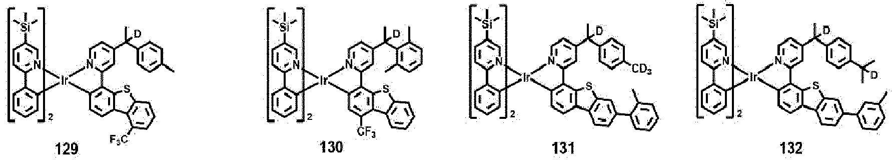

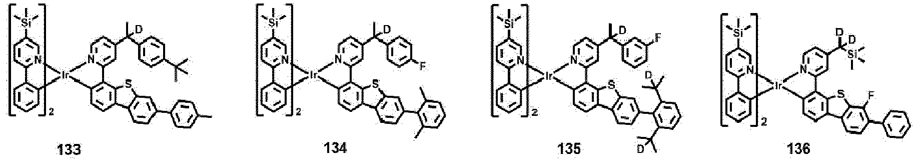

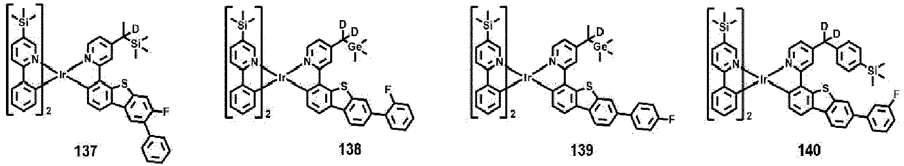

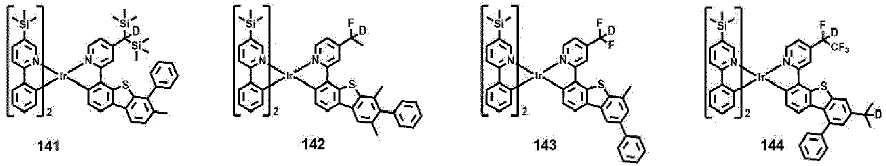

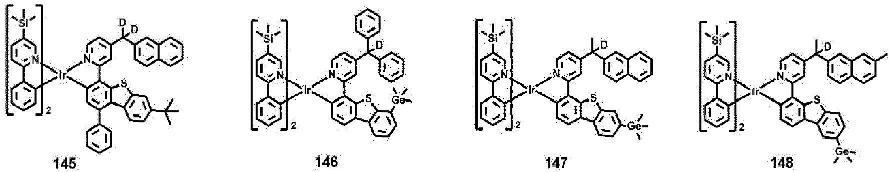

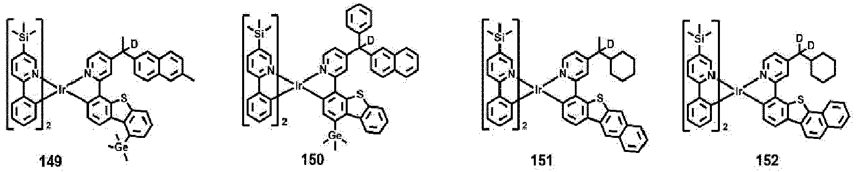

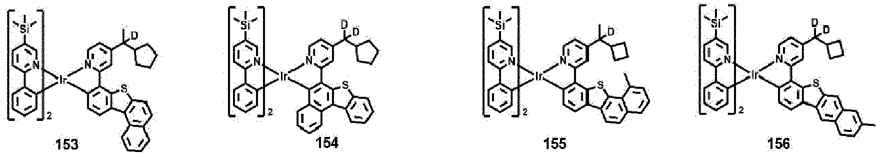

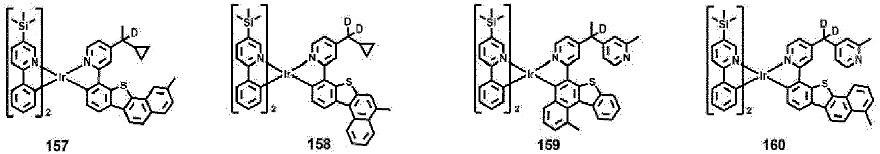

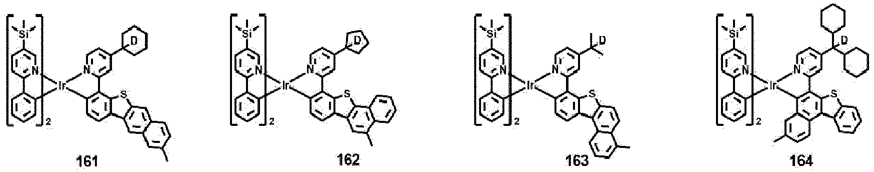

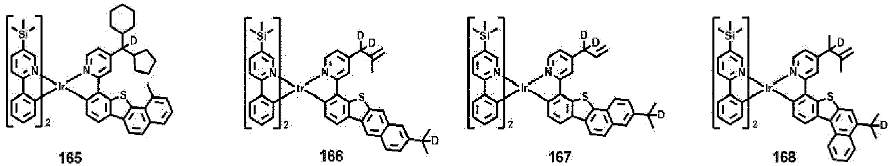

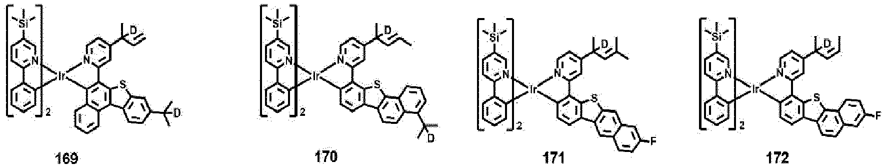

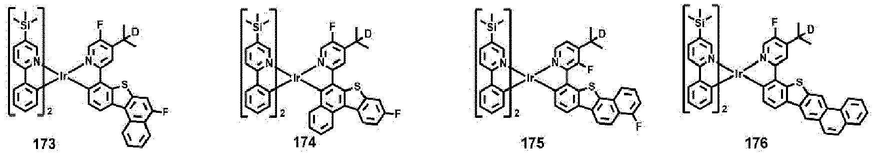

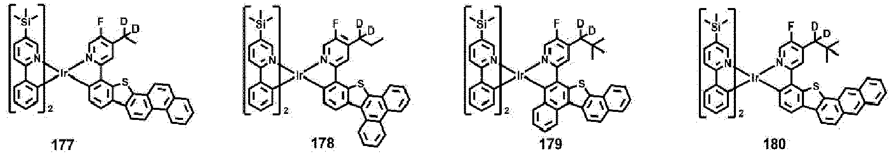

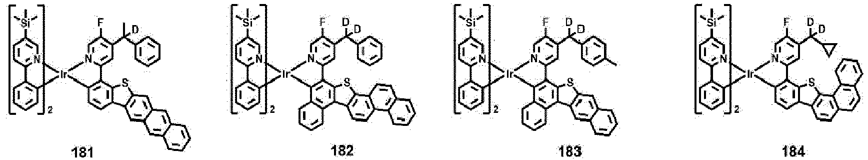

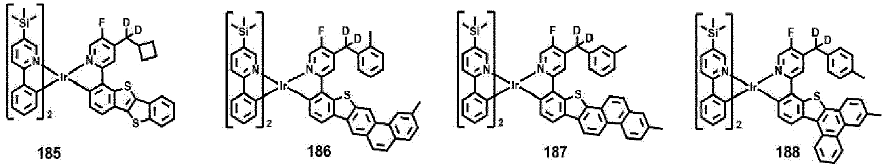

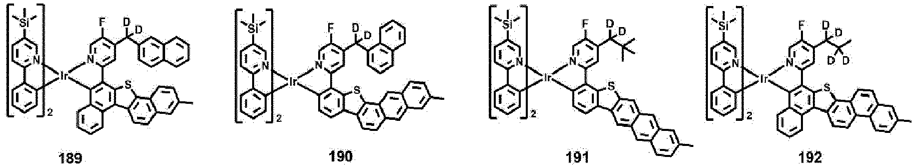

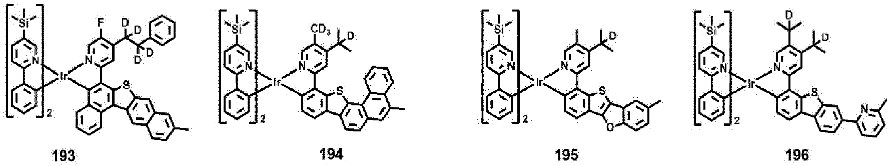

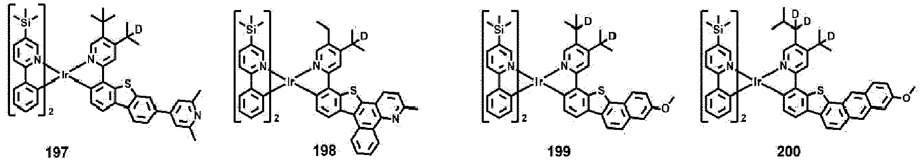

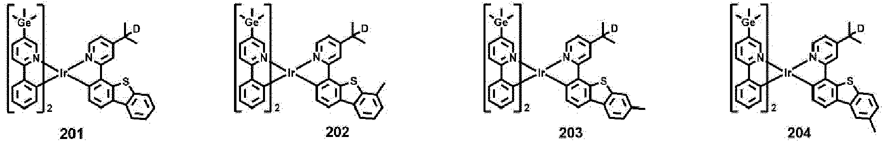

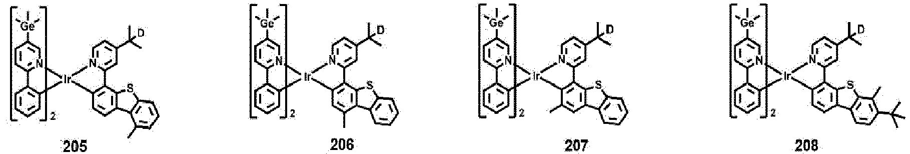

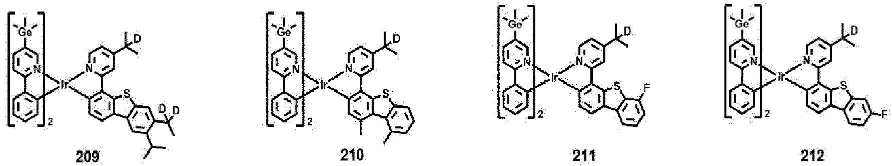

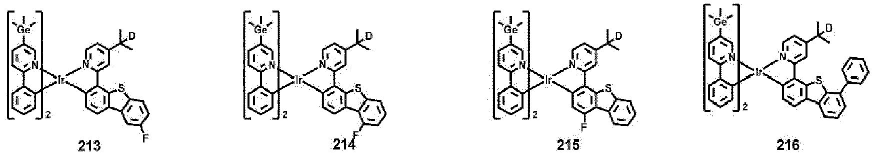

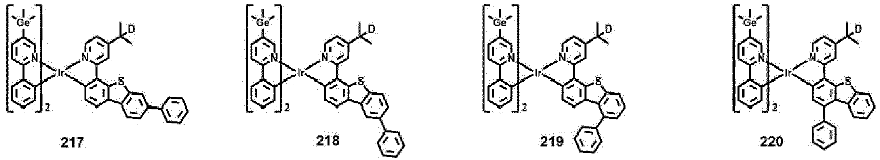

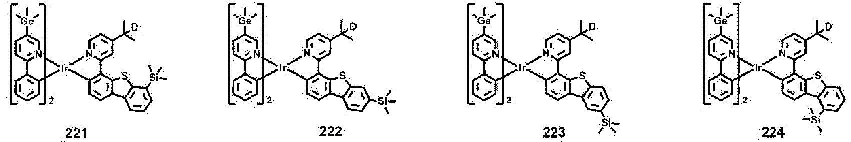

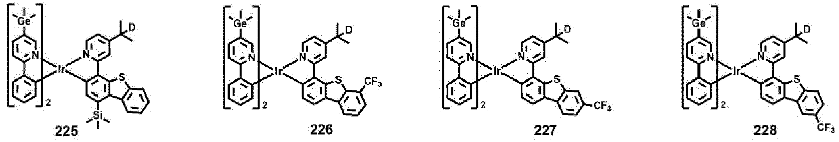

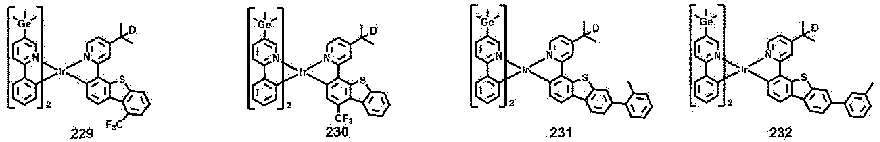

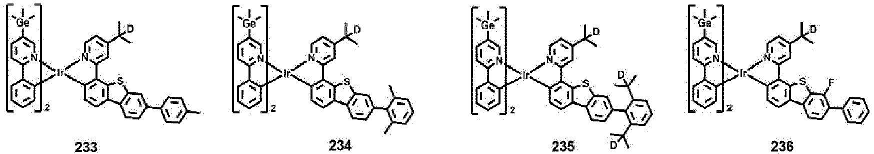

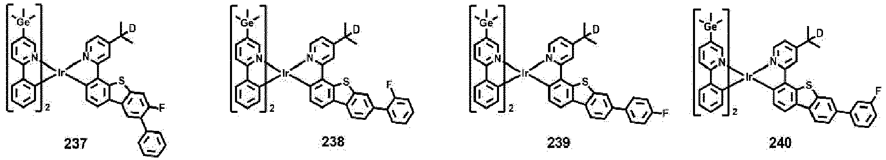

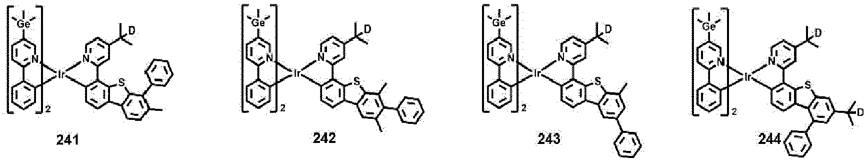

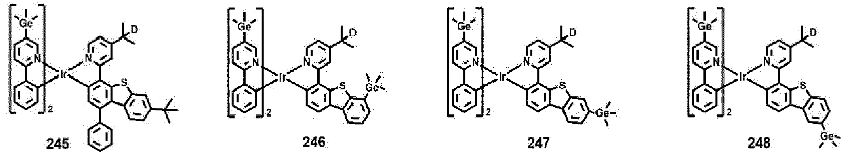

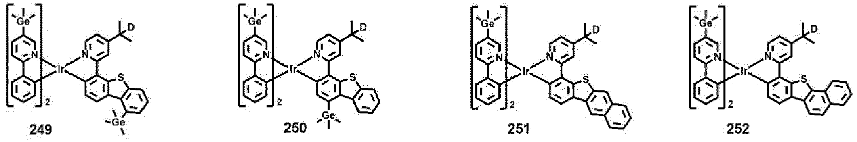

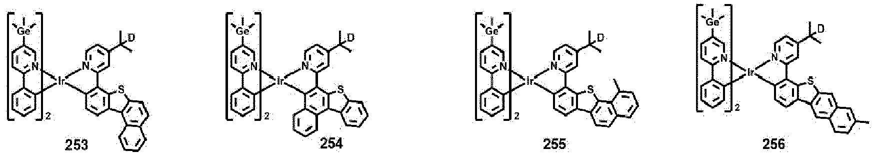

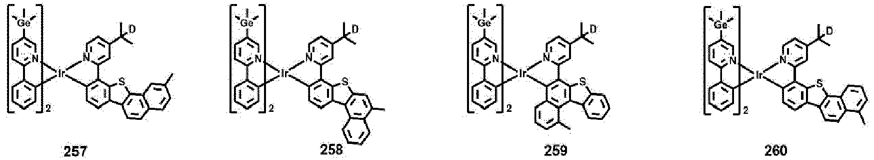

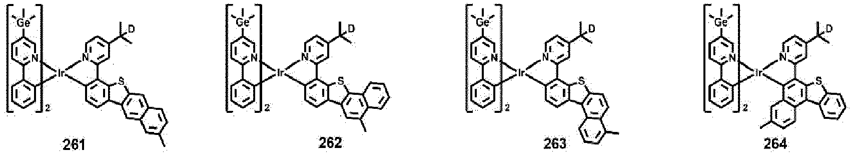

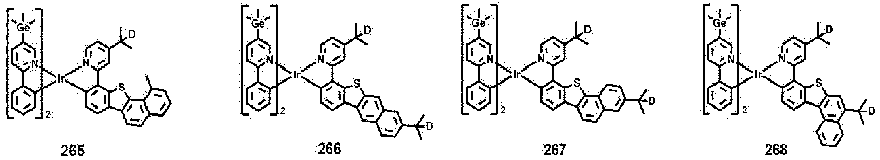

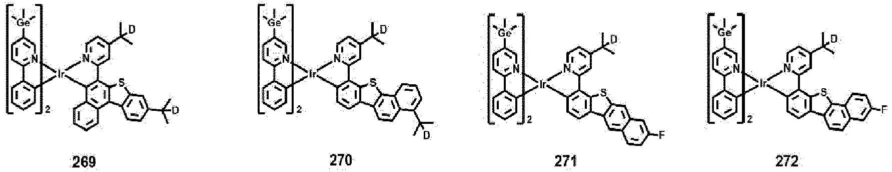

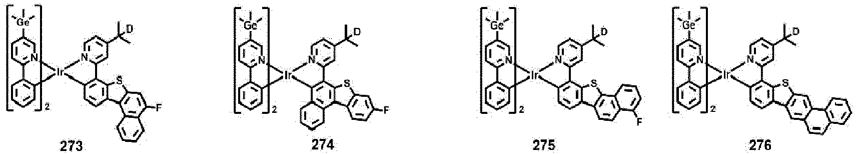

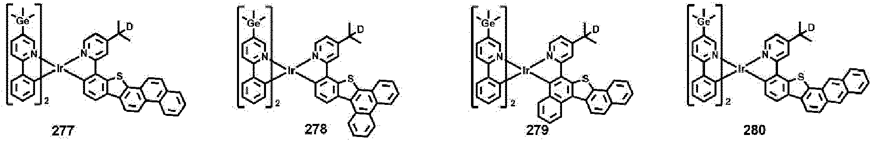

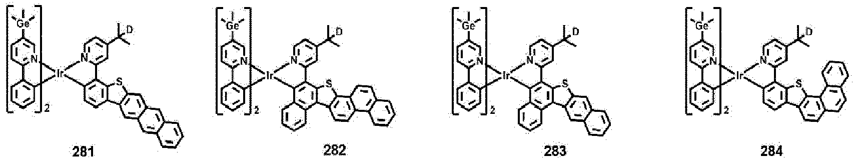

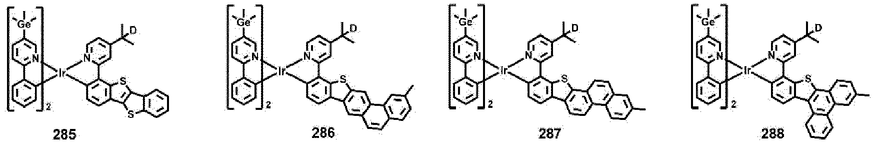

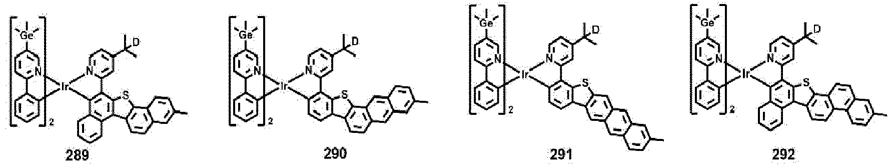

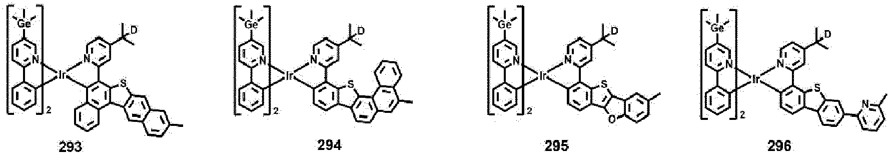

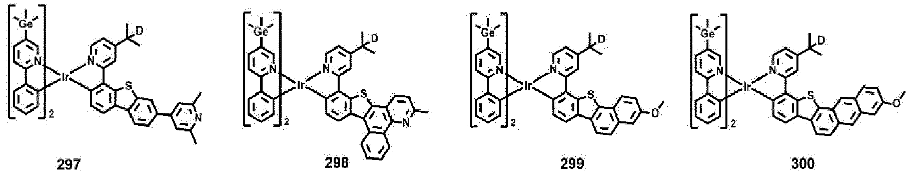

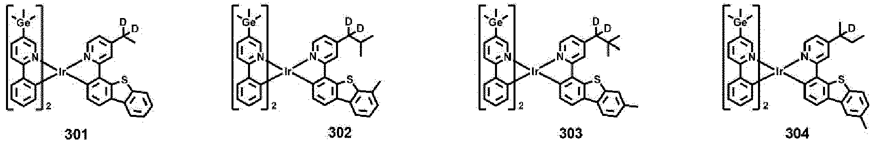

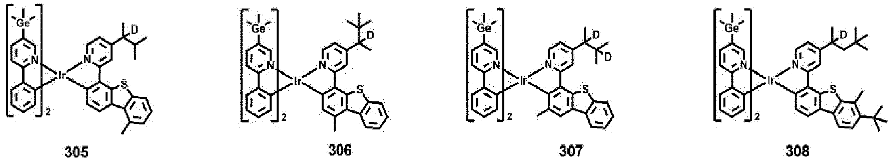

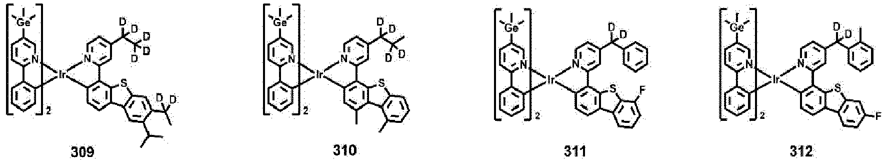

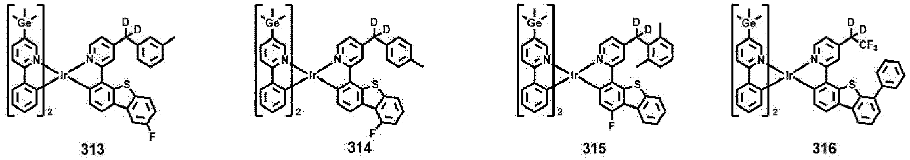

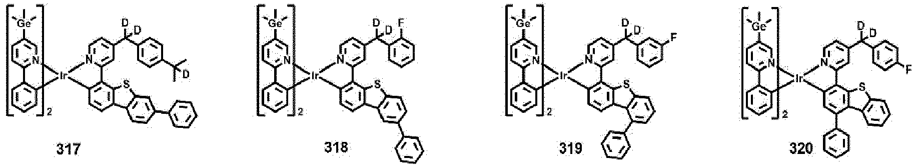

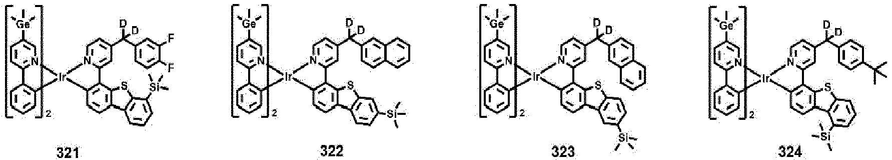

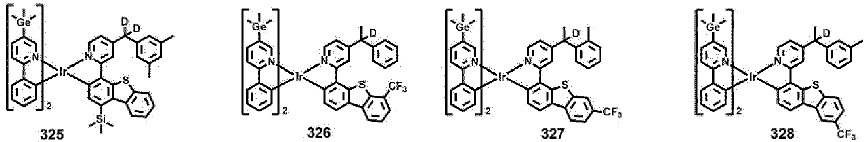

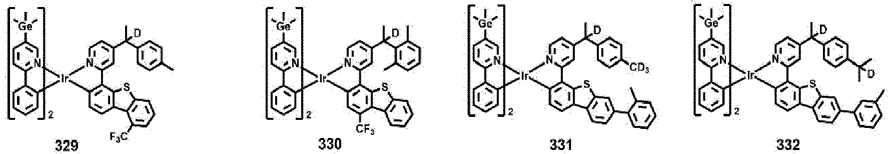

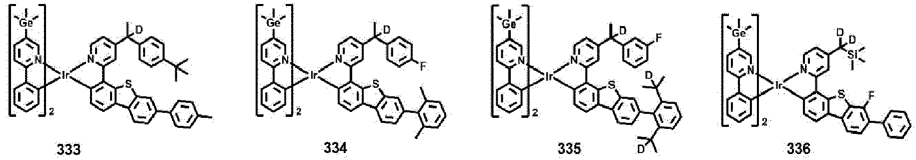

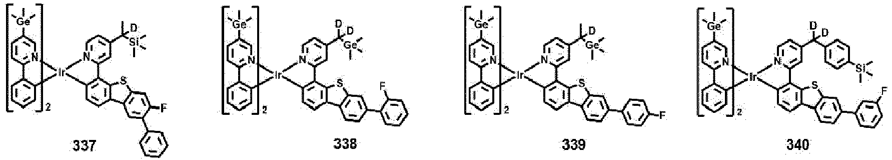

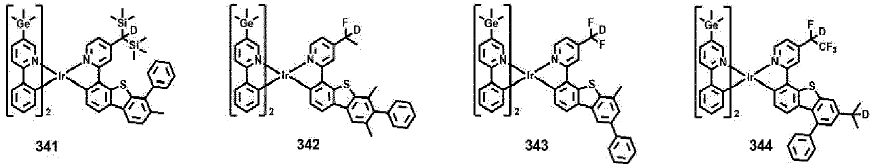

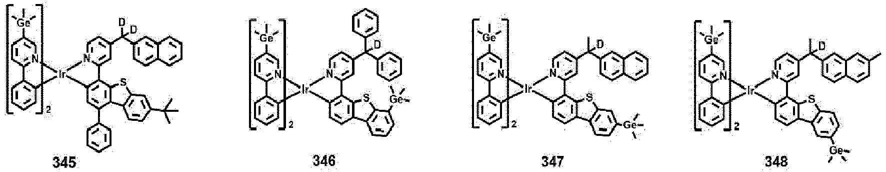

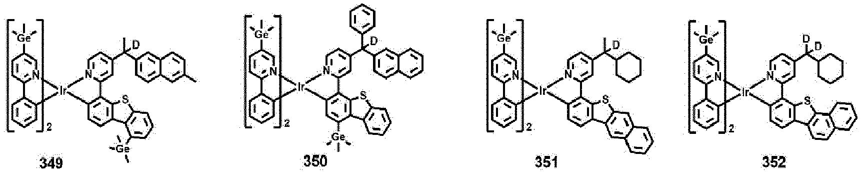

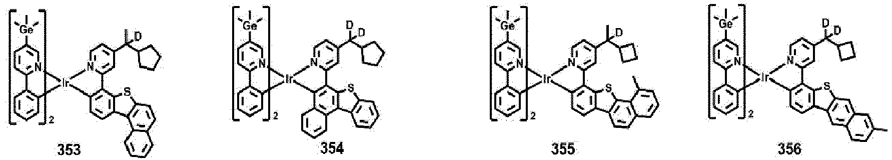

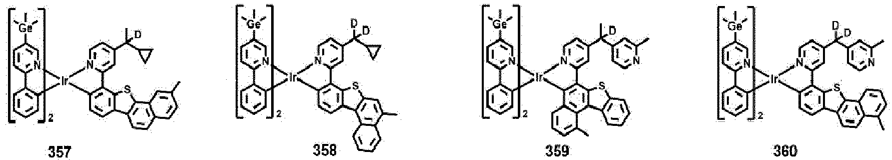

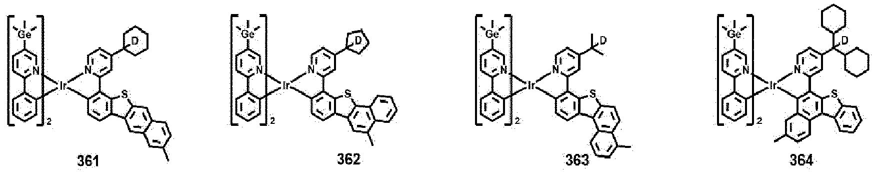

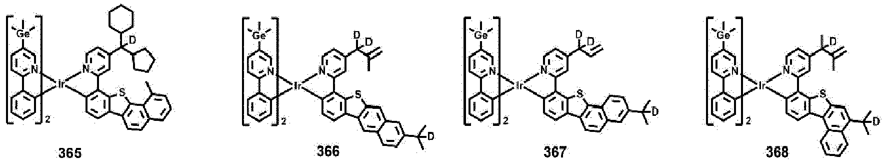

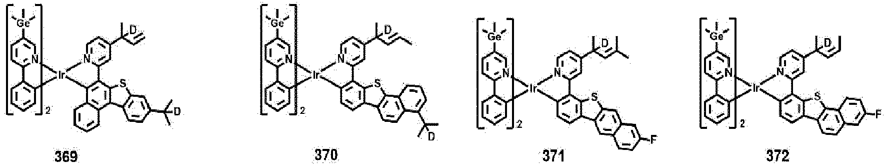

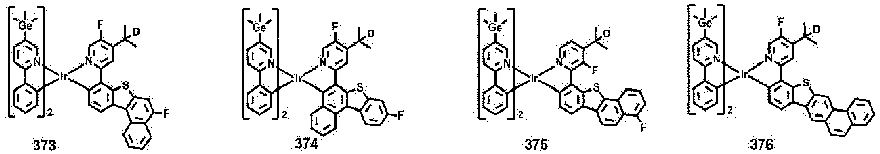

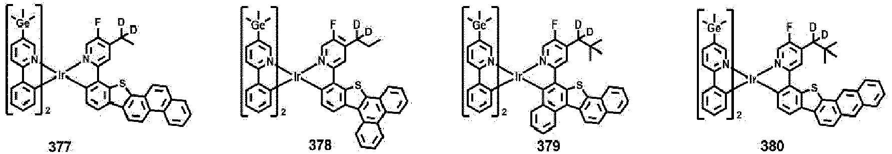

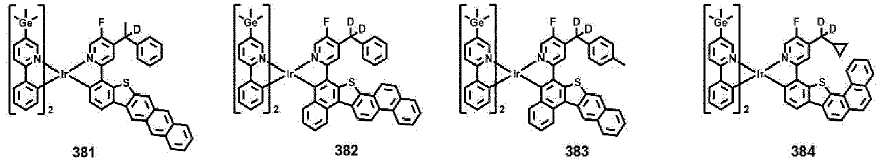

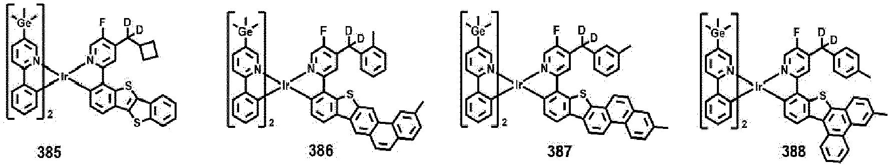

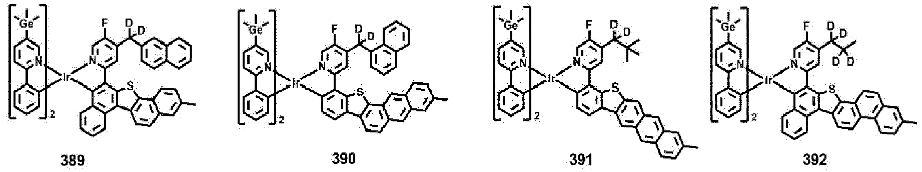

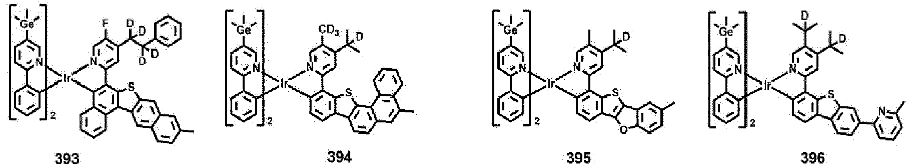

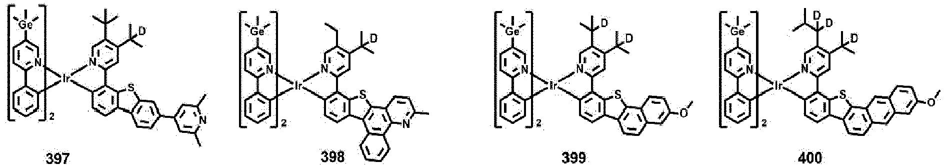

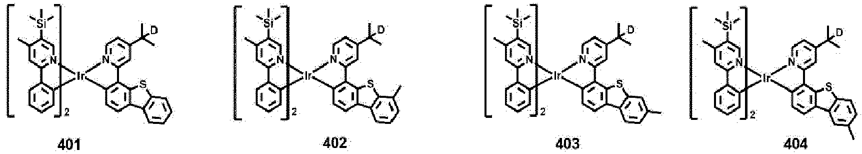

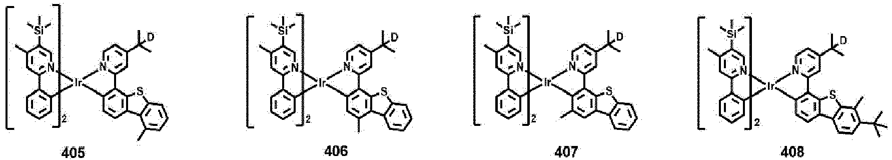

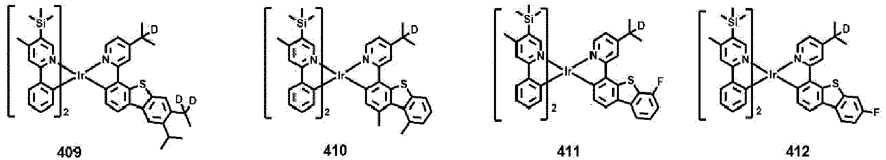

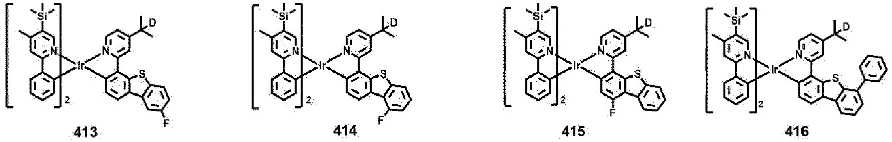

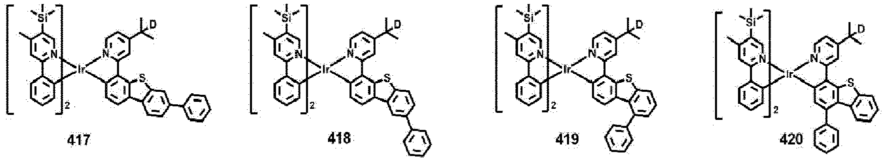

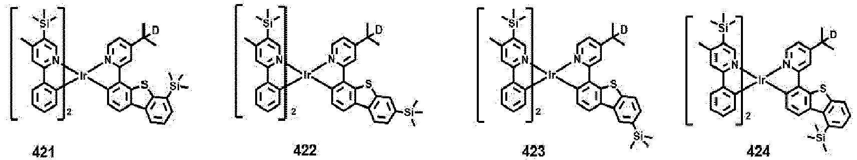

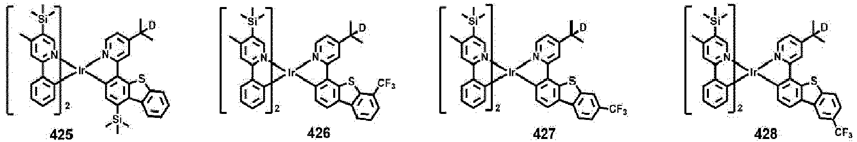

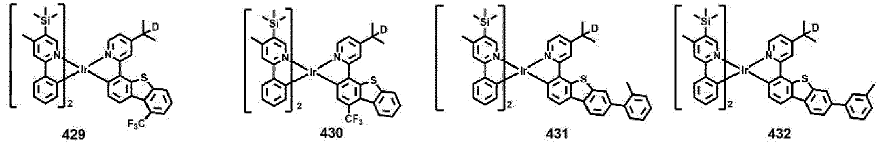

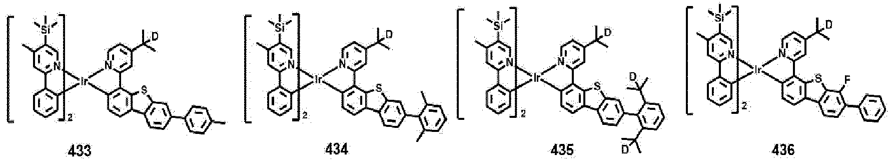

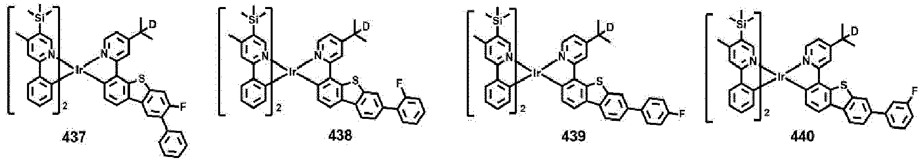

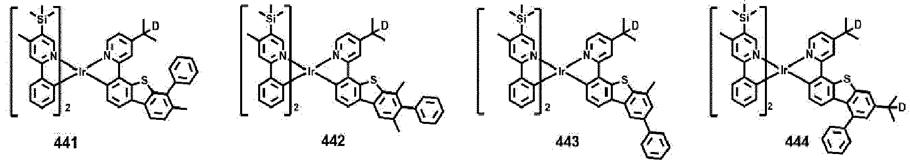

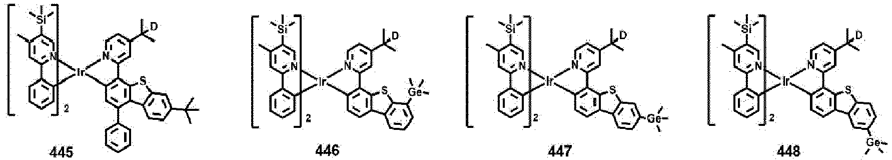

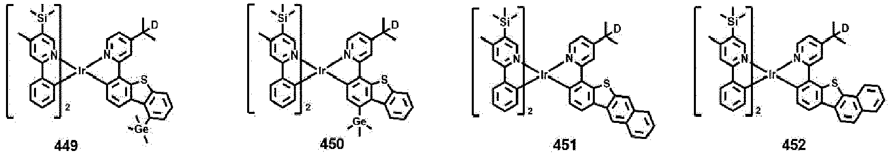

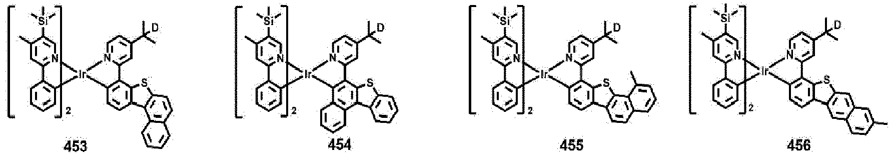

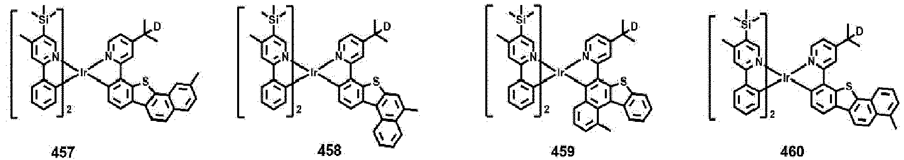

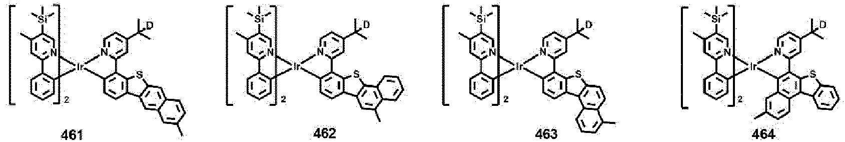

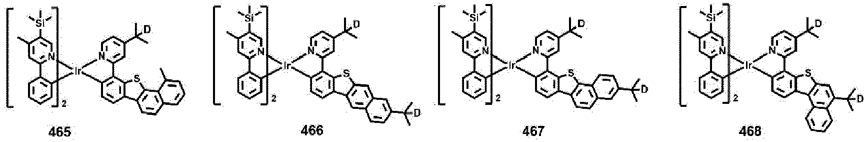

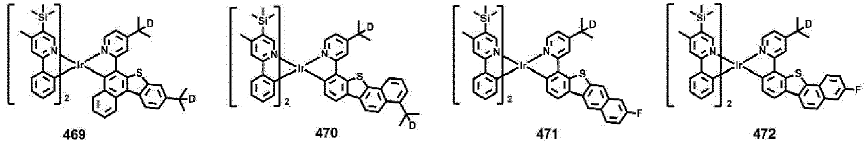

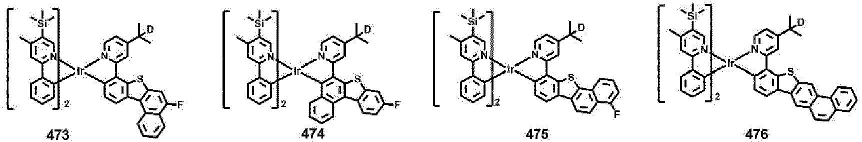

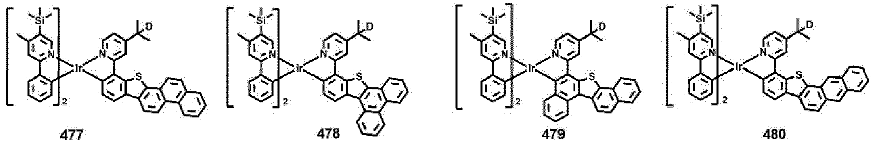

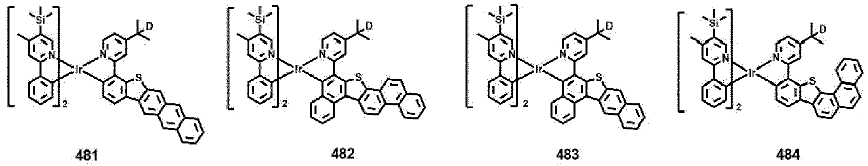

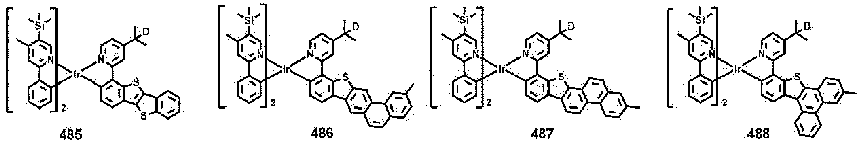

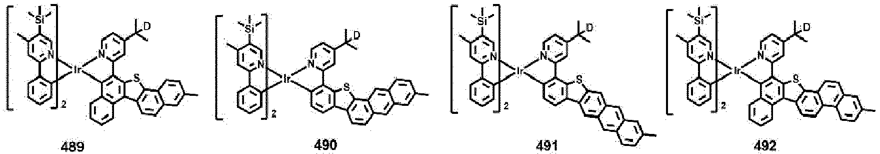

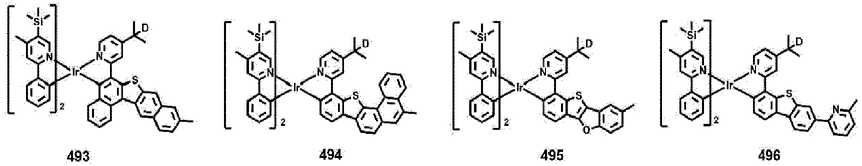

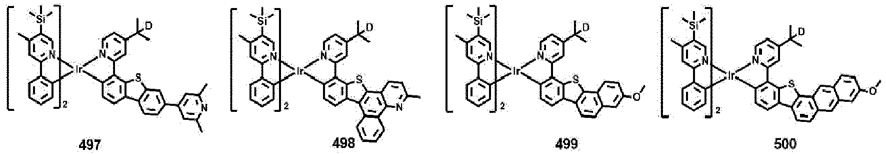

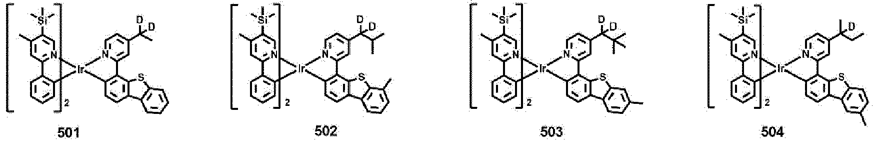

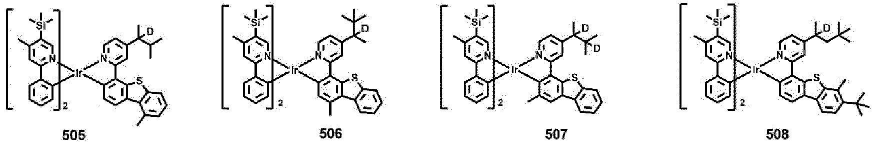

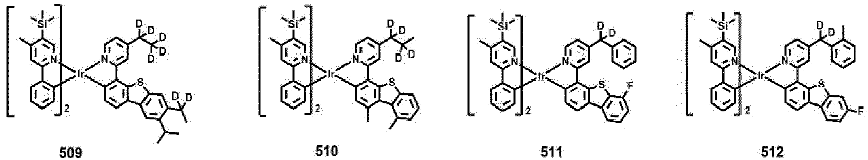

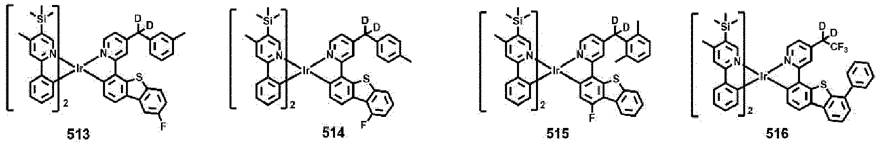

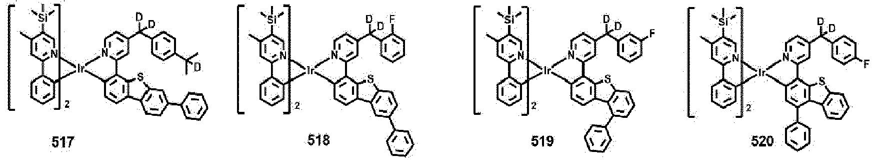

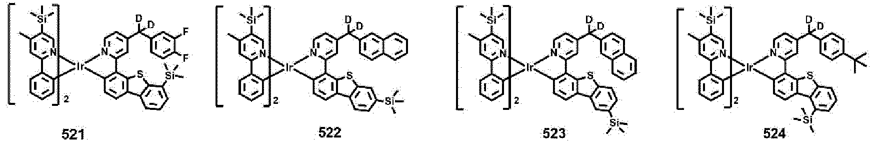

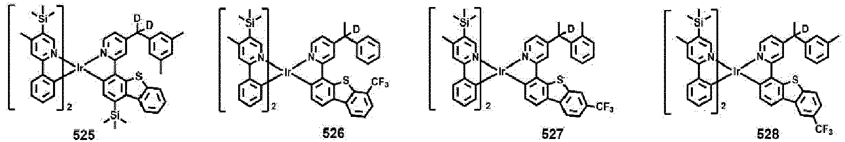

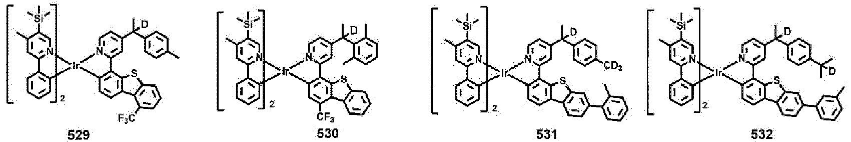

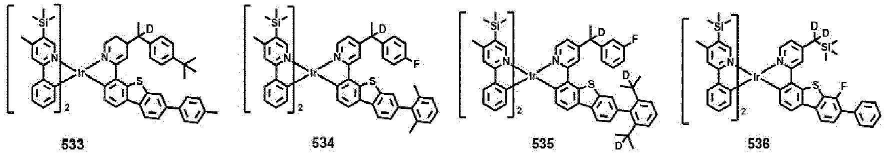

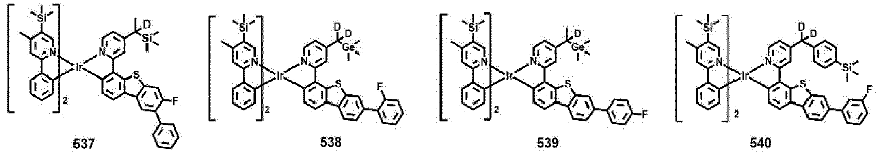

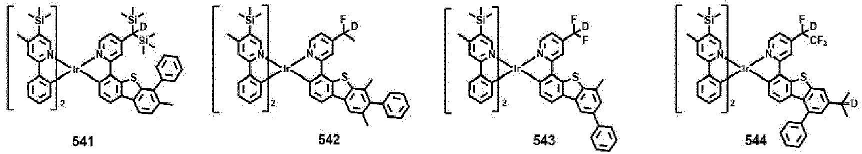

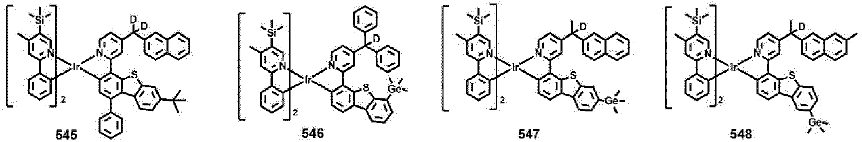

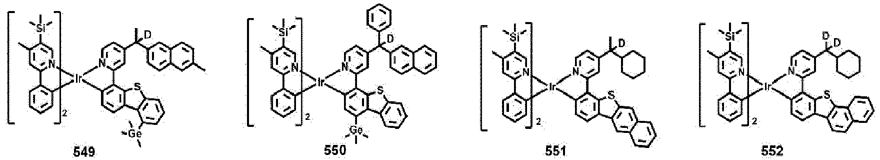

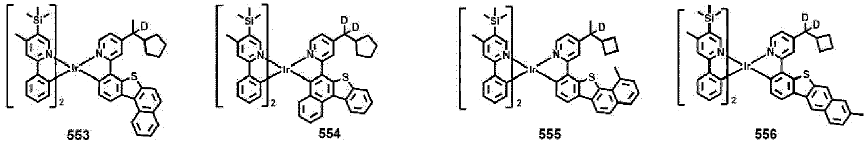

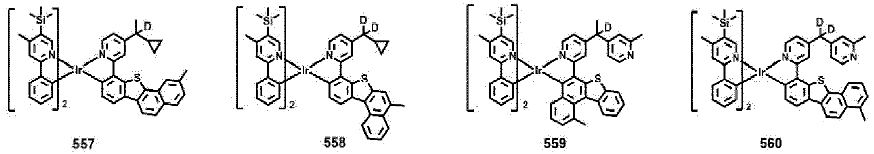

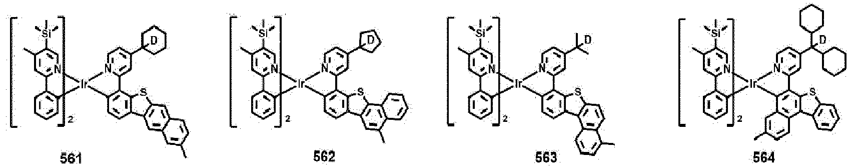

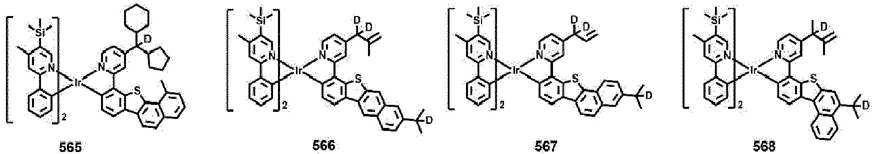

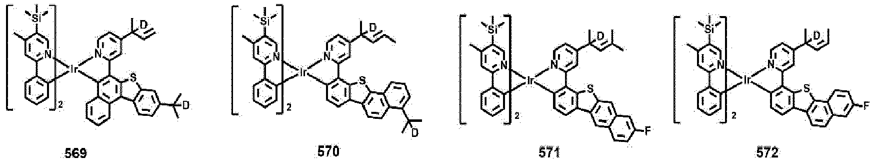

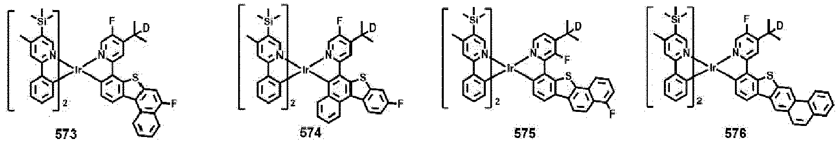

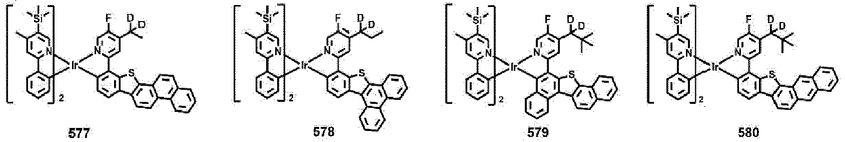

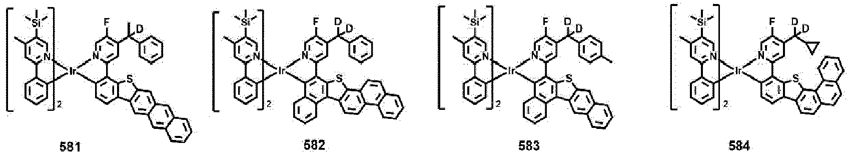

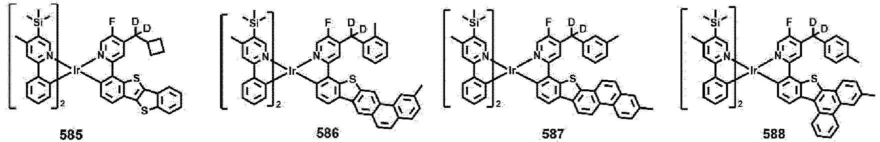

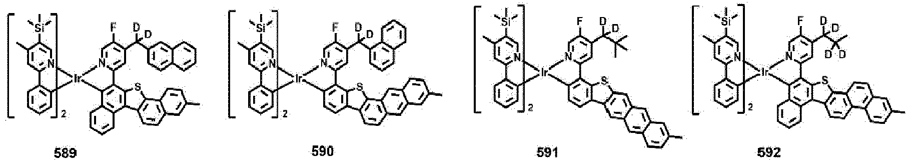

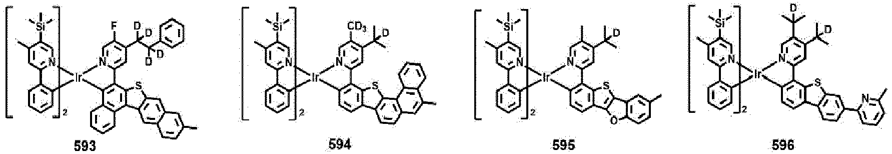

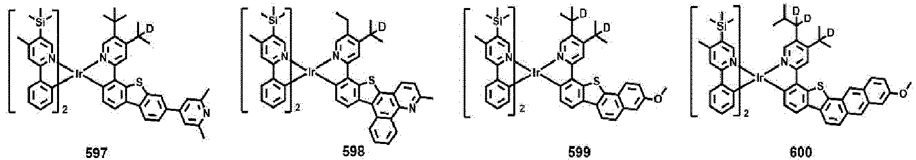

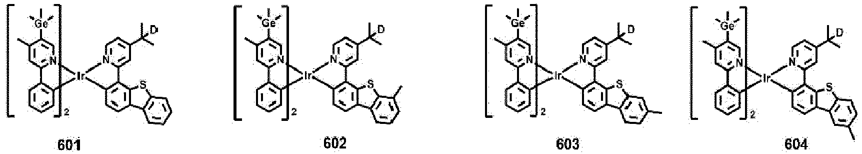

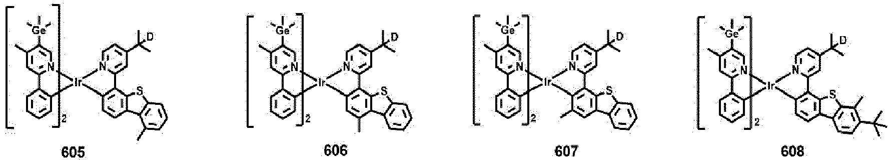

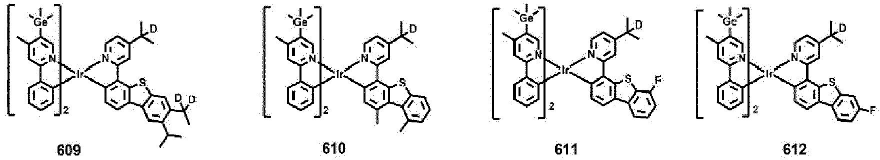

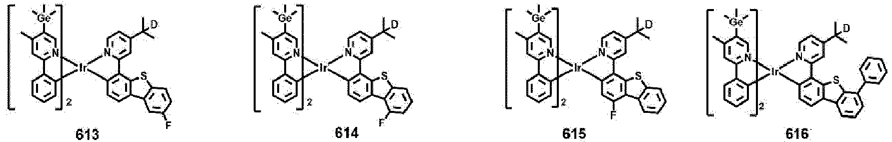

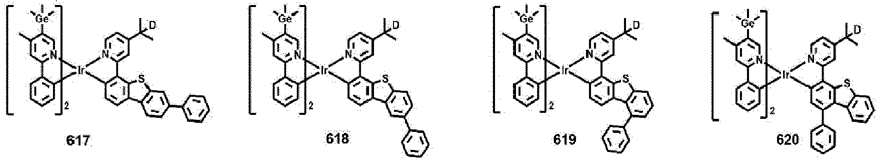

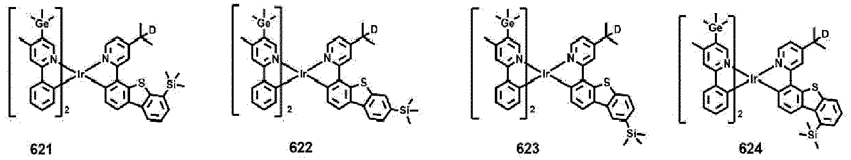

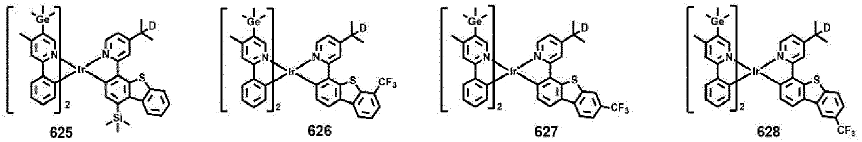

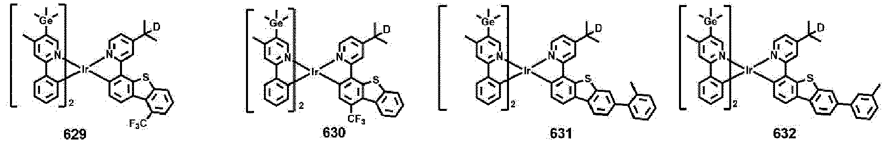

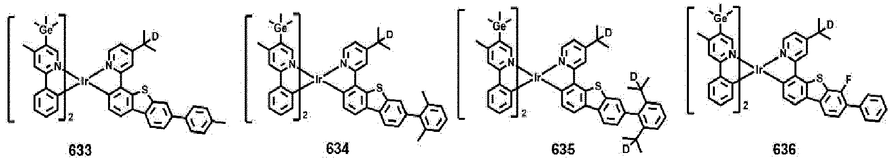

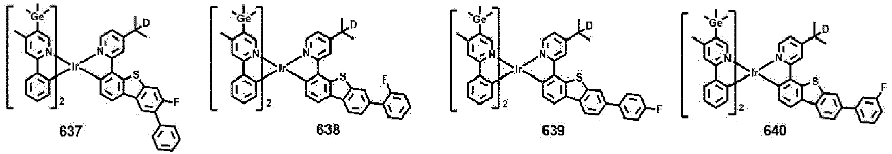

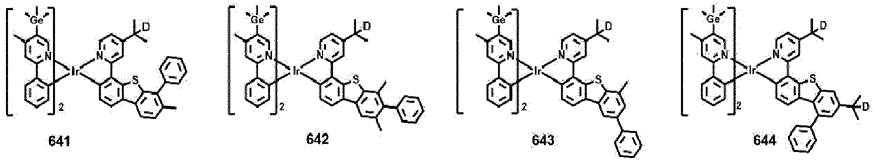

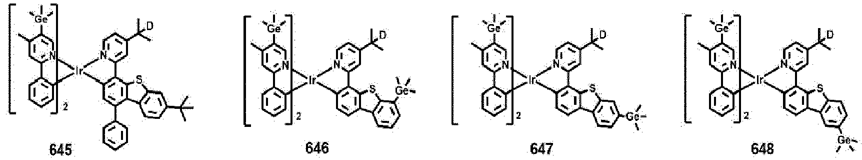

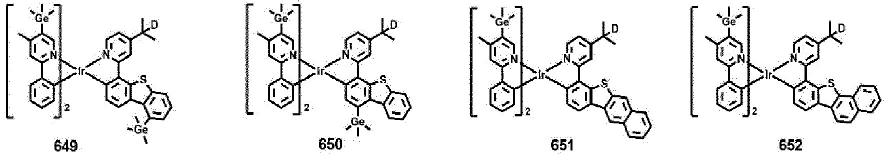

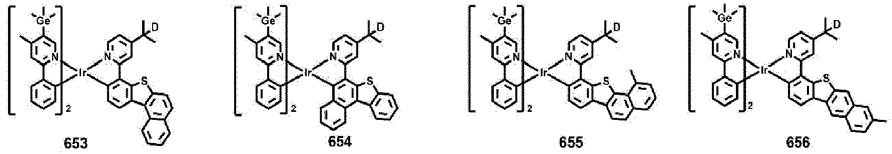

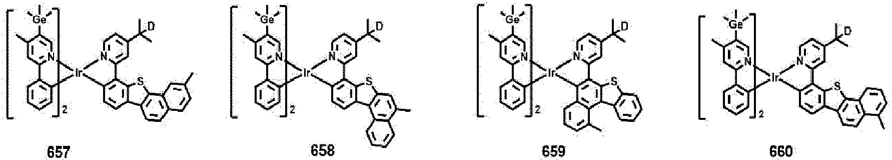

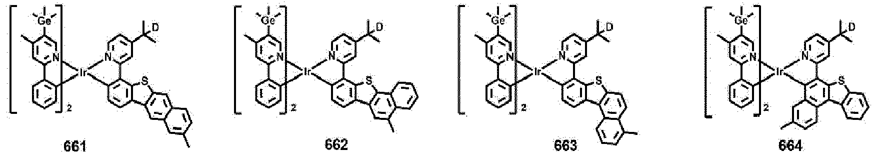

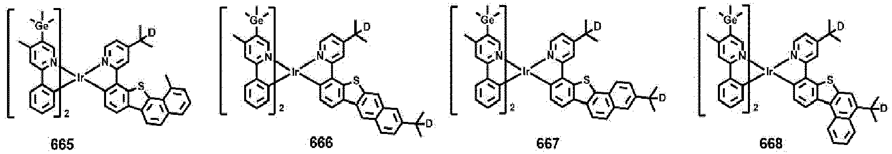

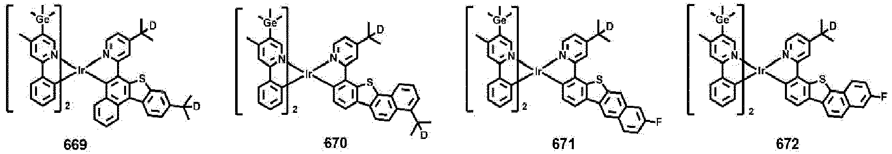

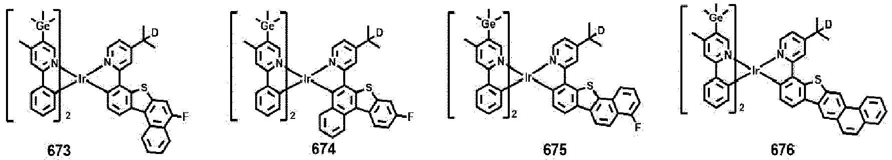

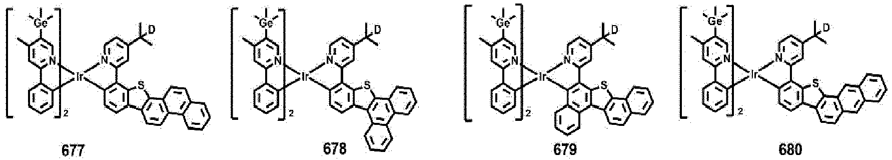

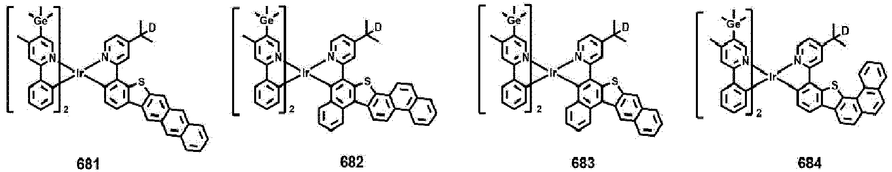

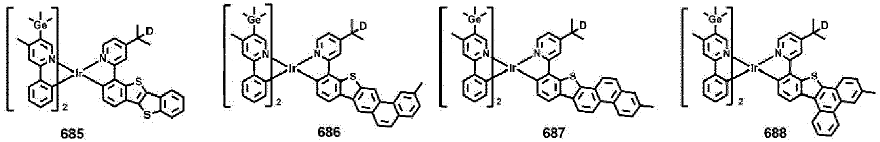

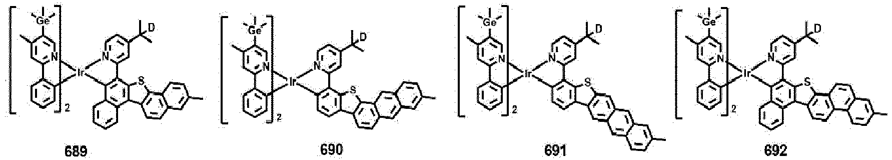

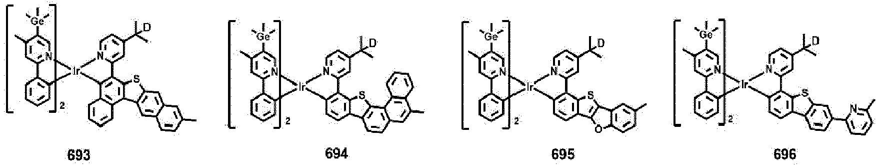

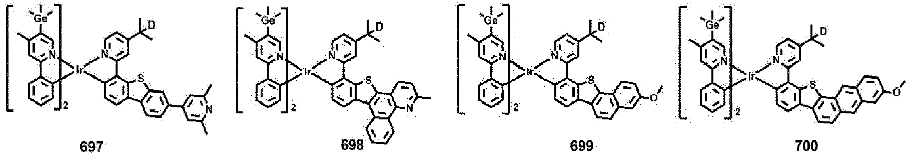

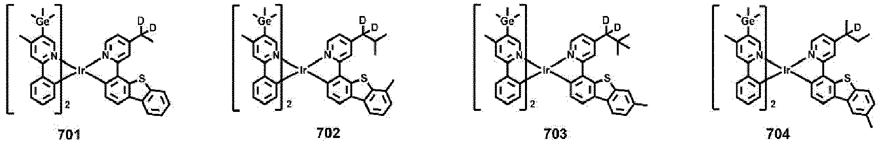

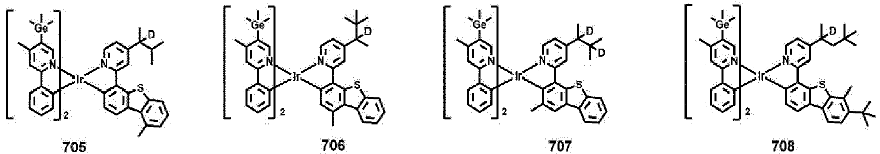

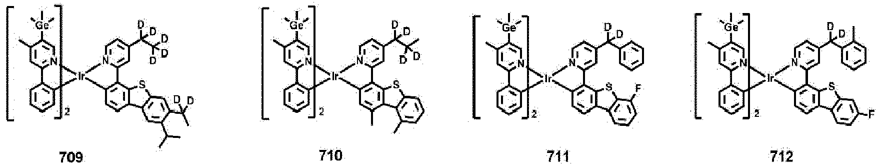

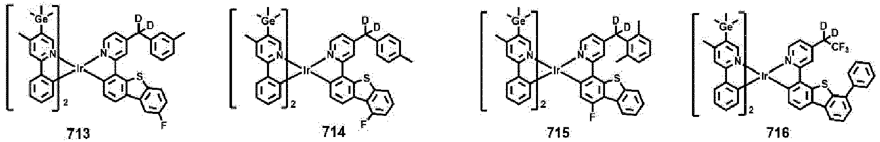

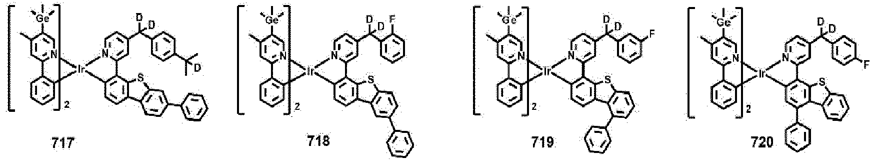

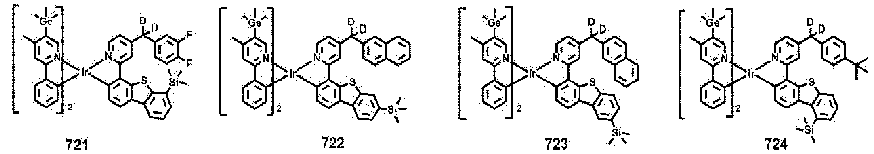

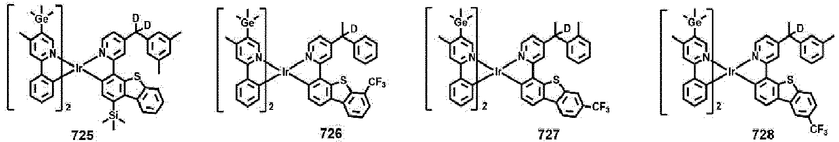

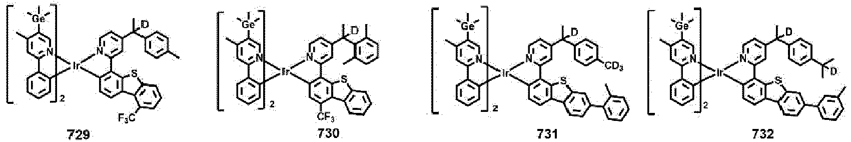

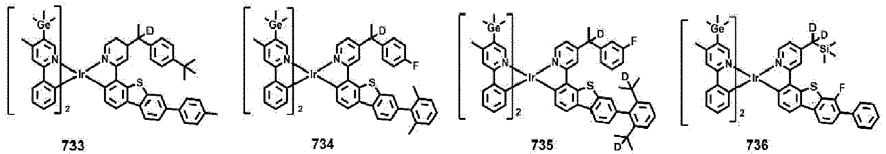

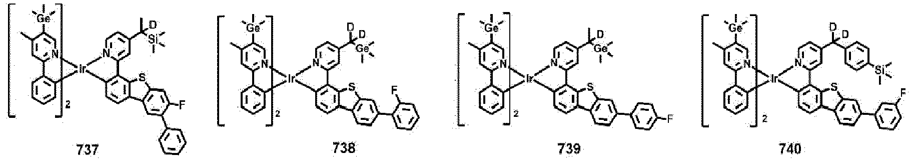

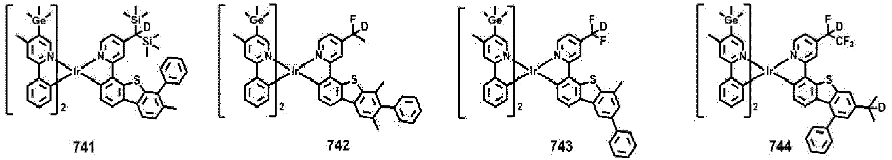

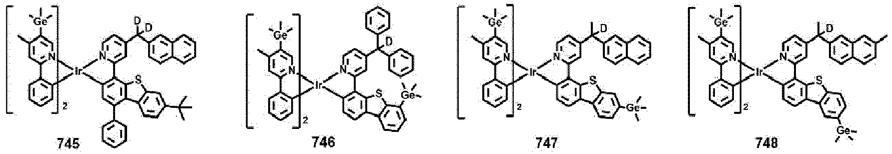

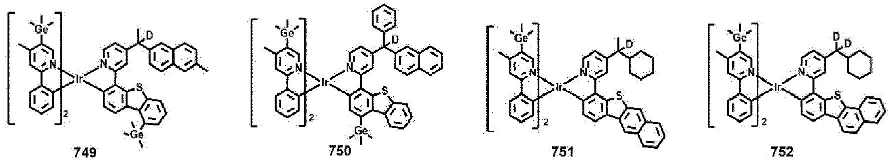

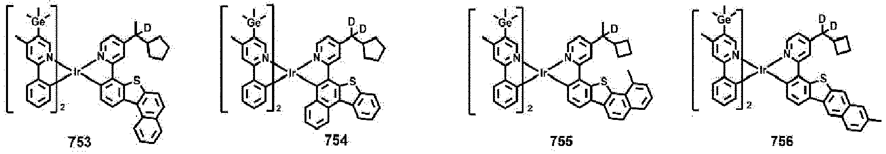

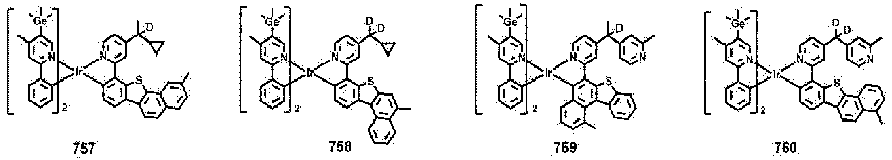

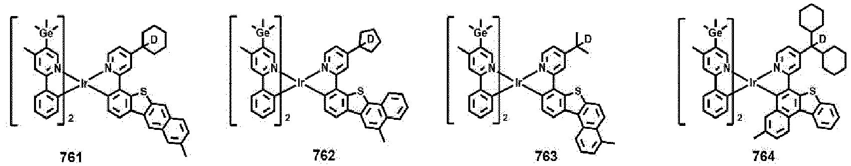

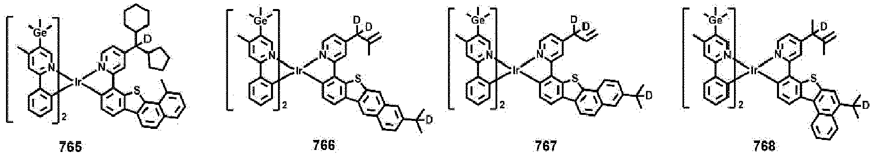

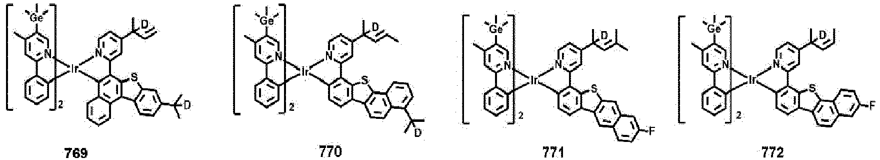

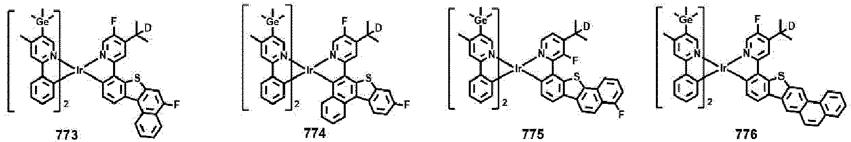

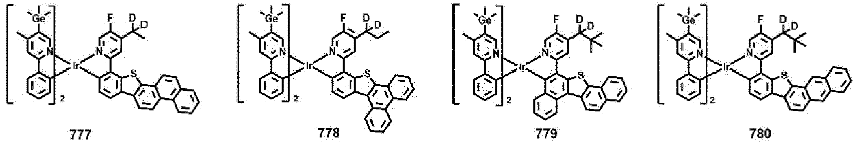

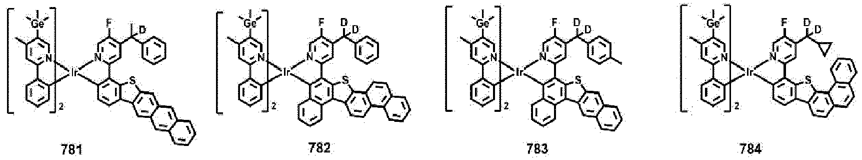

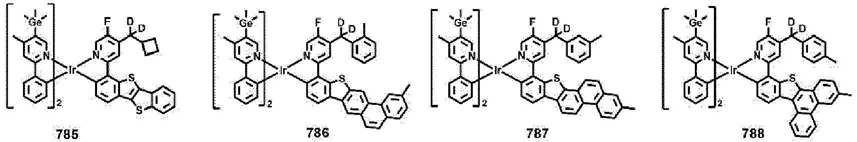

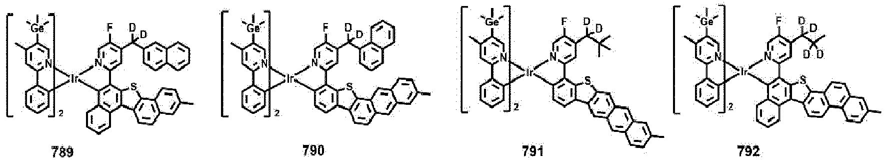

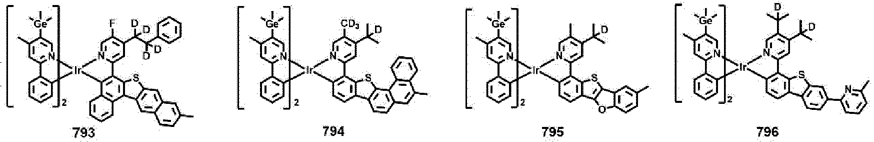

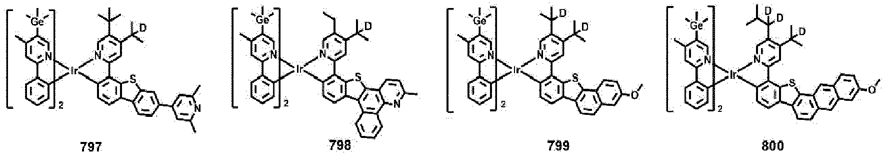

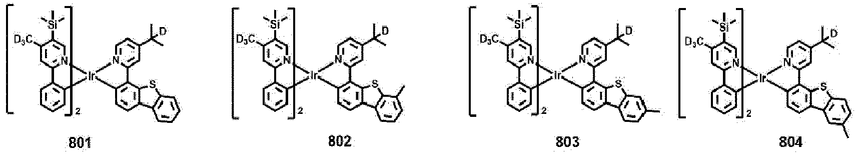

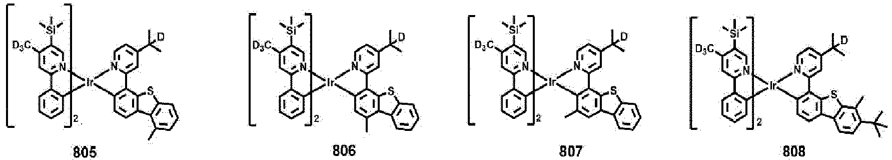

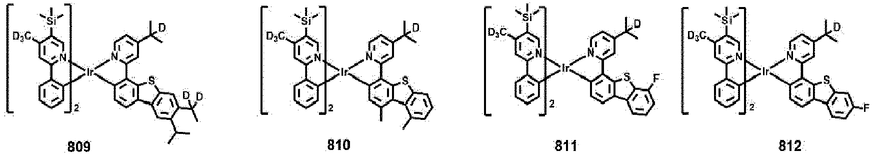

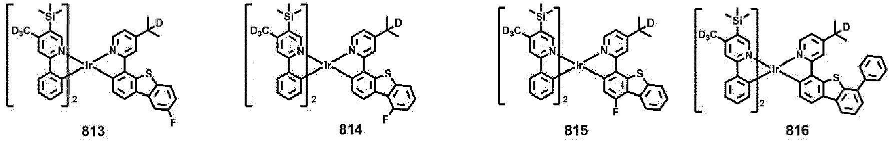

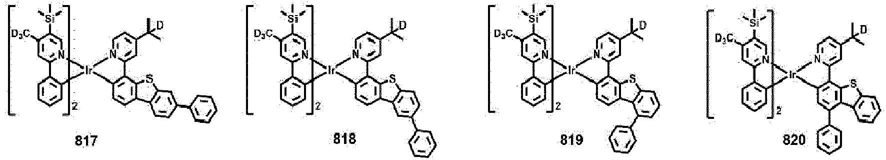

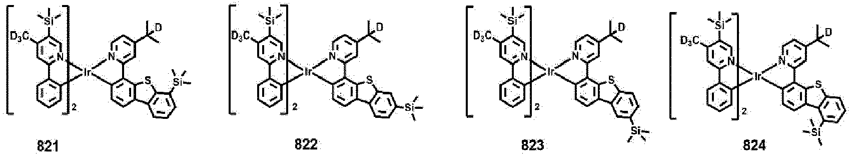

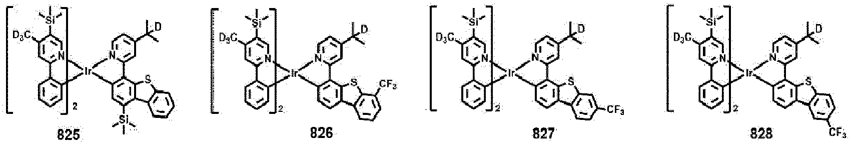

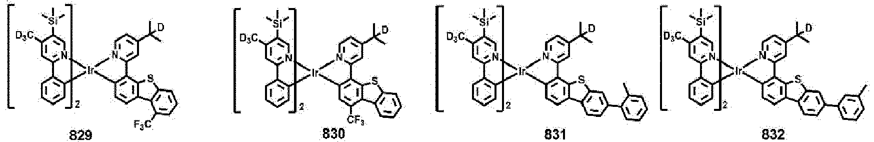

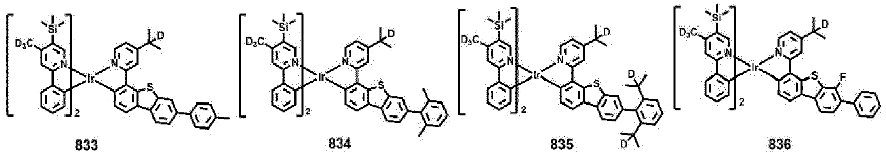

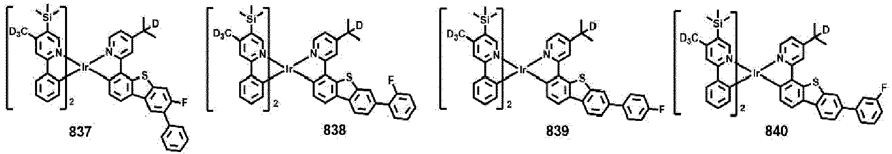

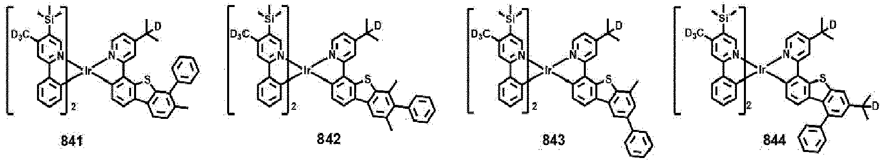

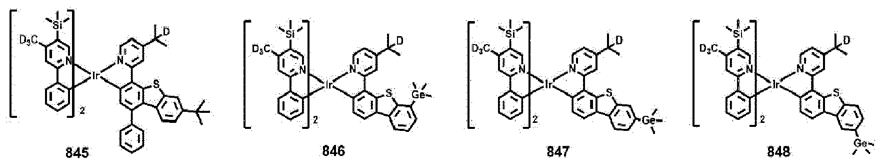

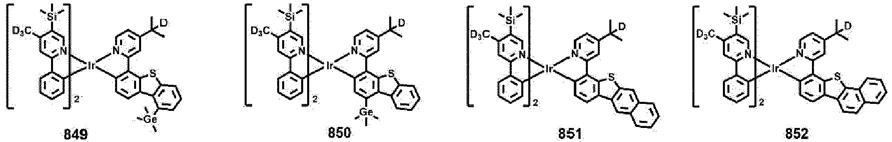

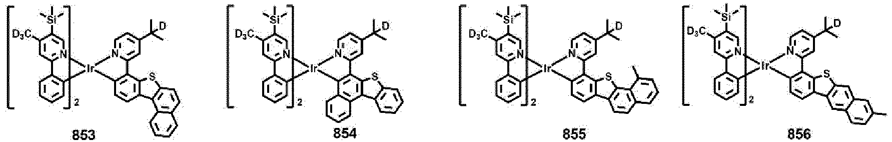

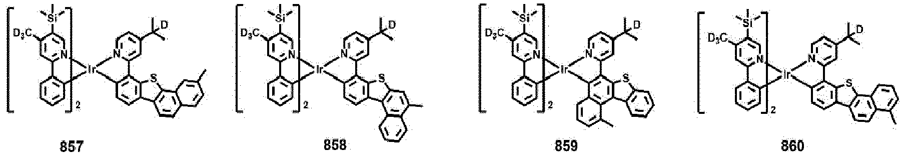

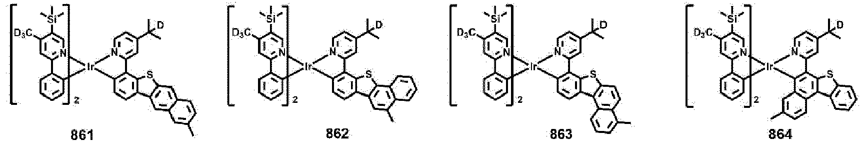

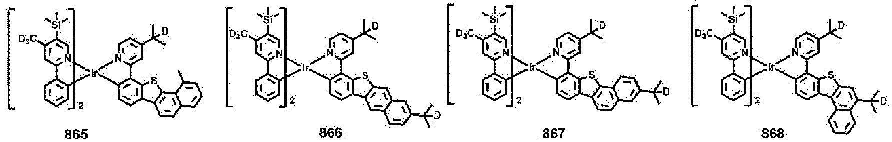

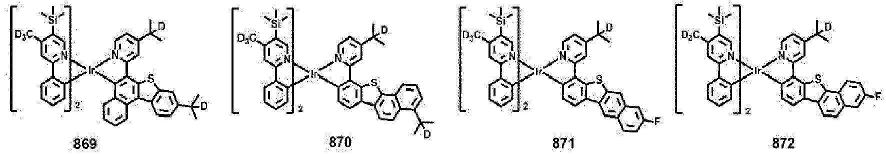

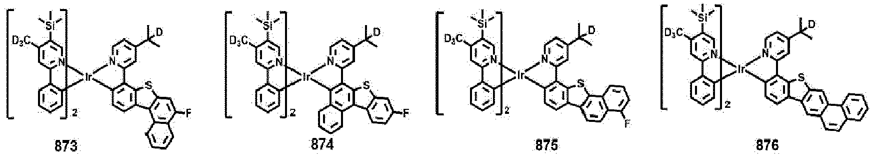

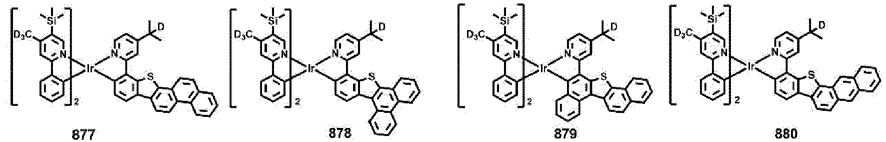

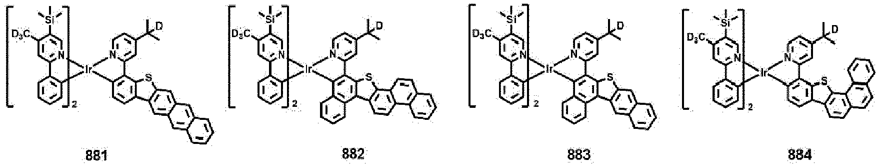

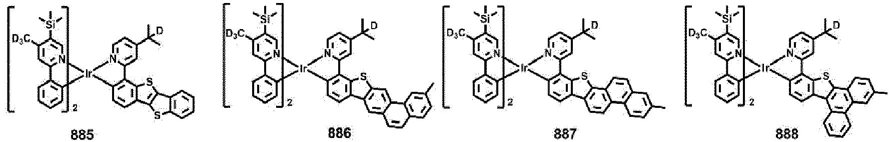

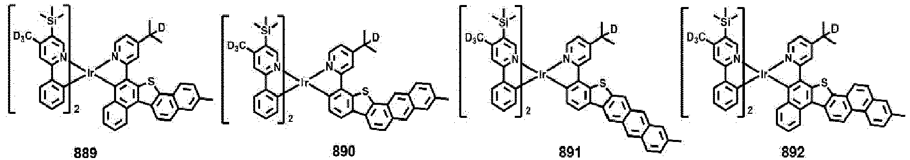

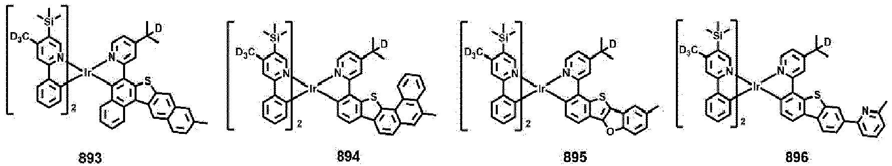

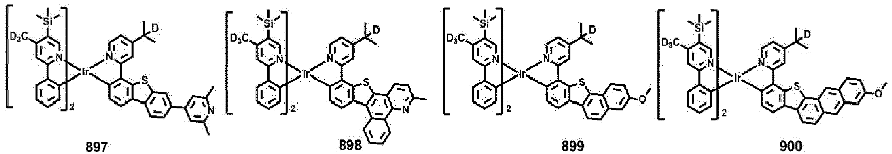

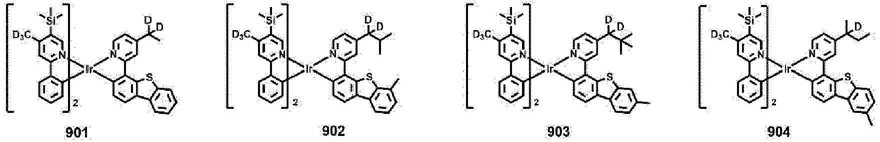

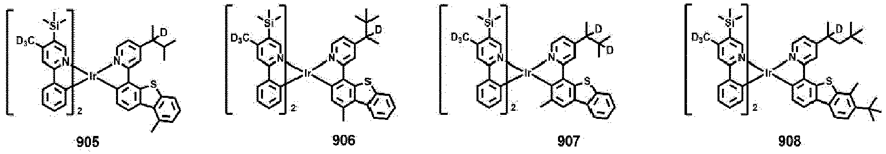

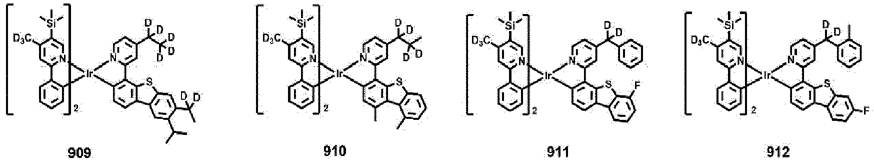

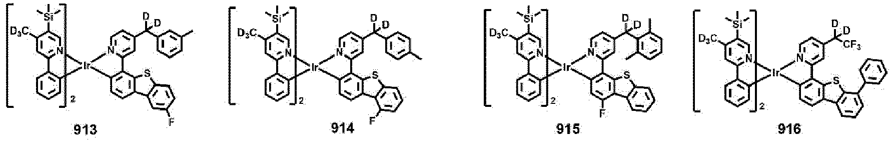

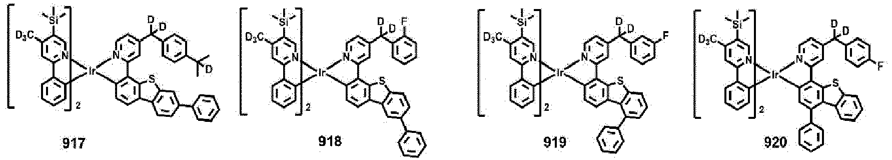

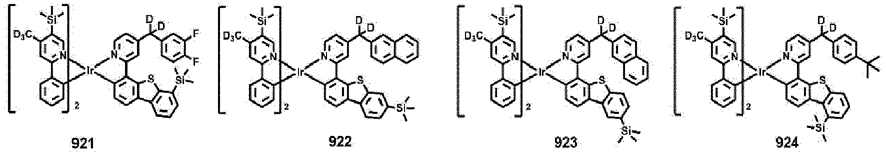

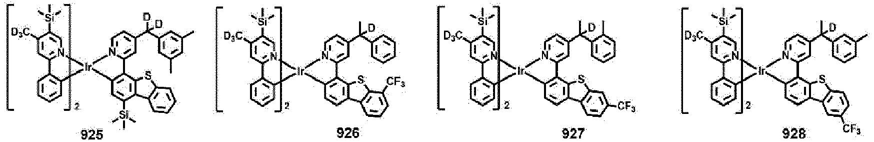

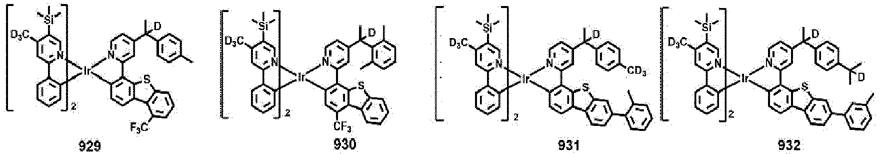

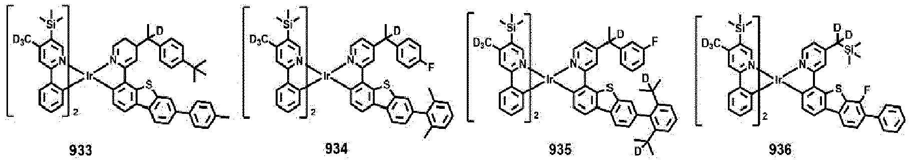

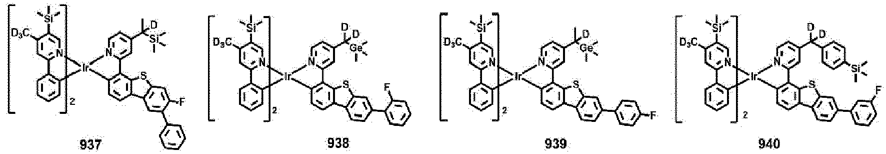

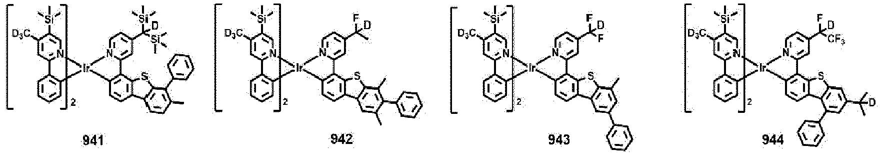

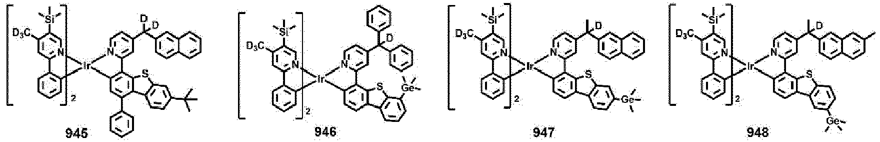

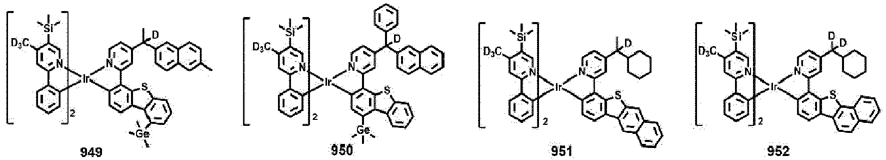

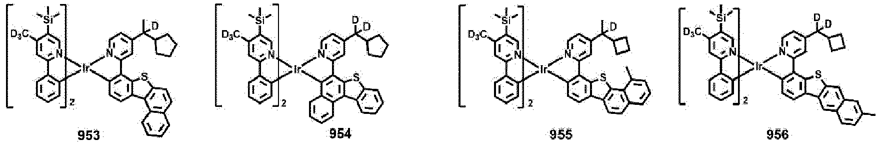

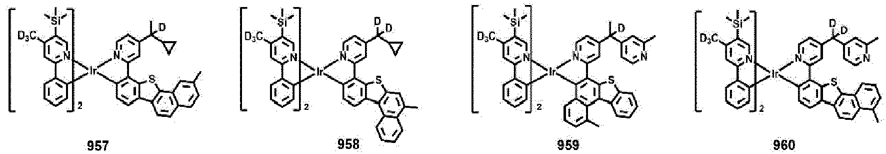

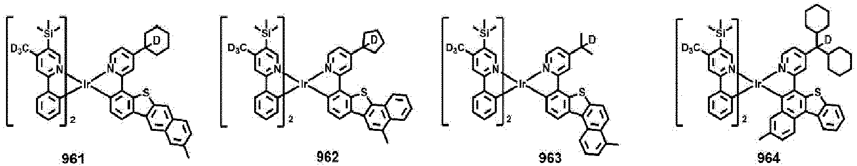

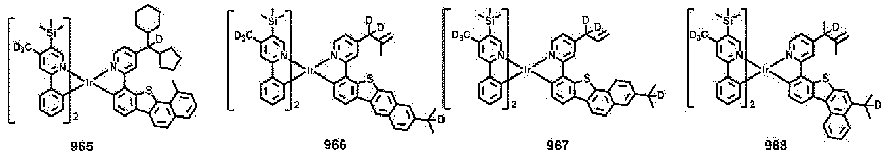

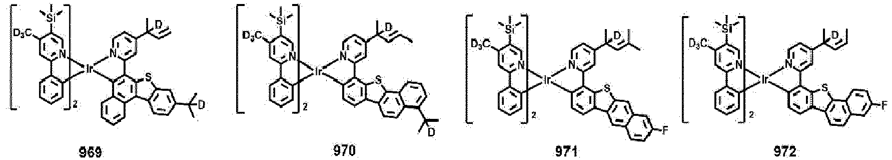

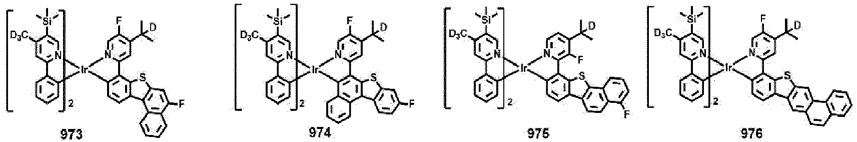

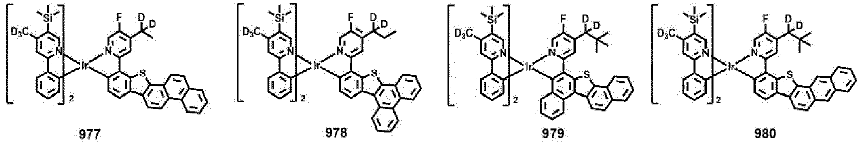

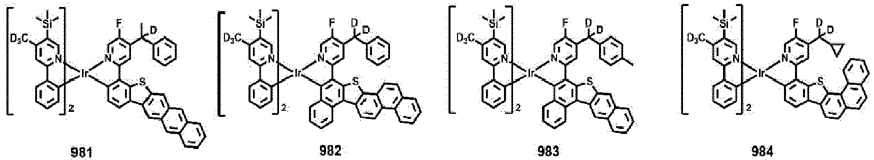

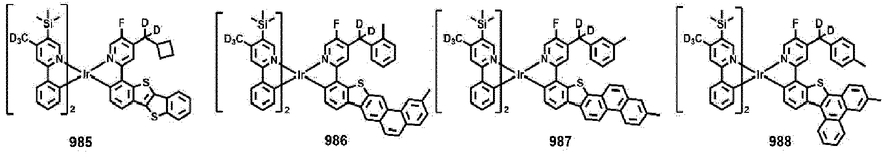

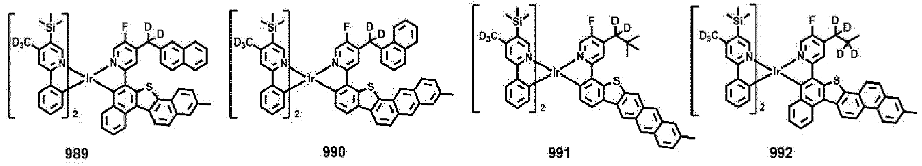

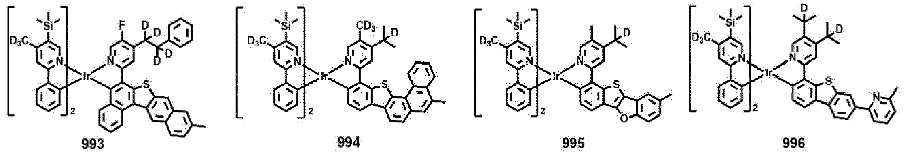

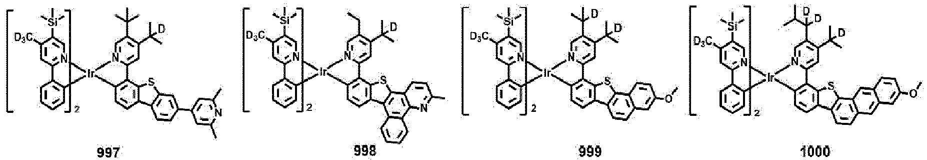

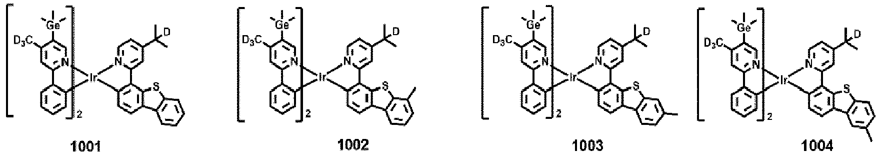

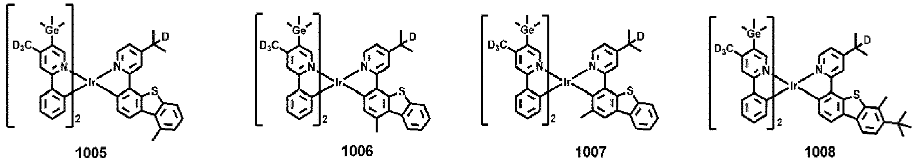

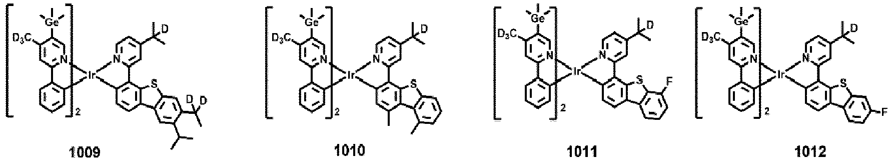

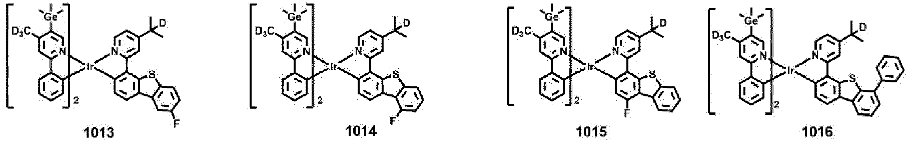

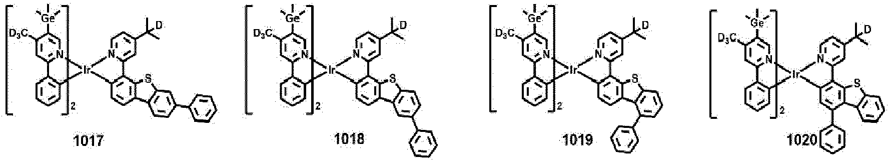

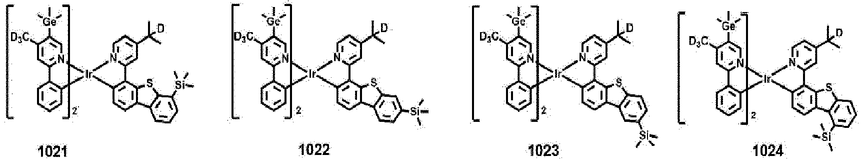

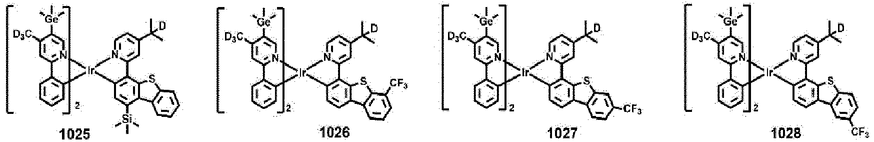

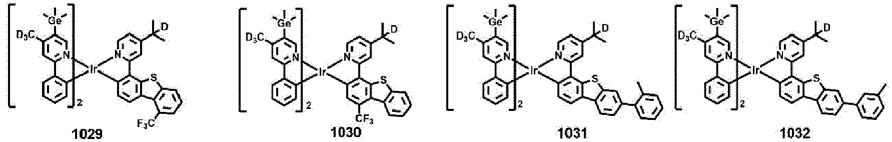

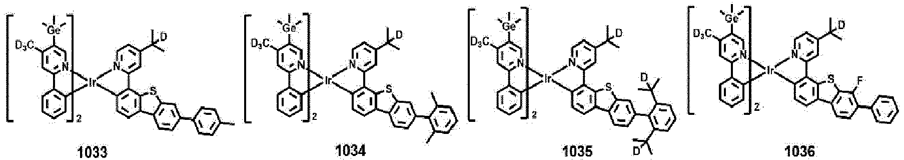

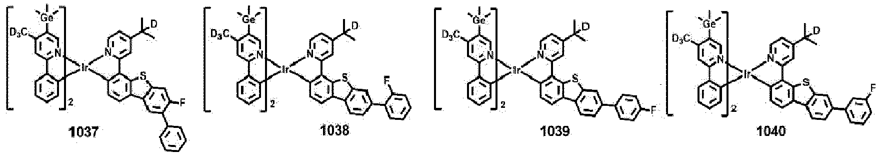

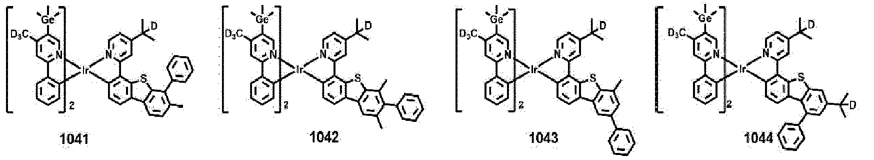

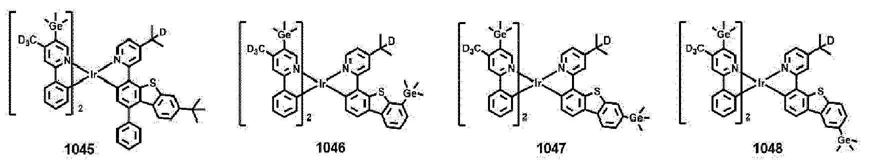

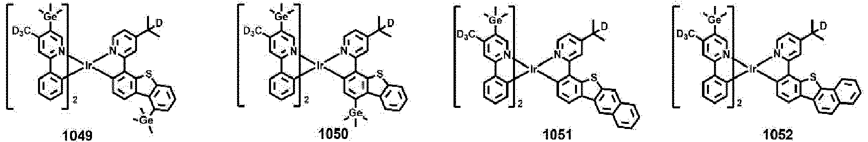

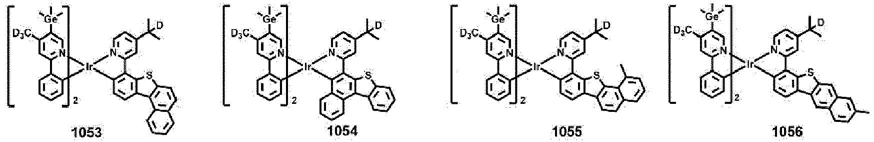

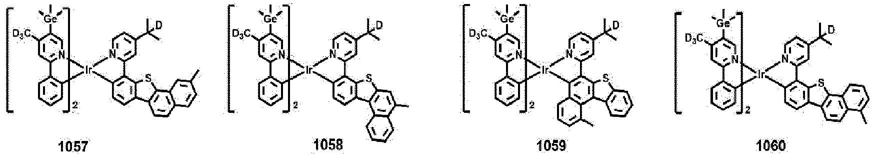

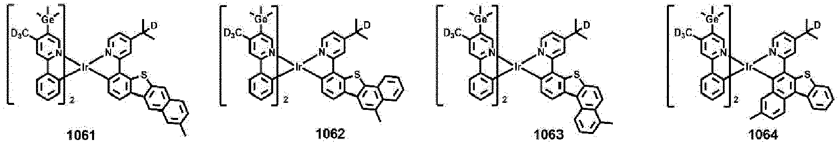

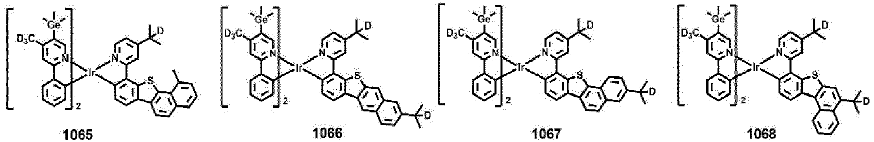

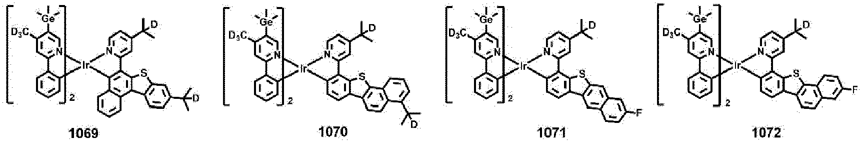

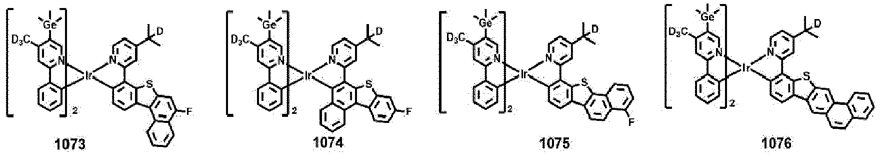

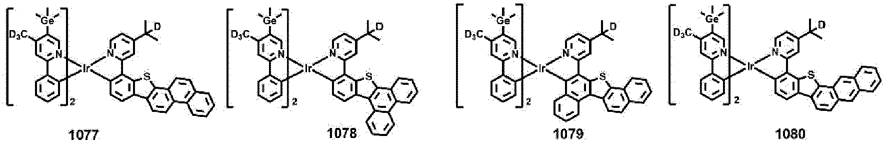

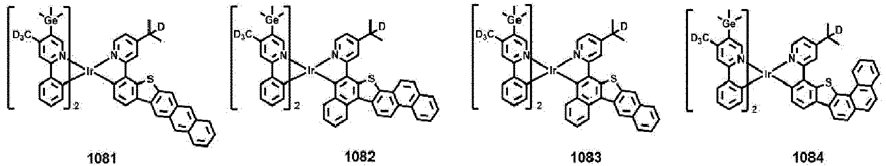

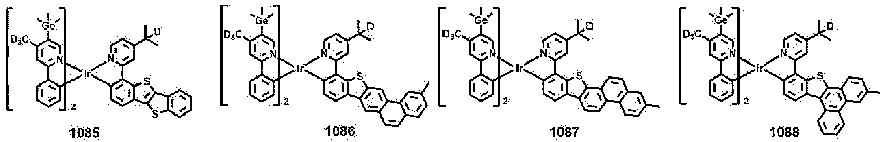

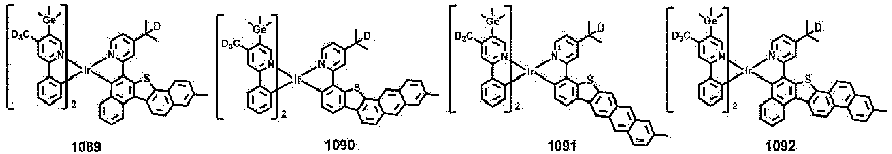

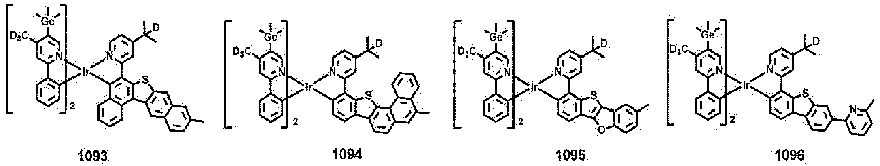

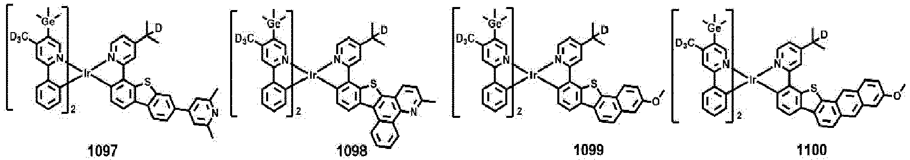

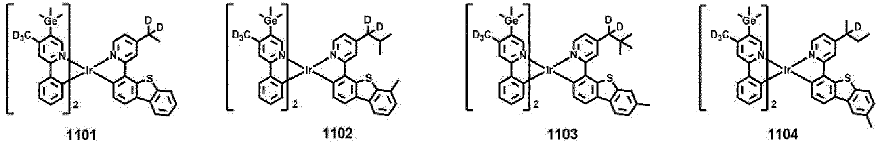

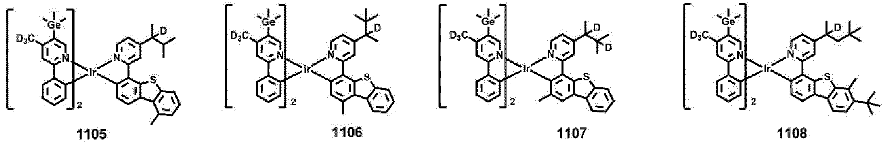

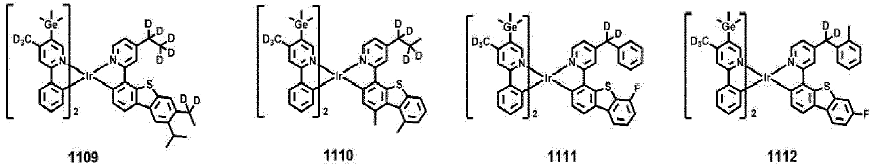

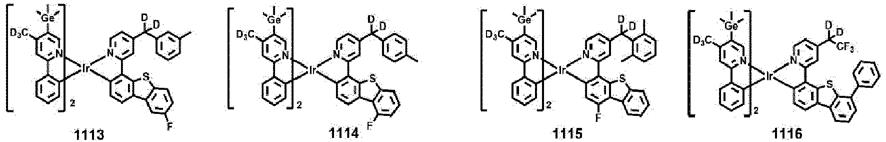

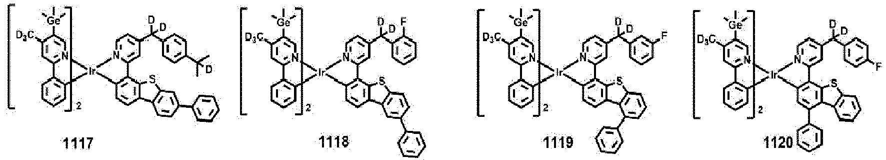

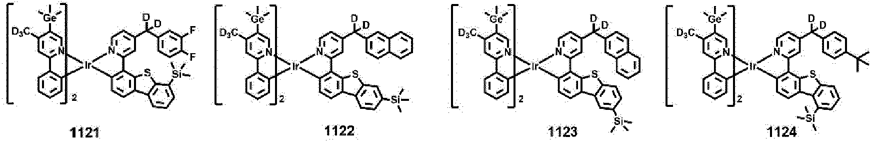

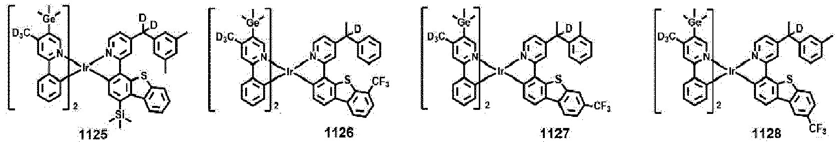

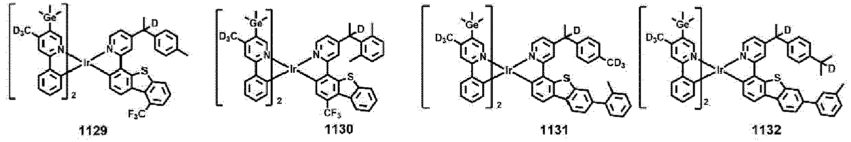

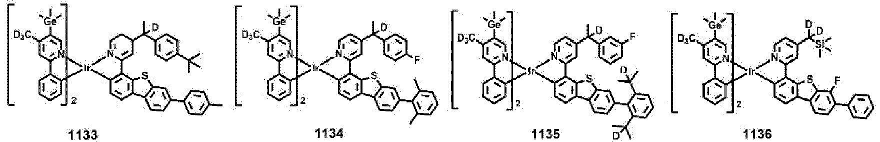

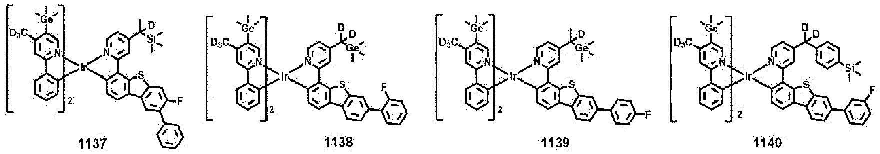

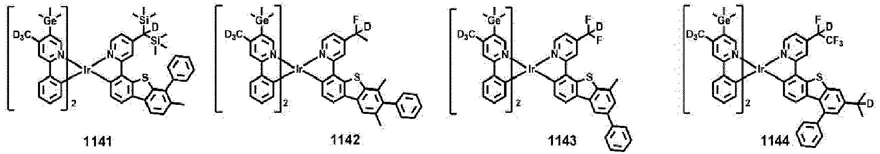

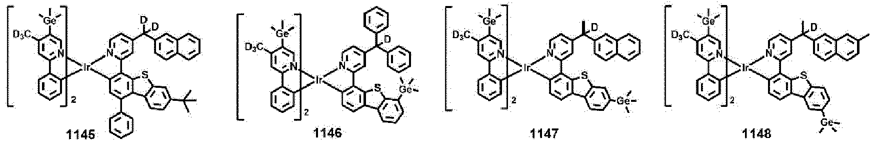

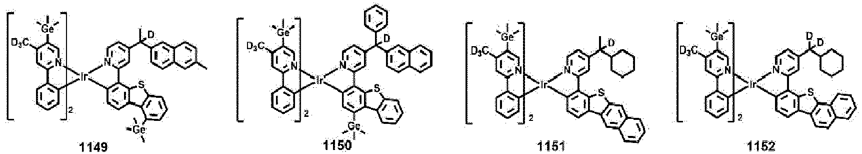

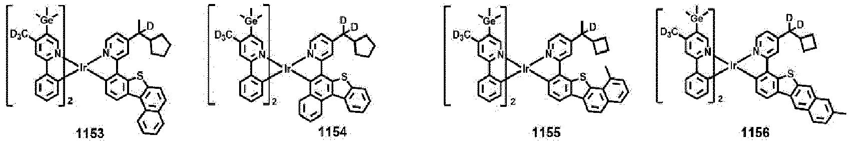

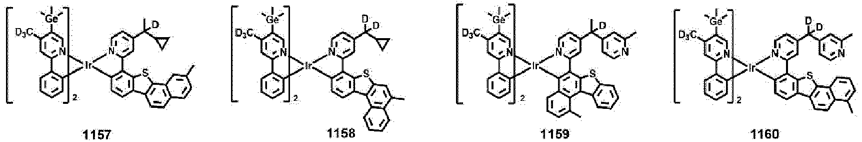

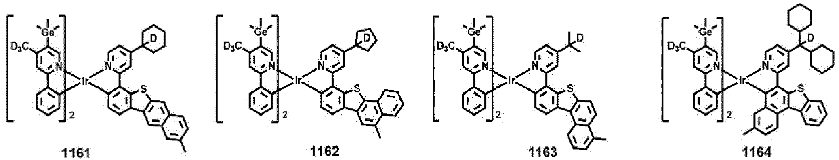

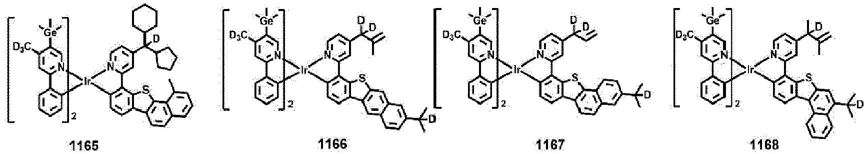

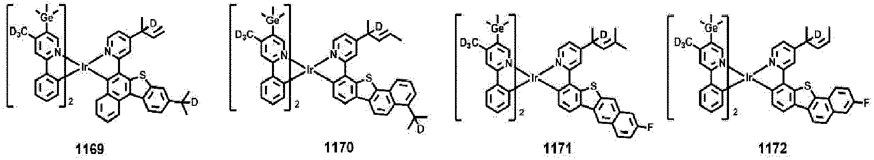

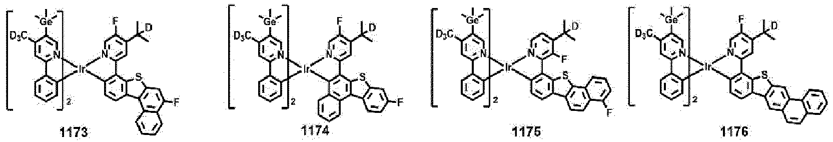

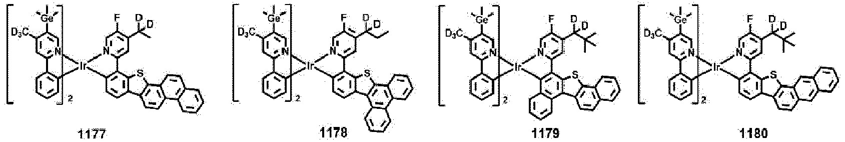

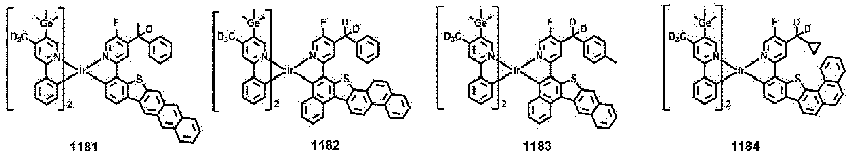

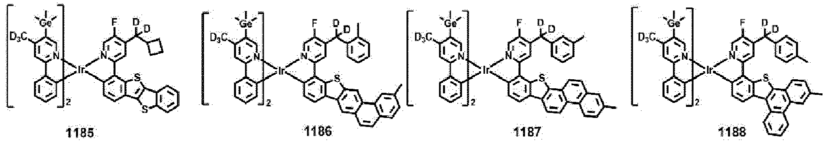

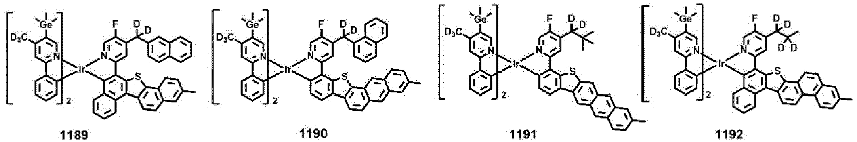

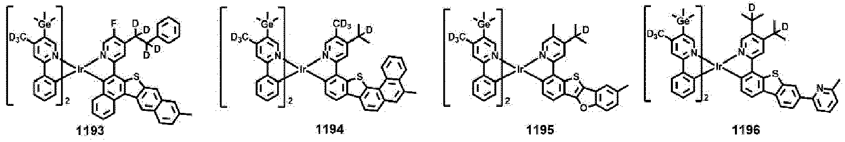

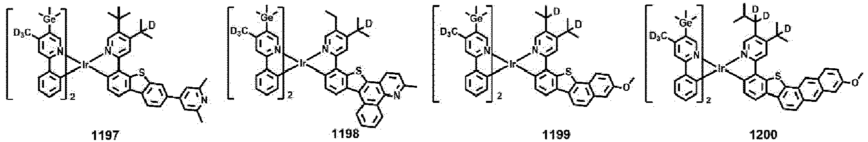

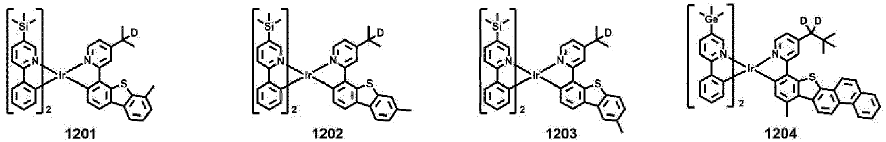

L₁ in the organometallic compound represented by Formula 1 is a ligand represented by Formula 2-1, n1, which is the number of L₁(s), is 1 or 2, L₂ is a ligand represented by Formula 2-2, n2, which is the number of L₂(s), is 1 or 2, and L₁ and L₂ are different from each other. That is, the organometallic compound is a heteroleptic complex essentially including (or consisting essentially of), as a ligand bonded to metal M, at least one ligand represented by Formula 2-1 and at least one ligand represented by Formula 2-2.

In relation to Formula 2-2, R₁₂ is hydrogen, deuterium, a methyl group, or a deuterated methyl group; or R₁₂ and R₁₃ are linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ. Accordingly, the organometallic compound represented by Formula 1 may have excellent heat resistance, and an electronic device, for example, an organic light-emitting device using the organometallic compound may have a long lifespan.

A₁ in Formula 2-1 is a group represented by Formula 3 (at least one of Z₃ to Z₅ in Formula 3 is deuterium, or a deuterated group), and is not -CD₃ (that is, a case in which all of Z₃ to Z₅ in Formula 3 are deuterium simultaneously, may be excluded), and c1, which is the number of A₁(s), is an integer from 1 to 20. That is, ring CY₁ of Formula 2-1 is substituted with at least one A₁. As a result, the transition dipole moment of the organometallic compound represented by Formula 1 is increased, and the orientation characteristics of the organometallic compound are improved, and thus the luminescence efficiency of an electronic device, for example, an organic light-emitting device using the organometallic compound may be improved.

Furthermore, a group represented by *-X₁(R₂₁)(R₂₂)(R₂₃) in Formula 2-2 may be bonded at position 5 of the pyridine ring in the ligand represented by Formula 2-2 (see Formula 2-2). Since the organometallic compound including the ligand represented by Formula 2-2 has excellent heat resistance and decomposition resistance, an electronic device, for example, an organic light-emitting device, including the organometallic compound may have high stability and long lifespan during manufacture, storage, and/or operation.

The highest occupied molecular orbital (HOMO) energy level, lowest unoccupied molecular orbital (LUMO) energy level, single (S₁) energy level, and triple (T₁) energy level of organometallic compounds represented by Formula 1 were evaluated by density functional theory (DFT) using the Gaussian 09 program with the molecular structure optimization obtained at the B3LYP basis level, and results thereof are shown in Table 1, where the energy levels are in electron volts (eV).

**Table 1**

| Compound No. | HOMO (eV) | LUMO (eV) | S₁(eV) | T1 (eV) |
|---|---|---|---|---|
| 1 | -4.8205 | -1.2759 | 2.8521 | 2.5521 |
| 2 | -4.9065 | -1.3363 | 2.9333 | 2.5594 |
| 3 | -4.7476 | -1.1943 | 2.8506 | 2.5161 |
| 4 | -4.8115 | -1.2715 | 2.8545 | 2.4444 |
| 1204 | -4.7761 | -1.2321 | 2.8706 | 2.4855 |

From Table 1, it was confirmed that the organometallic compound represented by Formula 1 has such electric characteristics that are suitable for use as a dopant for an electronic device, for example, an organic light-emitting device.

Synthesis methods of the organometallic compound represented by Formula 1 may be recognizable by one of ordinary skill in the art by referring to Synthesis Examples provided below.

Therefore, since the organometallic compound represented by Formula 1 may be suitable for use as a dopant of an organic layer of an organic light-emitting device, for example, an emission layer in the organic layer, according to another aspect, provided is an organic light-emitting device including a first electrode, a second electrode, and an organic layer which is located between the first electrode and the second electrode and includes an emission layer, wherein the organic layer includes at least one organometallic compounds represented by Formula 1.

The organic light-emitting device may have low driving voltage, high external quantum efficiency, and long lifespan characteristics due to the inclusion of an organic layer including the organometallic compound represented by Formula 1 as described herein.

The organometallic compound of Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 in the emission layer is less than an amount of the host in the emission layer). The emission layer may emit, for example, green light or blue light.

The expression "(an organic layer) includes at least one organometallic compound represented by Formula 1" used herein may include a case in which "(an organic layer) includes identical organometallic compounds represented by Formula 1" and a case in which "(an organic layer) includes two or more different organometallic compounds represented by Formula 1".

For example, the organic layer may include, as the organometallic compound, only Compound 1. In this embodiment, Compound 1 may be included in the emission layer of the organic light-emitting device. In one or more embodiments, the organic layer may include, as the organometallic compound, Compound 1 and Compound 2. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode is an anode, and the second electrode is a cathode, and the organic layer may further include a hole transport region located between the first electrode and the emission layer, and an electron transport region located between the emission layer and the second electrode, and the hole transport region may include a hole injection layer, a hole transport layer, an electron-blocking layer, a buffer layer, or a combination thereof, and the electron transport region may include a hole-blocking layer, an electron transport layer, an electron injection layer, or a combination thereof.

The term "organic layer" used herein refers to a single layer and/or a plurality of layers between the first electrode and the second electrode of the organic light-emitting device. The "organic layer" may include, in addition to an organic compound, an organometallic complex including a metal.

The FIGURE is a schematic view of a cross-sectional view of an organic light-emitting device 10 according to one or more embodiments. Hereinafter, the structure and manufacturing method of an organic light-emitting device according to one or more embodiments will be described with reference to the FIGURE. In the FIGURE, the organic light-emitting device 10 includes a first electrode 11, an organic layer 15, and a second electrode 19, which are sequentially stacked.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and/or water repellency.

The first electrode 11 may be produced by depositing or sputtering, onto the substrate, a material for forming the first electrode 11. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal or metal alloy, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. For example, the first electrode 11 may have a three-layered structure of ITO/Ag/ITO.

The organic layer 15 is located on the first electrode 11.

The organic layer 15 may include a hole transport region, an emission layer, and an electron transport region.

The hole transport region may be located between the first electrode 11 and the emission layer.

The hole transport region may include a hole injection layer, a hole transport layer, an electron-blocking layer, a buffer layer, or a combination thereof.

The hole transport region may include only either a hole injection layer or a hole transport layer. In one or more embodiments, the hole transport region may have a hole injection layer/hole transport layer structure or a hole injection layer/hole transport layer/electron-blocking layer structure, wherein, for each structure, respective layers are sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100°C to about 500°C, a vacuum pressure of about 10⁻⁸ torr to about 10⁻³ torr, and a deposition rate of about 0.01 angstroms per second (Å/sec) to about 100 Å/sec.

When the hole injection layer is formed by spin coating, the coating conditions may vary depending on a material for forming the hole injection layer, and the structure and thermal characteristics of the hole injection layer. For example, the coating conditions may include a coating speed in a range of about 2,000 revolutions per minute (rpm) to about 5,000 rpm and a heat treatment temperature in a range of about 80°C to about 200°C for removing a solvent after coating.

The conditions for forming the hole transport layer and the electron-blocking layer may be similar to or the same as the conditions for forming the hole injection layer.

The hole transport region may include at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(naphthalene-1-yl)-N,N'-diphenyl-benzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or a combination thereof:

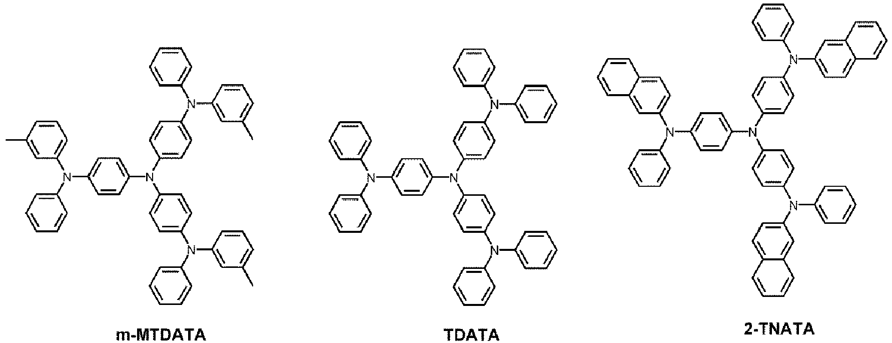

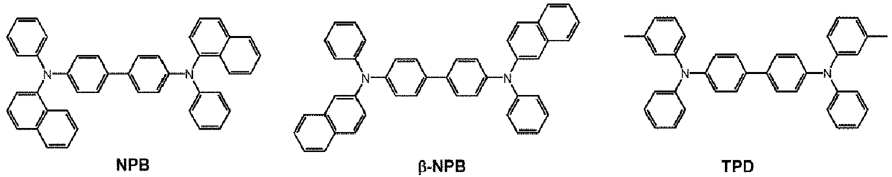

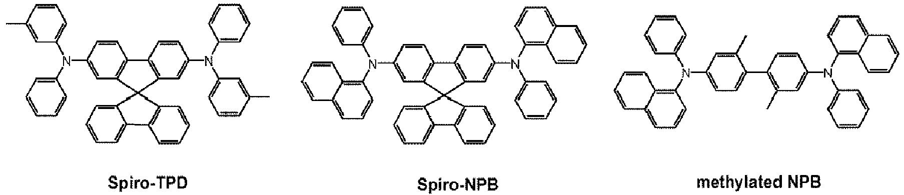

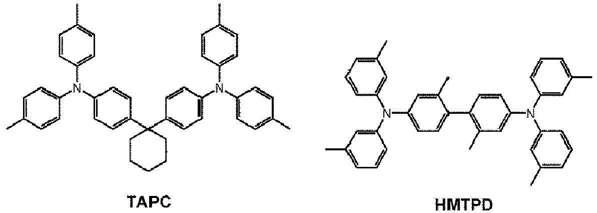

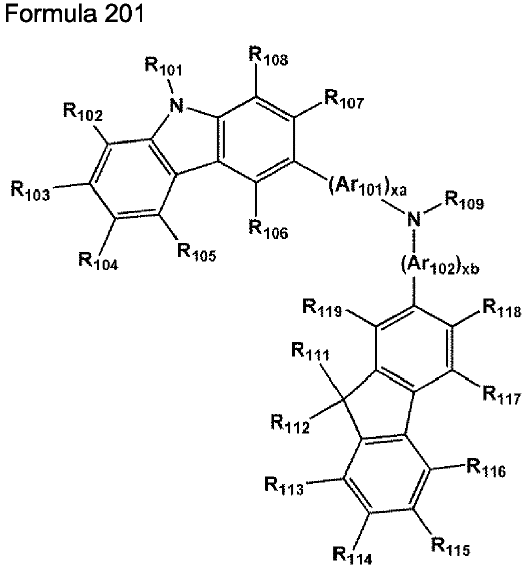

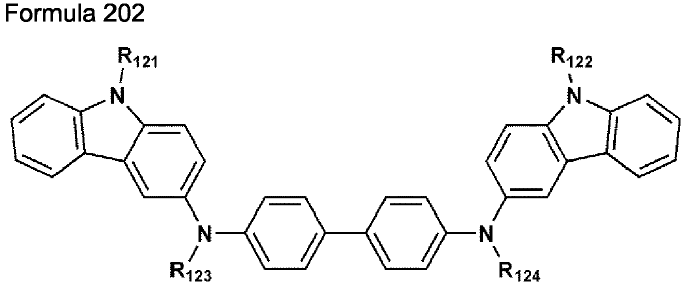

Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -CI, -Br, -I, - SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1 and xb may be 0.

R₁₀₁ to R₁₀₈, R₁₁₁ to R₁₁₉ and R₁₂₁ to R₁₂₄ in Formulae 201 and 202 may each independently be:
hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, or the like), a C₁-C₁₀ alkoxy group (for example, a methoxy group, an ethoxy group, a propoxy group, a butoxy group, a pentoxy group, or the like), or a C₁-C₆₀ alkylthio group;
a C₁-C₁₀ alkyl group, a C₁-C₁₀ alkoxy group, or a C₁-C₁₀ alkylthio group, each unsubstituted or substituted with at least one of deuterium, -F, -CI, -Br, -I, - SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group or a pyrenyl group, each unsubstituted or substituted with at least one of deuterium, -F, -CI, - Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

R₁₀₉ in Formula 201 may be a phenyl group, a naphthyl group, an anthracenyl group, or a pyridinyl group, each unsubstituted or substituted with at least one of deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A:

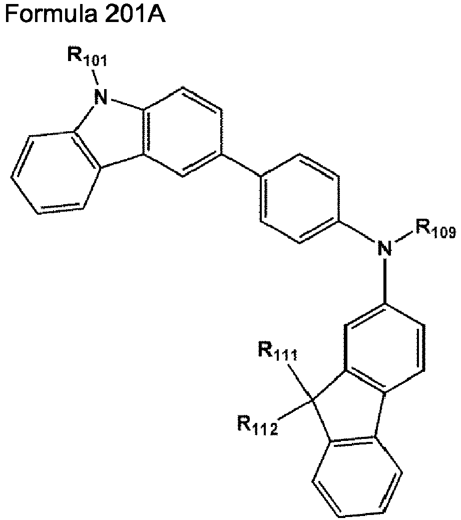

R₁₀₁, R₁₁₁, R₁₁₂, and R₁₀₉ in Formula 201A are each as described in the present specification.

For example, the hole transport region may include at least one of Compounds HT1 to HT20, or a combination thereof:

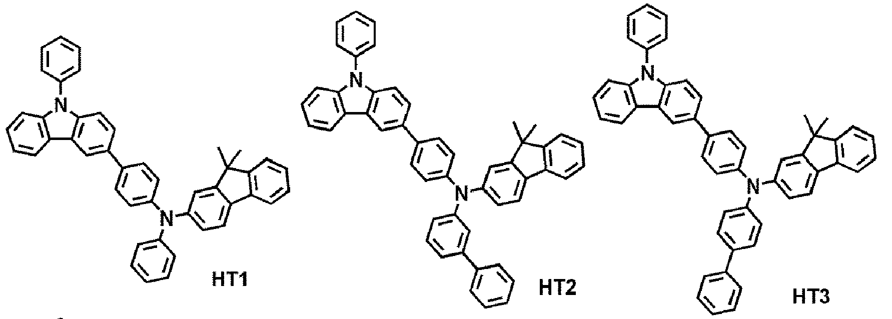

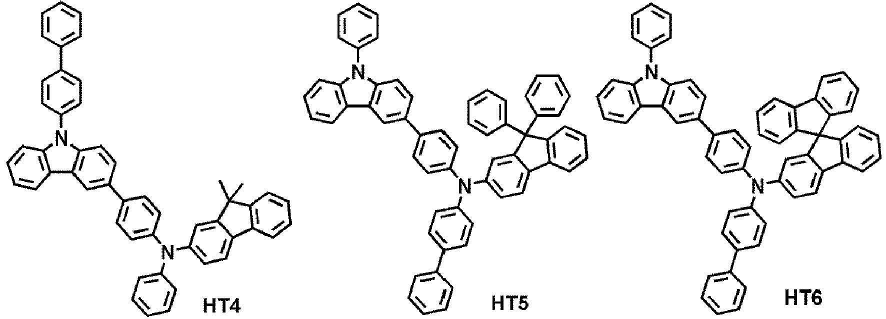

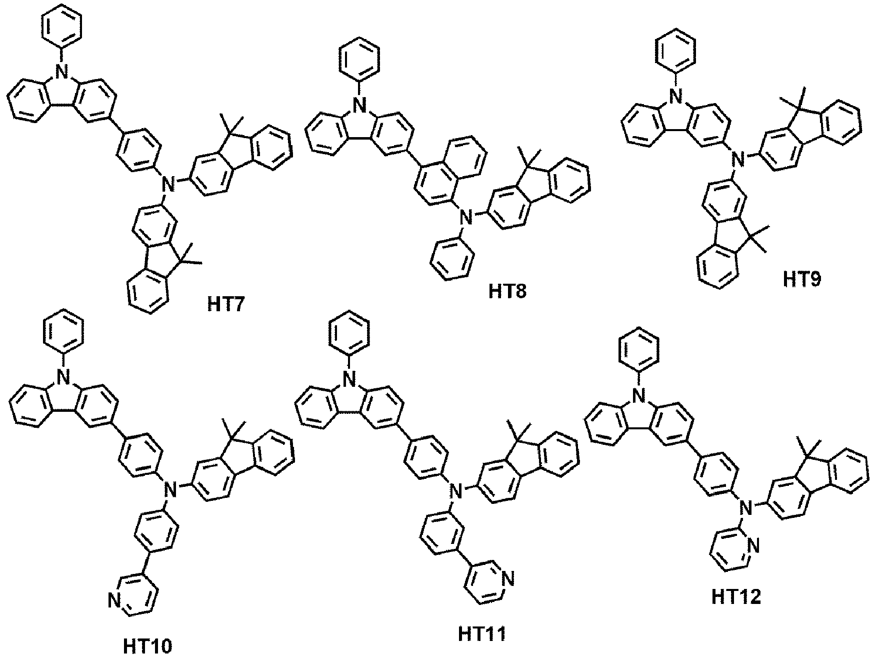

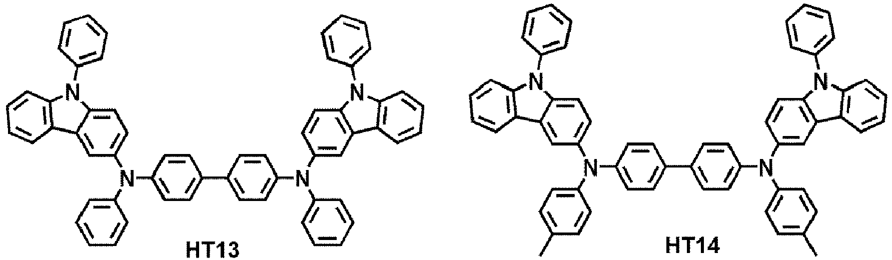

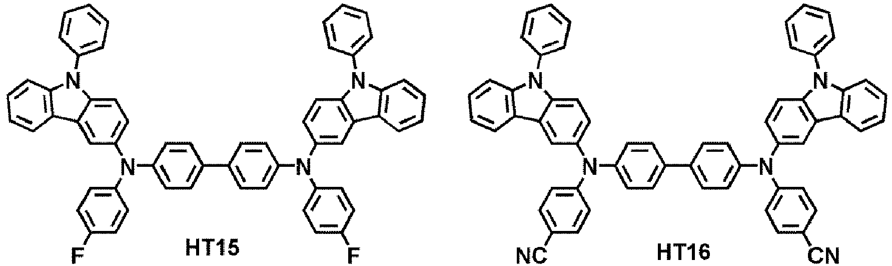

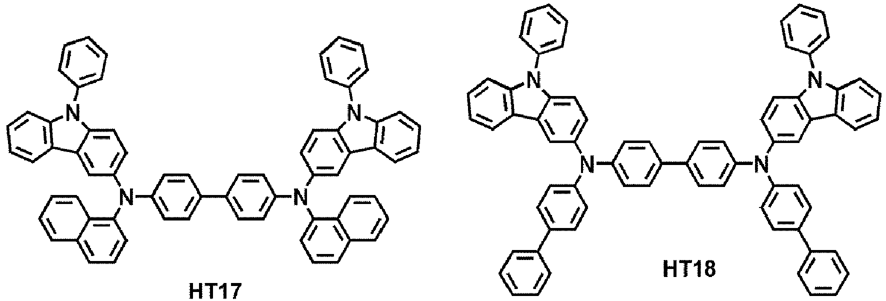

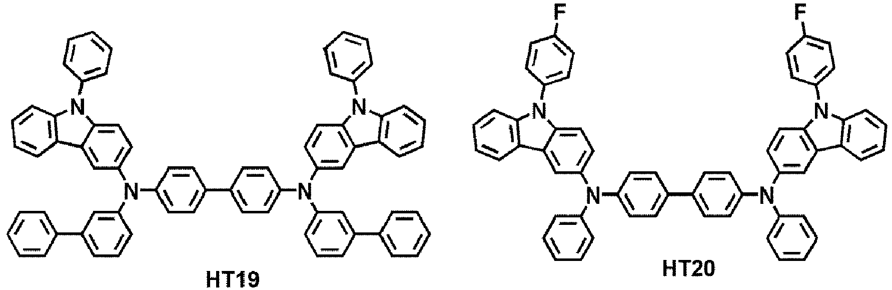

A thickness of the hole transport region may be in the range of about 100 Å to about 10,000 Å, for example, about 100 Å to about 1,000 Å. When the hole transport region includes a hole injection layer, a hole transport layer, an electron-blocking layer, or a combination thereof, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or a combination thereof. For example, the p-dopant may be: a quinone derivative such as tetracyanoquinodimethane (TCNQ), 2,3,5,6-tetrafluoro-tetracyano-1,4-benzoquinonedimethane (F4-TCNQ), or F6-TCNNQ; a metal oxide, such as tungsten oxide or molybdenum oxide; a cyano group-containing compound, such as Compound HT-D1; or a combination thereof.

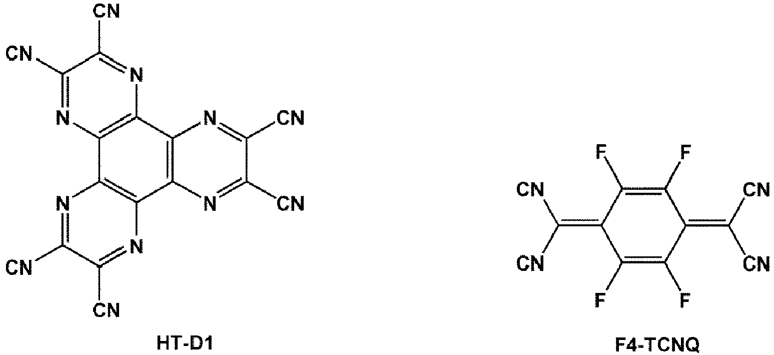

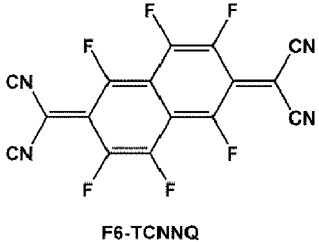

The hole transport region may include a buffer layer.

Also, the buffer layer may compensate for an optical resonance distance according to a wavelength of light emitted from the emission layer, and thus, efficiency of a formed organic light-emitting device may be improved.

Meanwhile, when the hole transport region includes an electron-blocking layer, a material for forming the electron-blocking layer may include a material that is used in the hole transport region as described above, a host material described below, or a combination thereof. In one or more embodiments, when the hole transport region includes an electron-blocking layer, mCP, which will be described later may be used as an electron-blocking layer material.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

The emission layer may include a host and a dopant, and the dopant may include the organometallic compound represented by Formula 1 as described herein.

The host may include 3-tert-butyl-9,10-di(naphth-2-yl)anthracene (TBADN), 9,10-di(naphthalen-2-yl)anthracene (ADN, also referred to as "DNA"), 4,4'-bis(N-carbazolyl)-1,1'-biphenyl (CBP), 4,4'-bis(9-carbazolyl)-2,2'-dimethyl-biphenyl (CDBP), N,N',N''-1,3,5-tricarbazoloylbenzene (TCP), 1,3-bis(carbazol-9-yl)benzene (mCP), Compound H50, Compound H51, Compound H52, or a combination thereof:

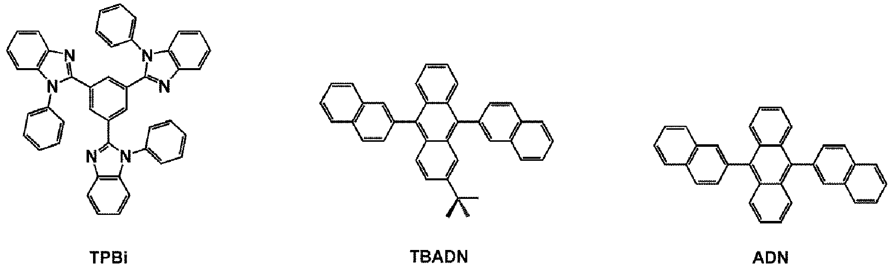

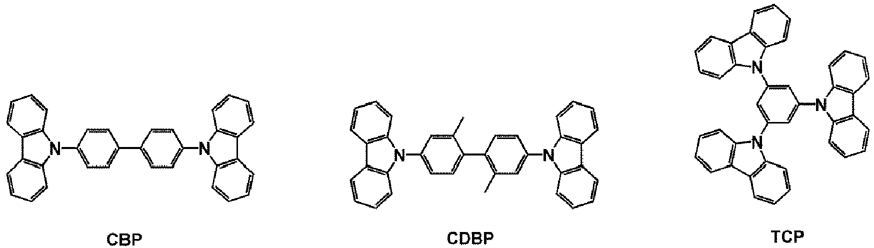

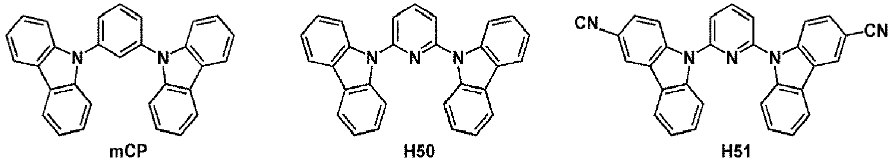

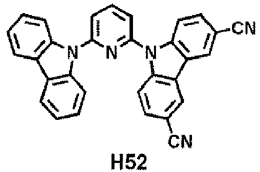

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

An electron transport region may be located on the emission layer.

The electron transport region may include a hole-blocking layer, an electron transport layer, an electron injection layer, or a combination thereof.

For example, the electron transport region may have a hole-blocking layer/electron transport layer/electron injection layer structure or an electron transport layer/electron injection layer structure. The electron transport layer may have a single-layered structure or a multi-layered structure including two or more different materials.

Conditions for forming the hole-blocking layer, the electron transport layer, and the electron injection layer which constitute the electron transport region may be understood by referring to the conditions for forming the hole injection layer.

When the electron transport region includes a hole-blocking layer, the hole-blocking layer may include, for example, 2,9-dimethyl-4,7-diphenyl-1,10-phenanthroline (BCP), 4,7-diphenyl-1,10-phenanthroline (Bphen), bis(2-methyl-8-quinolinolato-N1,08)-(1,1'-biphenyl-4-olato)aluminum (BAlq), or a combination thereof:

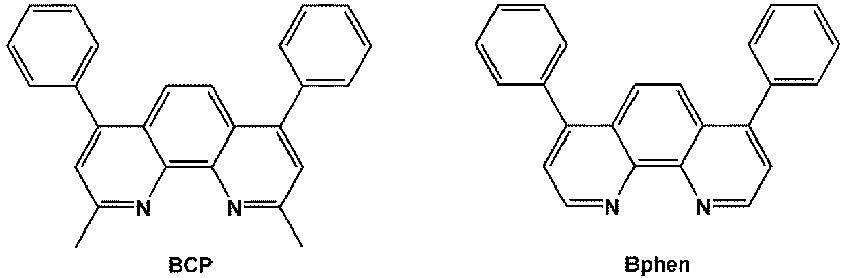

A thickness of the hole-blocking layer may be in a range of about 20 Å to about 1,000 Å, for example, about 30 Å to about 600 Å. When the thickness of the hole-blocking layer is within these ranges, excellent hole blocking characteristics may be obtained without a substantial increase in driving voltage.

The electron transport layer may include BCP, Bphen, 1,3,5-tris(N-phenylbenzimidazole-2-yl)benzene (TPBi), tris(8-hydroxyquinolinato)aluminum (Alq₃), bis(2-methyl-8-quinolinolato-N1,08)-(1,1'-biphenyl-4-olato)aluminum (Balq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof:

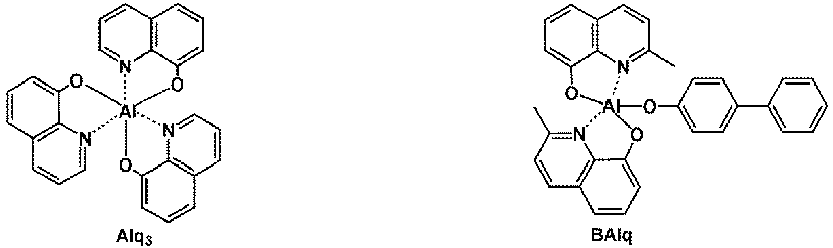

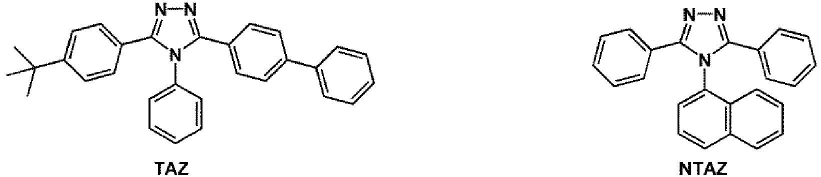

In one or more embodiments, the electron transport layer may include one of Compounds ET1 to ET25 or a combination thereof:

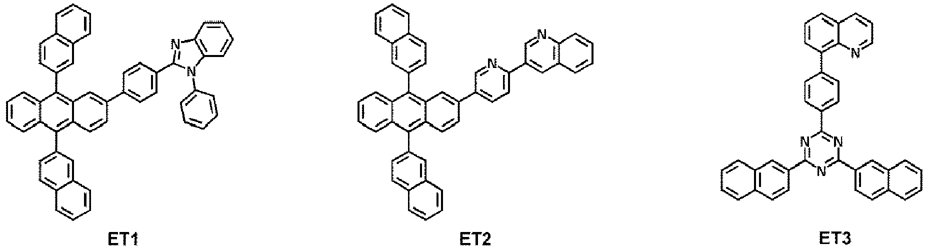

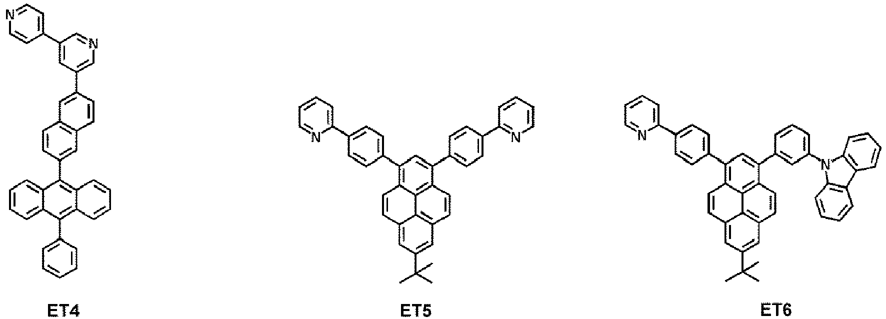

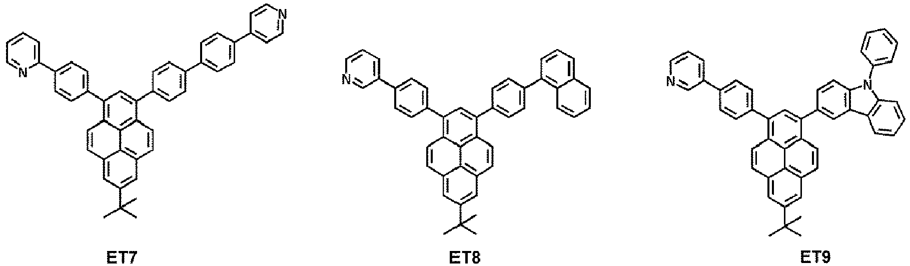

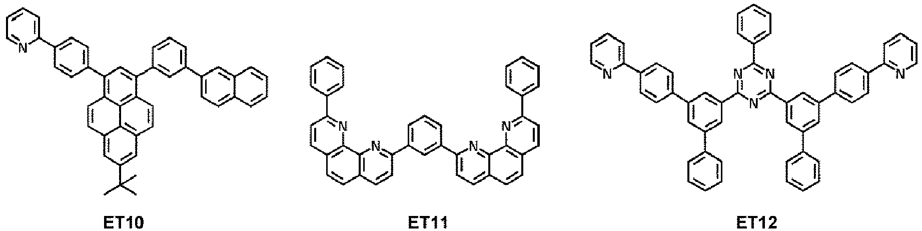

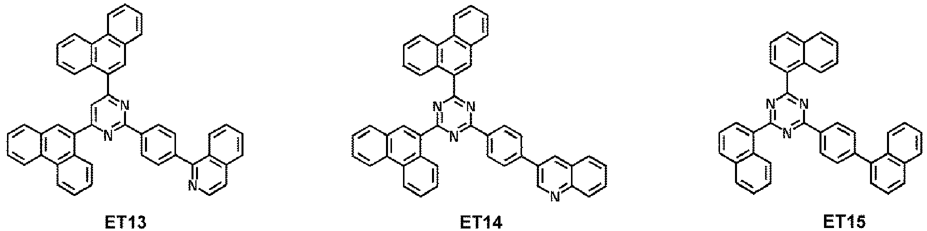

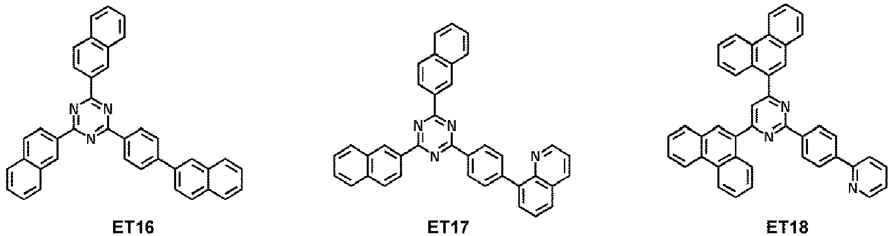

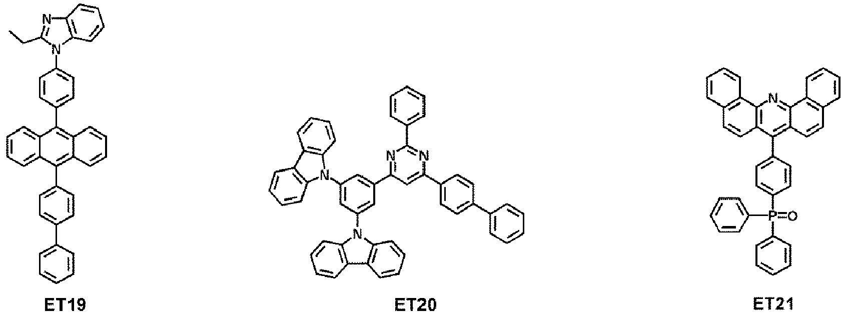

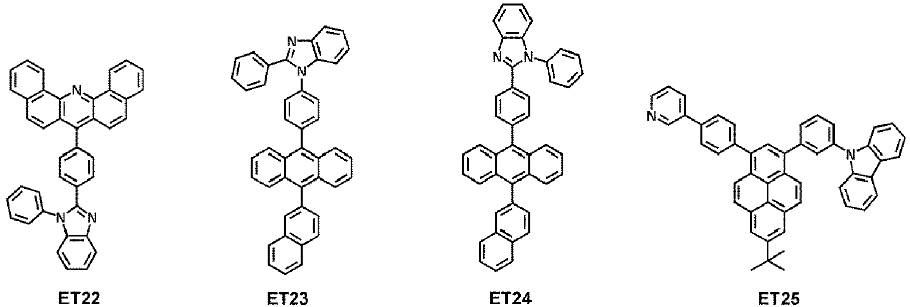

A thickness of the electron transport layer may be in the range of about 100 Å to about 1,000 Å, for example, about 150 Å to about 500 Å. When the thickness of the electron transport layer is within the range described above, the electron transport layer may have satisfactory electron transporting characteristics without a substantial increase in driving voltage.

The electron transport layer may include a metal-containing material in addition to the material as described above.

The metal-containing material may include a Li complex. The Li complex may include, for example, Compound ET-D1 or ET-D2:

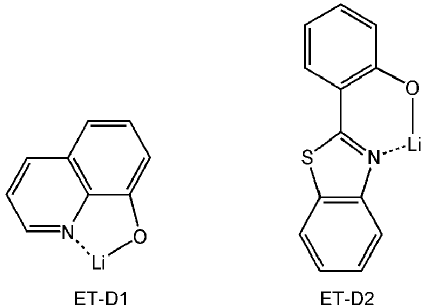

The electron transport region may include an electron injection layer that promotes the flow of electrons from the second electrode 19 thereinto.

The electron injection layer may include LiF, NaCl, CsF, Li₂O, BaO, or a combination thereof.

A thickness of the electron injection layer may be in a range of about 1 Å to about 100 Å, and, for example, about 3 Å to about 90 Å. When the thickness of the electron injection layer is within the ranges described above, satisfactory electron injection characteristics may be obtained without a substantial increase in driving voltage.

The second electrode 19 may be located on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device according to one or more embodiments has been described in connection with the FIGURE. However, embodiments of the present disclosure are not limited thereto.

According to another aspect, the organic light-emitting device may be included in an electronic apparatus. Thus, an electronic apparatus including the organic light-emitting device is provided. The electronic apparatus may include, for example, a display, an illumination, a sensor, and the like.

Another aspect provides a diagnostic composition including at least one organometallic compound represented by Formula 1.

The organometallic compound represented by Formula 1 provides high luminescent efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "C₁-C₆₀ alkyl group" as used herein refers to a linear or branched saturated aliphatic hydrocarbons monovalent group having 1 to 60 carbon atoms, and the term "C₁-C₆₀ alkylene group- as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with at least one of a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched C₆ alkyl group, for example, a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group), and examples thereof are a methoxy group, an ethoxy group, a propoxy group, a butoxy group, and a pentoxy group. The term "C₁-C₆₀ alkylthio group" as used herein refers to a monovalent group represented by -SA_{101'} (wherein A_{101'} is the C₁-C₆₀ alkyl group).

The term "C₂-C₆₀ alkenyl group" as used herein refers to a hydrocarbon group formed by substituting at least one carbon-carbon double bond in the middle or at the terminus of a C₂-C₅₀ alkyl group, and examples thereof include an ethenyl group, a propenyl group, and a butenyl group. The term "C₂-C₆₀ alkenylene group" as used herein refers to a divalent group having the same structure as the C₂-C₅₀ alkenyl group.

The term "C₂-C₆₀ alkynyl group" as used herein refers to a hydrocarbon group formed by substituting at least one carbon-carbon triple bond in the middle or at the terminus of a C₂-C₅₀ alkyl group, and examples thereof include an ethynyl group, and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms. The term "C₃-C₁₀ cycloalkylene group" as used herein refers to a divalent group having the same structure as the C₃-C₁₀ cycloalkyl group.

Examples of the C₃-C₁₀ cycloalkyl group are a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a monovalent saturated monocyclic group that includes at least one hetero atom selected from N, O, P, Si, S, Se, Ge, and B as a ring-forming atom and 1 to 10 carbon atoms. The term "C₁-C₁₀ heterocycloalkylene group" as used herein refers to a divalent group having the same structure as the C₁-C₁₀ heterocycloalkyl group.

Examples of the C₁-C₁₀ heterocycloalkyl group are a silolanyl group, a silinanyl group, tetrahydrofuranyl group, a tetrahydro-2H-pyranyl group, and a tetrahydrothiophenyl group.

The term "C₃-C₁₀ cycloalkenyl group" as used herein refers to a monovalent cyclic group that includes 3 to 10 carbon atoms and at least one carbon-carbon double bond in the ring thereof and has no aromaticity, and examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, Si, S, Se, Ge, and B as a ring-forming atom, 1 to 10 carbon atoms, and at least one double bond in its ring, and has no aromaticity. Examples of the C₁-C₁₀ heterocycloalkenyl group are a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Examples of the C₅-C₅₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group having at least one hetero atom selected from N, O, P, Si, S, Se, Ge, and B as a ring-forming atom and a cyclic aromatic system having 1 to 60 carbon atoms. The term "C₁-C₆₀ heteroarylene group" as used herein refers to a divalent group having at least one hetero atom selected from N, O, P, Si, S, Se, Ge, and B as a ring-forming atom and a carbocyclic aromatic system having 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the rings may be fused to each other.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein indicates -OA₁₀₂ (wherein A102 indicates the C₆-C₆₀ aryl group). The term "C₆-C₆₀ arylthio group" as used herein indicates -SA103 (wherein A₁₀₃ indicates the C₆-C₆₀ aryl group).

The term "C₁-C₆₀ heteroaryloxy group" as used herein indicates -OA_{102'} (wherein A_{102'} indicates the C₁-C₆₀ heteroaryl group). The term "C₁-C₆₀ heteroarylthio group" as used herein indicates -SA_{103'} (wherein A_{103'} indicates the C₁-C₆₀ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group described above.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Examples of the "C₅-C₃₀ carbocyclic group (unsubstituted or substituted with at least one R₁₀ₐ)" used herein are an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The C₁-C₃₀ heterocyclic group may be a monocyclic group or a polycyclic group. The "C₁-C₃₀ heterocyclic group (unsubstituted or substituted with at least one R₁₀ₐ)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one R₁₀ₐ).

Examples of the "C₅-C₃₀ carbocyclic group" and the "C₁-C₃₀ heterocyclic group" as used herein are i) a first ring, ii) a second ring, iii) a condensed ring in which two or more first rings are condensed with each other, iv) a condensed ring in which two or more second rings are condensed with each other, or v) a condensed ring in which at least one first ring is condensed with at least one second ring,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" as used herein respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group (that is, a fluorinated methyl group)" includes -CF₃, -CF₂H, and -CFH₂. The "fluorinated C₁-C₆₀ alkyl group (or, a fluorinated C₁-C₂₀ alkyl group, or the like)", "the fluorinated C₃-C₁₀ cycloalkyl group", "the fluorinated C₁-C₁₀ heterocycloalkyl group", or "the fluorinated a phenyl group" may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, not all hydrogen included therein is substituted with a fluoro group.

The term "deuterated group" as used herein refers to a substituent group having at least one hydrogen atom substituted with deuterium. The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" as used herein respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include -CD₃, -CD₂H, and -CDH₂, and examples of the "deuterated C₃-C₁₀ cycloalkyl group" are, for example, Formula 10-501 and the like. The "deuterated C₁-C₆₀ alkyl group (or, the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, not all hydrogen included therein are substituted with deuterium.

The term "deuterium-free group" as used herein refers to a substituent group that does not have at least one hydrogen atom substituted with deuterium. That is, the term "deuterium-free group" as used herein refers to a substituent group that does not have a deuterium.

The term "(C₁-C₂₀ alkyl) 'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl)phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon selected from ring-forming carbons is substituted with nitrogen.

At least one substituent of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₅₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₅₀ alkyl aryl group, the substituted C₇-C₆₀ aryl alkyl group, the substituted C₅-C₅₀ aryloxy group, the substituted C₆-C₆₀ arylthio group, the substituted C₁-C₆₀ heteroaryl group, the substituted C₂-C₅₀ alkyl heteroaryl group, the substituted C₁-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may each independently be:
deuterium, -F, -CI, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₅₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₅₀ alkyl heteroaryl group, a monovalent non-aromatic condensed polycyclic group, or a monovalent non-aromatic condensed heteropolycyclic group, each unsubstituted or substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₅₀ alkynyl group, a C₁-C₆₀ alkoxy group, a C₁-C₆₀ alkylthio group C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), - Si(Q23)(Q24)(Q25), -Ge(Q23)(Q24)(Q25), -B(Q26)(Q27), -P(=O)(Q₂₈)(Q₂₉), - P(Q₂₈)(Q₂₉), or a combination thereof;
-N(Q31)(Q32), -Si(Q₃₃)(Q₃₄)(Q₃₅), -Ge(Q33)(Q34)(Q35), -B(Q36)(Q37), - P(=O)(Q₃₈)(Q₃₉), or -P(Q₃₈)(Q₃₉); or
a combination thereof.
Q1 to Q9, Q11 to Q19, Q21 to Q29, and Q31 to Q39 used herein may each independently be: hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

For example, Q1 to Q9, Q11 to Q19, Q21 to Q29 and Q31 to Q₃₉ as described herein may each independently be:
-CH3, -CD₃, -CD₂H, -CDH₂, -CH2CH3, -CH2CD3, -CH2CD2H, -CH2CDH2, - CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

Hereinafter, a compound and an organic light-emitting device according to one or more exemplary embodiments are described in further detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### EXAMPLES

### Synthesis Example 1 (Compound 1)

### Synthesis of Compound C1

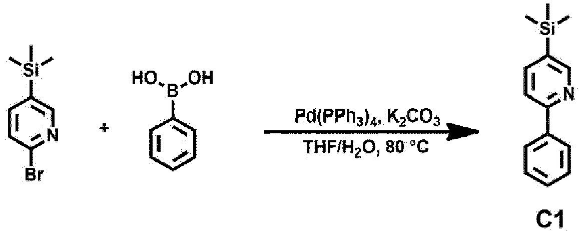

80 milliliters (mL) of tetrahydrofuran (THF) and 30 mL of deionized (DI) water were mixed with 2-bromo-5-(trimethylsilyl)pyridine (10 grams (g), 43.44 millimoles (mmol)), phenylboronic acid (5.83 g, 47.79 mmol), tetrakis(triphenylphosphine)palladium(0) (Pd(PPh₃)₄, 2.51 g, 2.17 mmol), and potassium carbonate (K₂CO₃, 18.01 g, 130.33 mmol), and then, the mixture was stirred and heated under reflux at 80°C for 18 hours. After the temperature was allowed to lower to room temperature, the organic layer was extracted using methylene chloride (MC), anhydrous magnesium sulfate (MgSO₄) was added thereto to remove moisture, and the filtrate obtained by filtration was exposed to reduced pressure to obtain the residual product, which was then purified by column chromatography using ethyl acetate (EA) and hexane at a ratio of 1:4 (volume ratio, the same below), thereby obtaining 7.23 g (73%) of Compound C1.

### Synthesis of Compound B1

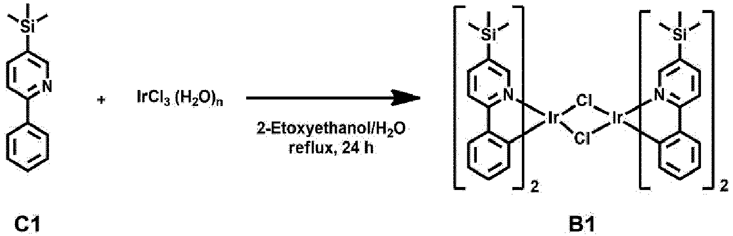

90 mL of 2-ethoxyethanol and 30 mL of DI water were mixed with Compound C1 (5.0 g, 22.04 mmol) and iridium chloride hydrate (IrCl₃(H₂O)ₙ, n=3, 3.70 g, 10.49 mmol), and then, the mixture was stirred and heated under reflux for 24 hours, and then, the temperature was allowed to lower to room temperature. The resulting solid was separated by filtration, washed sufficiently with DI water, methanol (MeOH), and hexanes, in this stated order, and then dried in a vacuum oven to obtain 6.53 g (46%) of Compound B1.

### Synthesis of Compound A1

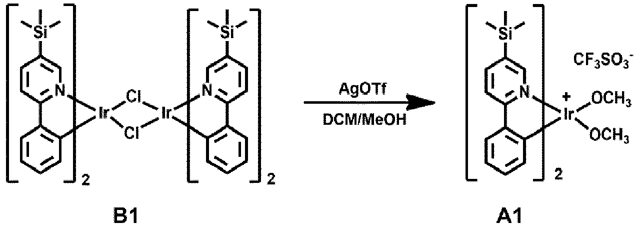

Compound B1 (5.00 g, 3.67 mmol) was mixed with 90 mL of MC (i.e., DCM), and then, (trifluoromethanesulfonate)silver(l) (AgOTf, 2.03 g, 7.90 mmol) dissolved in 30 mL of methanol was added thereto. Afterwards, the resultant reaction solution was stirred to proceed a reaction for 18 hours at room temperature while light was blocked from the reaction solution with aluminum foil, and then filtered through CELITE to remove a solid produced therein. The filtrate was then subjected to reduced pressure to obtain a solid (Compound A1) that was used in the next reaction without an additional purification process.

### Synthesis of Compound L1

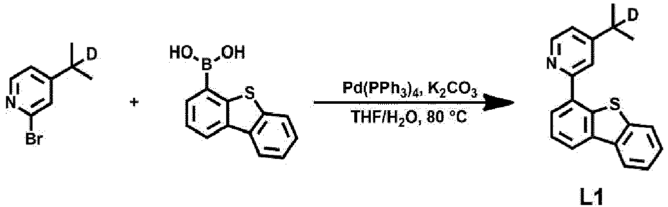

2-bromo-4-(propan-2-yl-2-d)pyridine (4.44 g, 22.20 mmol), dibenzo[b,d]thiophen-4-ylboronic acid (5.06 g, 22.20 mmol), Pd(PPh₃)₄ (1.28 g, 1.11 mmol), and K₂CO₃ (9.20 g, 66.60 mmol) were mixed with 90 mL of THF and 30 mL of DI water, followed by stirring and heating under reflux at 80°C for 18 hours. After the temperature was allowed to lower to room temperature, the organic layer was extracted using MC, anhydrous MgSO₄ was added thereto to remove residual water, and the filtrate obtained by filtration was subjected to reduced pressure to obtain the residual product, which was then purified by column chromatography using EA and hexane at a ratio of 1:2, thereby obtaining 4.93 g (73%) of Compound L1.

### Synthesis of Compound 1

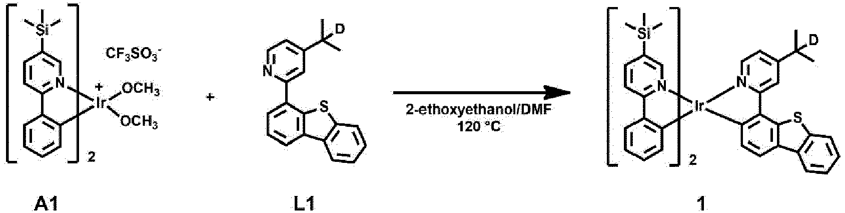

Compound A1 (5.15 g, 6.00 mmol) and Compound L1 (1.83 g, 6.00 mmol) were mixed with 50 mL of 2-ethoxyethanol and 50 mL of N,N-dimethylformamide (DMF), and then, the resultant solution was stirred and heated under reflux for 48 hours at a temperature of 120°C. Then, the temperature was allowed to lower to room temperature. After removing the solvents under reduced pressure, column chromatography was performed using EA and hexane at a ratio of 1:8 to obtain 1.42 g (25%) of Compound 1. The obtained compound was identified by high resolution mass spectrometry using matrix assisted laser desorption ionization (HRMS(MALDI)) and high-performance liquid chromatography (HPLC) analysis.

HRMS (MALDI) calculated for C₄₈H₄₇DIrN₃SSi₂: m/z: 948.2799, found: 948.2805.

### Synthesis Example 2 (Compound 2)

### Synthesis of Compound C2

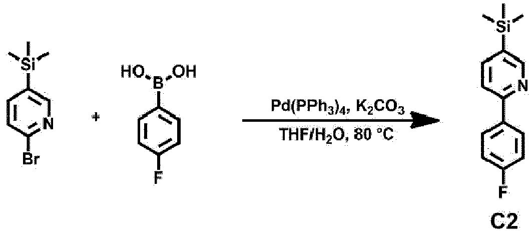

2-bromo-5-(trimethylsilyl)pyridine (10 g, 43.44 mmol), 4-fluorophenylboronic acid (6.08 g, 43.44 mmol), Pd(PPh₃)₄ (2.51 g, 2.17 mmol), and K₂CO₃ (18.01 g, 130.33 mmol) were mixed with 90 mL of tetrahydrofuran (THF) and 30 mL of DI water, and then stirred and heated under reflux at 80°C for 18 hours. After the temperature was allowed to lower to room temperature, the organic layer was extracted using MC, anhydrous MgSO₄ was added thereto to remove residual water, and the filtrate obtained by filtration was subjected to reduced pressure to obtain the residual product, which was then purified by column chromatography using EA and hexane at a ratio of 1:4, thereby obtaining 8.53 g (80%) of Compound C2.

### Synthesis of Compound B2

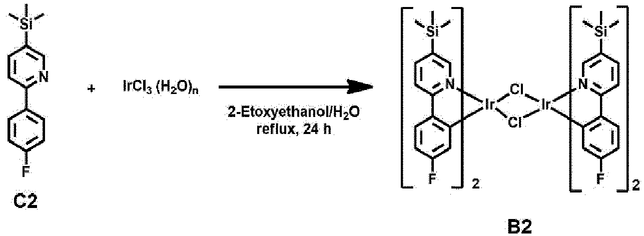

Compound C2 (7.36 g, 30.00 mmol) and iridium chloride hydrate (8.66 g, 29.00 mmol) were mixed with 90 mL of 2-ethoxyethanol and 30 mL of DI water, and then, the mixture was stirred and heated under reflux for 24 hours, and then, the temperature was allowed to lower to room temperature. The resulting solid was separated by filtration, washed sufficiently with DI water, methanol, and hexanes, in this stated order, and then dried in a vacuum oven to obtain 8.60 g (80%) of Compound B2.

### Synthesis of Compound A2

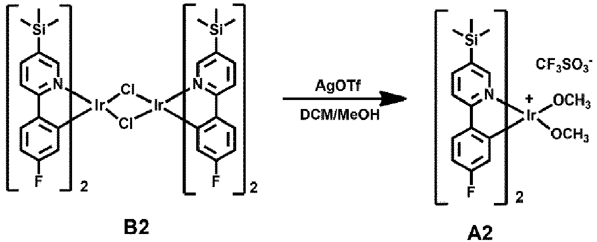

Compound B2 (5.26 g, 3.67 mmol) was mixed with 90 mL of MC, and then, AgOTf (1.13 g, 4.40 mmol) dissolved in 30 mL of methanol was added thereto. Afterwards, the resultant reaction solution was stirred to proceed a reaction for 18 hours at room temperature while light was blocked from the reaction solution with aluminum foil, and filtered through CELITE to remove a solid produced therein. The filtrate was then subjected to reduced pressure to obtain a solid (Compound A2) which was used in the next reaction without an additional purification process.

### Synthesis of Compound L2

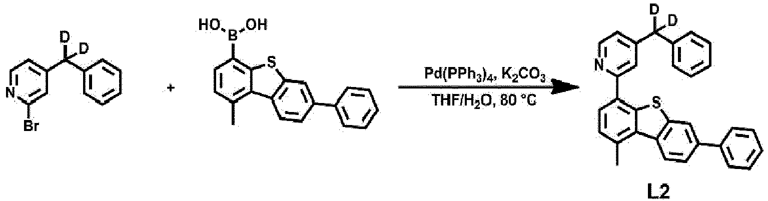

2-bromo-4-(phenylmethyl-d2)pyridine (5.00 g, 20.00 mmol), (1-methyl-7-phenyldibenzo[b,d]thiophen-4-yl)boronic acid (6.36 g, 20.00 mmol), Pd(PPh₃)₄ (1.14 g, 1.00 mmol), and K₂CO₃ (8.29 g, 60.00 mmol) were mixed with 90 mL of THF and 30 mL of DI water, followed by stirring and heating under reflux at 80°C for 18 hours. After the temperature was allowed to lower to room temperature, the organic layer was extracted using MC, anhydrous MgSO₄ was added thereto to remove residual water, and the filtrate obtained by filtration was subjected to reduced pressure to obtain the residual product, which was then purified by column chromatography using EA and hexane at a ratio of 1:2, thereby obtaining 7.72 g (87%) of Compound L2.

### Synthesis of Compound 2

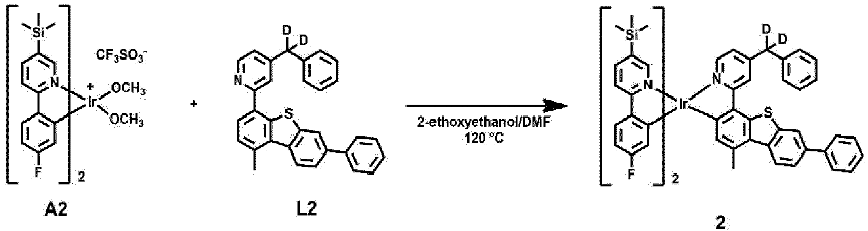

Compound A2 (3.00 g, 3.36 mmol) and Compound L2 (1.49 g, 3.36 mmol) were mixed with 50 mL of 2-ethoxyethanol and 50 mL of N,N-dimethylformamide, and then, the resultant solution was stirred under reflux for 48 hours at a temperature of 120°C. Then, the temperature was allowed to lower to room temperature. After removing the solvents under reduced pressure condition, column chromatography was performed using EA and hexane at a ratio of 1:10 to obtain 0.79 g (21%) of Compound 2. The obtained compound was identified by HRMS (MALDI) and HPLC analysis.

HRMS (MALDI) calculated for C₅₉H₅₀D₂F₂IrN₃SSi₂: m/z: 1123.3143, found: 1123.3102.

### Synthesis Example 3 (Compound 3)

### Synthesis of Compound C3

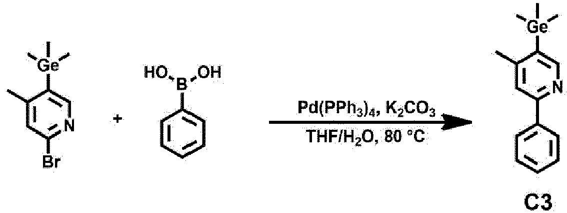

2-bromo-4-methyl-5-(trimethylgermyl)pyridine (5 g, 17.32 mmol), phenylboronic acid (2.11 g, 17.32 mmol), Pd(PPh₃)₄ (1.20 g, 1.04 mmol), and K₂CO₃ (7.18 g, 51.96 mmol) were mixed with 90 mL of tetrahydrofuran (THF) and 30 mL of DI water, and then stirred and heated under reflux at 80°C for 18 hours. After the temperature was allowed to lower to room temperature, the organic layer was extracted using MC, anhydrous MgSO₄ was added thereto to remove residual water, and the filtrate obtained by filtration was subjected to reduced pressure to obtain the residual product, which was then purified by column chromatography using EA and hexane at a ratio of 1:8, thereby obtaining 4.21 g (85%) of Compound C3.

### Synthesis of Compound B3

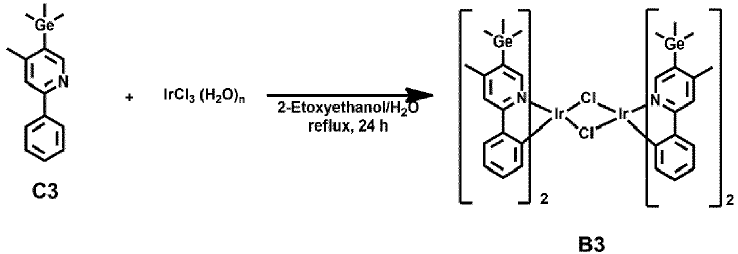

Compound C3 (8.58 g, 30.00 mmol) and iridium chloride hydrate (4.48 g, 15.00 mmol) were mixed with 90 mL of 2-ethoxyethanol and 30 mL of DI water, and then, the mixture was stirred and heated under reflux for 24 hours, and then, the temperature was allowed to lower to room temperature. The resulting solid was separated by filtration, washed sufficiently with DI water, methanol, and hexane, in this stated order, and then dried in a vacuum oven to obtain 7.78 g (65%) of Compound B3.

### Synthesis of Compound A3

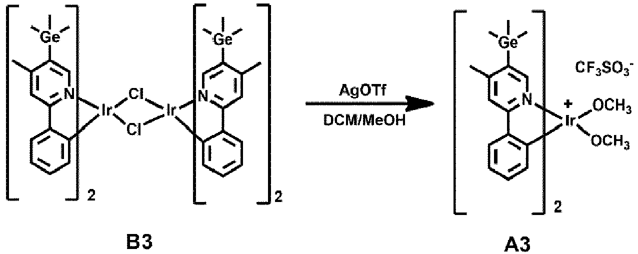

Compound B3 (3.00 g, 1.88 mmol) was mixed with 90 mL of MC, and then, AgOTf (1.01 g, 3.95 mmol) dissolved in 30 mL of methanol was added thereto. Afterwards, the resultant reaction solution was stirred to proceed a reaction at 80°C for 18 hours at room temperature while light was blocked from the reaction solution with aluminum foil, and filtered through CELITE to remove a solid produced therein. The filtrate was then subjected to reduced pressure to obtain a solid (Compound A3) which was used in the next reaction without an additional purification process.

### Synthesis of Compound L3

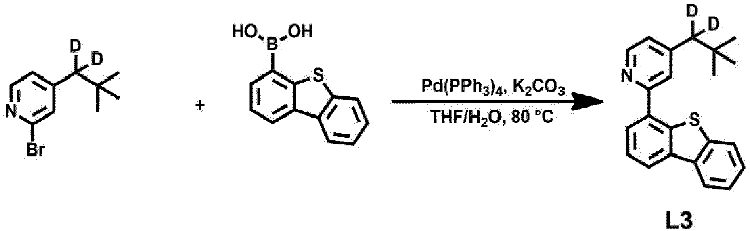

2-bromo-4-(2,2-dimethylpropyl-1,1-d₂)pyridine (5.00 g, 21.73 mmol), dibenzo[b,d]thiophen-4-ylboronic acid (4.96 g, 21.73 mmol), Pd(PPh₃)₄ (1.24 g, 1.09 mmol), and K₂CO₃ (9.01 g, 60.00 mmol) were mixed with 90 mL of THF and 30 mL of DI water, followed by stirring and heating under reflux for 18 hours. After the temperature was allowed to lower to room temperature, the organic layer was extracted using MC, anhydrous MgSO₄ was added thereto to remove residual water, and the filtrate obtained by filtration was exposed to reduced pressure to obtain the residual product, which was then purified by column chromatography using EA and hexane at a ratio of 1:2, thereby obtaining 5.29 g (73%) of Compound L3.

### Synthesis of Compound 3

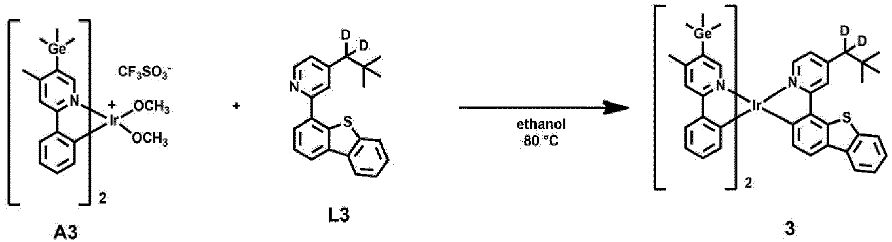

Compound A3 (3.00 g, 3.08 mmol) and Compound L3 (1.03 g, 3.08 mmol) were mixed with 100 mL of ethanol, and the temperature was lowered after the reaction was carried out by stirring under reflux at 80°C for 48 hours. After removing all solvent under reduced pressure, column chromatography was performed using EA and hexanes at the ratio of 1:10 to obtain 1.18 g (35%) of Compound 3. The obtained compound was identified by HRMS (MALDI) and HPLC analysis.

HRMS (MALDI) calculated for C₅₂H₅₄D₂Ge₂IrN₃S: m/z: 1097.2373, found: 1097.2398.

### Synthesis Example 4 (Compound 4)

### Synthesis of Compound C4

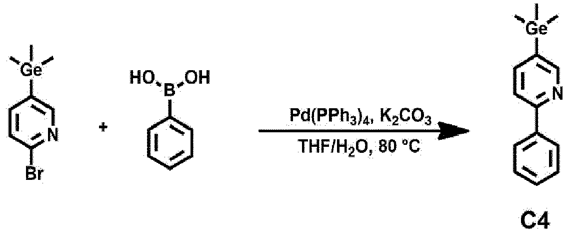

2-bromo-5-(trimethylgermyl)pyridine (5 g, 18.20 mmol), phenylboronic acid (2.22 g, 18.20 mmol), Pd(PPh₃)₄ (1.05 g, 0.91 mmol), and K₂CO₃ (7.55 g, 54.60 mmol) were mixed with 90 mL of THF and 30 mL of DI water, and then stirred and heated under reflux at 80°C for 18 hours. After the temperature was allowed to lower to room temperature, the organic layer was extracted using MC, anhydrous MgSO₄ was added thereto to remove residual water, and the filtrate obtained by filtration was subjected to reduced pressure to obtain the residual product, which was then purified by column chromatography using EA and hexane at a ratio of 1:8, thereby obtaining 4.06 g (82%) of Compound C4.

### Synthesis of Compound B4

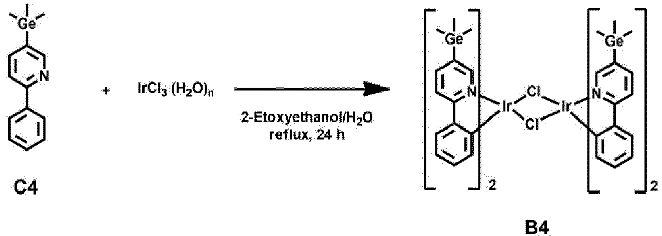

Compound C4 (8.16 g, 30.00 mmol) and iridium chloride hydrate (4.48 g, 15.00 mmol) were mixed with 90 mL of 2-ethoxyethanol and 30 mL of DI water, and then, the mixture was stirred and heated under reflux for 24 hours, and then, the temperature was allowed to lower to room temperature. The resulting solid was separated by filtration, washed sufficiently with DI water, methanol, and hexanes, in this stated order, and then dried in a vacuum oven to obtain 8.43 g (73%) of Compound B4.

### Synthesis of Compound A4

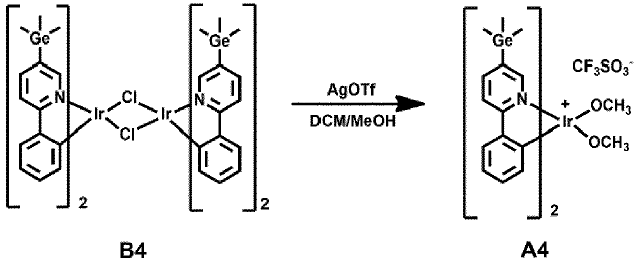

Compound B4 (3.00 g, 1.95 mmol) was mixed with 90 mL of MC, and then, AgOTf (1.05 g, 4.10 mmol) dissolved in 30 mL of methanol was added thereto. Afterwards, the resultant reaction solution was stirred to proceed a reaction for 18 hours at room temperature while light was blocked from the reaction solution with aluminum foil, and filtered through CELITE to remove a solid produced therein. The filtrate was then subjected to reduced pressure to obtain a solid (Compound A4) which was used in the next reaction without an additional purification process.

### Synthesis of Compound L4

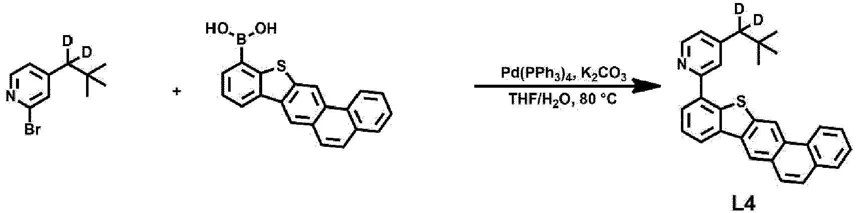

2-bromo-4-(2,2-dimethylpropyl-1,1-d₂)pyridine (5.00 g, 21.73 mmol), benzo[b]phenanthro[2,3-d]thiophen-11-ylboronic acid (7.13 g, 21.73 mmol), Pd(PPh₃)₄ (1.26 g, 1.09 mmol), and K₂CO₃ (9.01 g, 65.19 mmol) were mixed with 90 mL of THF and 30 mL of DI water, followed by stirring and heating under reflux at 80°C for 18 hours. After the temperature was allowed to lower to room temperature, the organic layer was extracted using MC, anhydrous MgSO₄ was added thereto to remove residual water, and the filtrate obtained by filtration was subjected to reduced pressure to obtain the residual product, which was then purified by column chromatography using EA and hexanes at the ratio of 1:10, thereby obtaining 8.29 g (88%) of Compound L4.

### Synthesis of Compound 4

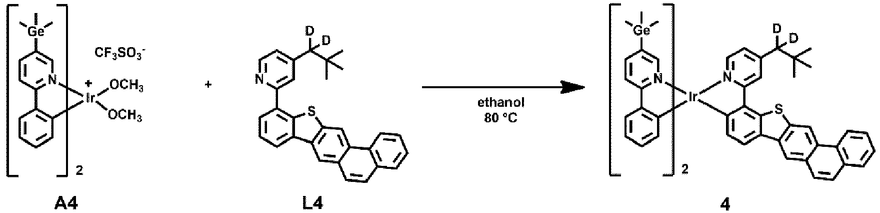

Compound A4 (3.00 g, 3.17 mmol) and Compound L4 (1.37 g, 3.17 mmol) were mixed with 100 mL of ethanol, and the reaction was carried out by stirring and heating under reflux at 80°C for 48 hours, and then the temperature was allowed to lower to room temperature. After removing the solvent under reduced pressure, column chromatography was performed using EA and hexane at a ratio of 1:10 to obtain 1.11 g (30%) of Compound 4. The obtained compound was identified by HRMS (MALDI) and HPLC analysis.

HRMS (MALDI) calculated for C₅₈H₅₄D₂Ge₂IrN₃S: m/z: 1169.2373, found: 1169.2356.

### Example 1

A coated glass substrate with ITO/Ag/ITO (as an anode) deposited thereon to a thickness of 70 Å/1000 A/70 Å was cut to a size of 50 mm x 50 mm x 0.5 mm, sonicated with isopropyl alcohol and DI water each for 5 minutes, and then cleaned by exposure to ultraviolet (UV) rays and ozone for 30 minutes. Then the resultant coated glass substrate was loaded onto a vacuum deposition apparatus.

2-TNATA was vacuum-deposited on the anode to form a hole injection layer having a thickness of 600 Å, and 4,4'-bis[N-(1-naphthyl)-N-phenylamino] biphenyl (hereinafter referred to as NPB) was vacuum-deposited on the hole injection layer to form a hole transport layer having a thickness of 1350 Å.

Next, CBP (host) and Compound 1 (dopant) were co-deposited at a weight ratio of 98:2 on the hole transport layer to form an emission layer having a thickness of 400 Å.

Thereafter, BCP was vacuum-deposited on the emission layer to form a hole-blocking layer having a thickness of 50 Å, Alq₃ was vacuum-deposited on the hole-blocking layer to form an electron transport layer having a thickness of 350 Å, LiF was vacuum-deposited on the electron transport layer to form an electron injection layer having a thickness of 10 Å, and Mg and Ag were co-deposited at a weight ratio of 90:10 on the electron injection layer to form a cathode having a thickness of 120 Å, thereby completing the manufacture of an organic light-emitting device.

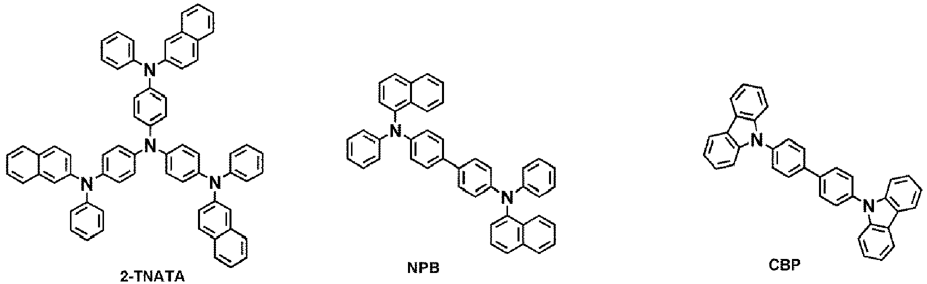

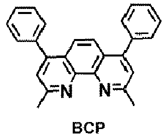

### Examples 2 to 4

Organic light-emitting devices were manufactured in a similar manner as in Example 1, except that Compounds shown in Table 2 were each used instead of Compound 1 as a dopant in forming an emission layer.

### Evaluation Example 1: Characterization of organic light-emitting device

For each of the organic light-emitting devices manufactured in Examples 1 to 4, the driving voltage(V), the maximum value of the external quantum efficiency (Max EQE) (%), and lifespan (LT₉₇) (hr) were evaluated. The results are shown in Table 2 as a relative value (%) with respect to the values of Example 1. A current-voltage meter (Keithley 2400) and a luminance meter (Minolta Cs-1000A) were used as an apparatus for evaluation, the lifespan (LT₉₇) (at 3500 candela per square meter, cd/m² or nits) was obtained by measuring the amount of time (hr) that elapsed until luminance was reduced to 97% of the initial brightness of 100%.

**Table 2**

| | Compound No. of dopant in emission layer | Driving voltage (relative value, %) | Max EQE (relative value, %) | LT97 (relative value, %) (at 3500 nit) |
|---|---|---|---|---|
| Example 1 | 1 | 100 % | 100 % | 100 % |
| Example 2 | 2 | 94% | 93% | 80% |
| Example 3 | 3 | 100 % | 103 % | 105% |
| Example 4 | 4 | 98% | 105% | 115% |

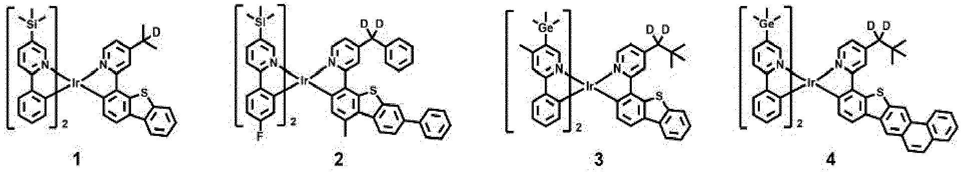

From Table 2, it can be confirmed that the organic light-emitting devices of Examples 1 to 4 have excellent characteristics in terms of driving voltage, external quantum efficiency, and lifespan.

Since the organometallic compounds have excellent electrical characteristics and heat resistance, an electronic device, for example, an organic light-emitting device, using one or more of the organometallic compounds may have excellent characteristics in terms of driving voltage, external quantum efficiency (EQE), and lifespan. Therefore, the use of the organometallic compound(s) may provide a high-quality organic light-emitting device and an electron device including the same.

It should be understood that the exemplary embodiments described herein should be considered in a descriptive sense only and not for purposes of limitation. Descriptions of certain features or aspects within each exemplary embodiment should typically be considered as available for other similar features or aspects in other exemplary embodiments. While one or more embodiments have been described with reference to the FIGURE, it will be understood by those of ordinary skill in the art that various changes in form and details may be made therein without departing from the scope as defined by the following claims.

## Claims

1. An organometallic compound, represented by Formula 1:
Formula 1 M(L₁)ₙ₁(L₂)ₙ₂
wherein, in Formula 1,
M is a transition metal,
L₁ is a ligand represented by Formula 2-1,
L₂ is a ligand represented by Formula 2-2,
n1 and n2 are each independently 1 or 2, wherein, when n1 is 2, each L₁ is identical to or different from another, and when n2 is 2, each L₂ is identical to or different from another,
a sum of n1 and n2 is 2 or 3, and
L₁ and L₂ are different from each other, 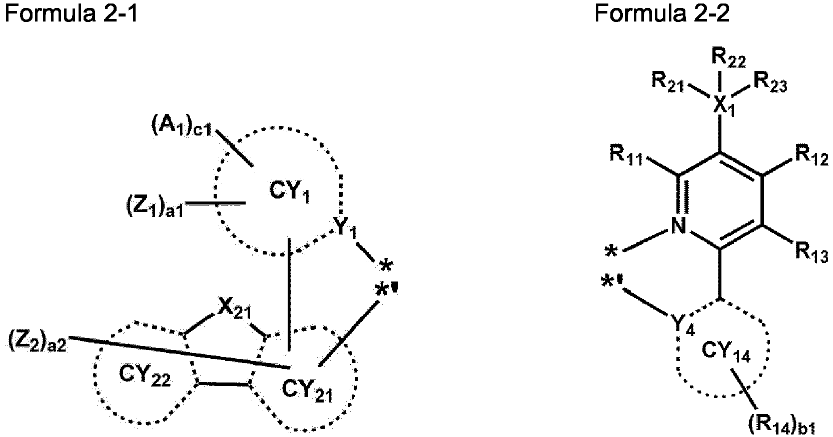 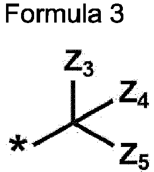
wherein, in Formulae 2-1, 2-2, and 3,
Y₁ and Y₄ are each independently C or N,
X₁ is Si or Ge,
X21 is O, S, S(=O), N(Z29), C(Z₂₉)(Z₃₀), or Si(Z₂₉)(Z₃₀),
ring CY₁, ring CY₂₁, ring CY₂₂, and ring CY₁₄ are each independently a C₅-C₃₀ carbocyclic group or a C₁-C₃₀ heterocyclic group,
A₁ is a group represented by Formula 3, provided that A₁ is not -CD₃,
c1 is an integer from 1 to 20,
R₂₁ to R₂₃ are each independently a C₁-C₆₀ alkyl group or a C₆-C₆₀ aryl group, unsubstituted or substituted with at least one of deuterium, -F, -CI, -Br, -I, -SF₅, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or a combination thereof,
Z₁ to Z₅, R₁₁ to R₁₄, Z₂₉, and Z₃₀ are each independently hydrogen, deuterium, - F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), - B(Q6)(Q7), -P(=O)(Q₈)(Q₉), or -P(Q₈)(Q₉),
provided that at least one of Z₃ to Z₅ of Formula 3 is deuterium or a deuterated group,
provided that in Formula 2-2,
R₁₂ is hydrogen, deuterium, a methyl group, or a deuterated methyl group, or
R₁₂ and R₁₃ are linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
a1, a2, and b1 are each independently an integer from 0 to 20, and when a1 is 2 or more, two or more of Z₁(s) are identical to or different from each other, when a2 is 2 or more, two or more of Z₂(s) are identical to or different from each other, and when b1 is 2 or more, two or more of R₁₄(s) are identical to or different from each other,
two or more of R₂₁ to R₂₃ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of Z₁(S) are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of Z₂(s) are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of Z₃ to Z₅ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₁₄(s) are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of Z₁, Z₂, and R₁₁ to R₁₄ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
R₁₀ₐ is as defined in connection with R₁₄,
* and *' in Formulae 2-1 and 2-2 each indicates a binding site to M in Formula 1,
* in Formula 3 indicates a binding site to ring CY₁ in Formula 2-1, and
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C1-C10 heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), - Si(Q23)(Q24)(Q25), -Ge(Q23)(Q24)(Q25), -B(Q26)(Q27), -P(=O)(Q₂₈)(Q₂₉), -P(Q₂₈)(Q₂₉), or a combination thereof;
-N(Q31)(Q32), -Si(Q₃₃)(Q₃₄)(Q₃₅), -Ge(Q33)(Q34)(Q35), -B(Q36)(Q37), - P(=O)(Q₃₆)(Q₃₉), or -P(Q₃₈)(Q₃₉); or
a combination thereof,
wherein Q1 to Q9, Q11 to Q19, Q21 to Q29, and Q31 to Q39 are each independently: hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

2. The organometallic compound of claim 1, wherein
in Formula 1, M is Ir, and the sum of n1 and n2 is 3; or
in Formula 1, M is Pt, and the sum of n1 and n2 is 2.

3. The organometallic compound of claims 1 or 2, wherein X₂₁ in Formula 2-1 is O or S; and/or
wherein c1 in Formula 2-1 is 1; and/or
wherein ring CY₁ in Formula 2-1 is a pyridine group, a 5,6,7,8-tetrahydroisoquinoline group, or a 5,6,7,8-tetrahydroquinoline group; and/or
wherein ring CY₂₁ in Formula 2-1 is a benzene group, a naphthalene group, a 1,2,3,4-tetrahydronaphthalene group, a pyridine group, or a pyrimidine group.

4. The organometallic compound of any of claims 1-3, wherein ring CY₂₂ in Formula 2-1 is a benzene group, a naphthalene group, a 1,2,3,4-tetrahydronaphthalene group, a phenanthrene group, an anthracene group, a pyridine group, a pyrimidine group, a benzofuran group, a benzothiophene group, a dibenzofuran group, a dibenzothiophene group, an azadibenzofuran group, an azadibenzothiophene group, a quinoline group, an isoquinoline group, a quinoxaline group, a quinazoline group, a benzoquinoline group, a benzoisoquinoline group, a benzoquinoxaline group, or a benzoquinazoline group; and/or
wherein ring CY₁₄ in Formula 2-2 is a benzene group, a naphthalene group, a 1,2,3,4-tetrahydronaphthalene group, a dibenzothiophene group, a dibenzofuran group, or a pyridine group.

5. The organometallic compound of any of claims 1-4, wherein
Z₁ to Z₅, R₁₁, R₁₃, R₁₄, Z₂₉, and Z₃₀ in Formulae 2-1 and 2-2 are each independently:
hydrogen, deuterium, -F, or a cyano group;
a C₁-C₂₀ alkyl group, a C₁-C₂₀ alkoxy group, a C₁-C₂₀ alkylthio group, a C₂-C₂₀ alkenyl group, a phenyl group, a naphthyl group, a pyridinyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), -Ge(Q₃₃)(Q₃₄)(Q₃₅), or a combination thereof; or
-Si(Q3)(Q4)(Q5) or -Ge(Q₃)(Q₄)(Q₅).

6. The organometallic compound of any of claims 1-5, wherein, in Formula 3,
Z₃ is deuterium or a deuterated group, and each of Z₄ and Z₅ is a deuterium-free group;
each of Z₃ and Z₄ is deuterium or a deuterated group, and Z₅ is a deuterium-free group; or
each of Z₃ to Z₅ is deuterium or a deuterated group, provided that at least one of Z₃ to Z₅ is not deuterium.

7. The organometallic compound of any of claims 1-6, wherein
the organometallic compound satisfies at least one of Condition (1) to Condition (3):
Condition (1)
in Formula 2-1, Z₁ is not hydrogen, and a1 is an integer from 1 to 20
Condition (2)
in Formula 2-2, R₁₄ is not hydrogen, and b1 is an integer from 1 to 20
Condition (3)
in Formula 2-1, Z₂ is not hydrogen, and a2 is an integer from 1 to 6.

8. The organometallic compound of any of claims 1-7, wherein, in Formula 2-1,
Z₂ is not hydrogen,
a2 is an integer from 1 to 3, and
at least one of Z₂(s) in the number of a2 is each independently a substituted or unsubstituted C₁-C₆₀ alkyl group, a substituted or unsubstituted C₁-C₆₀ alkoxy group, a substituted or unsubstituted C₁-C₆₀ alkylthio group, a substituted or unsubstituted C₂-C₂₀ alkenyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted monovalent non-aromatic condensed polycyclic group, or a substituted or unsubstituted monovalent non-aromatic condensed heteropolycyclic group.

9. The organometallic compound of any of claims 1-8, wherein a group represented by 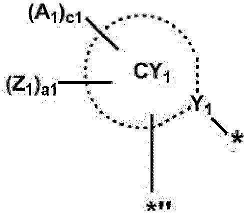 in Formula 2-1 is a group represented by one of Formulae CY1-1 to CY1-10: 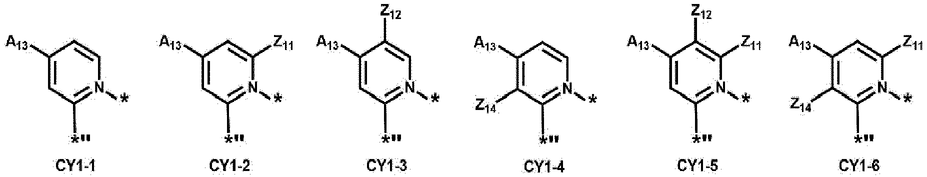 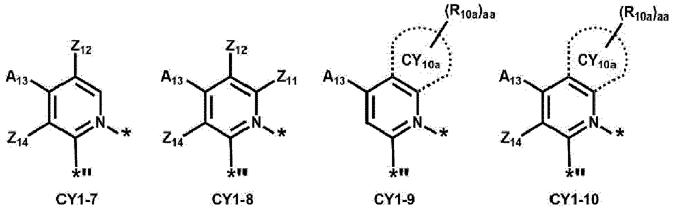
wherein, in Formulae CY1-1 to CY1-10,
Z₁₁, Z₁₂, and Z₁₄ are as defined in connection with Z₁ of claim 1, provided that each of Z₁₁, Z₁₂, and Z₁₄ is not hydrogen,
A₁₃ is as defined in connection with A₁ in claim 1,
ring CY₁₀ₐ is a C₅-C₃₀ carbocyclic group or a C₁-C₃₀ heterocyclic group,
R₁₀ₐ is as defined in connection with R₁₀ₐ in claim 1,
aa is an integer from 0 to 10,
* indicates a binding site to M in Formula 1, and
*" indicates a binding site to ring CY₂₁ in Formula 2-1.

10. The organometallic compound of any of claims 1-9, wherein a group represented by 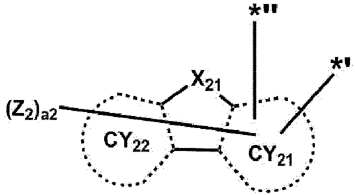 in Formula 2-1 is a group represented by one of Formulae CY2-1 to CY2-6: 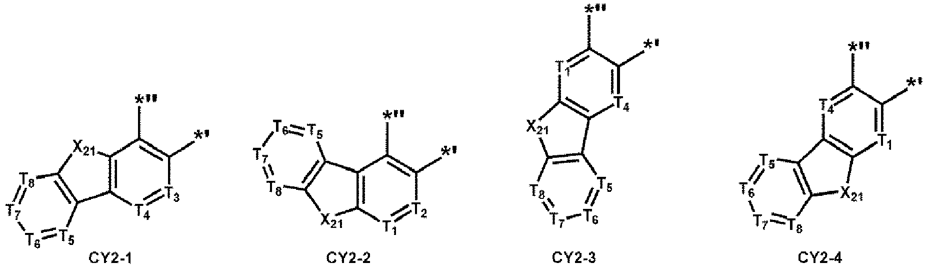 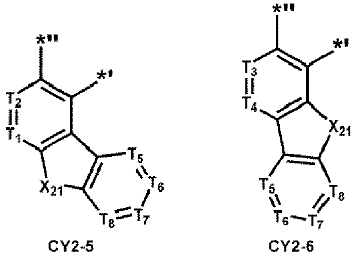
wherein, in Formulae CY2-1 to CY2-6,
T₁ to T₈ are each independently C or N,
X₂₁ is as defined in claim 1,
*" indicates a binding site to ring CY₁ in Formula 2-1, and
*' indicates a binding site to M in Formula 1.

11. The organometallic compound of any of claims 1-10, wherein
a group represented by 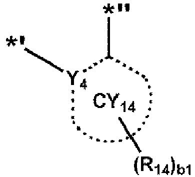 in Formula 2-2 is a group represented by one of Formulae CY14(1) to CY14(63): 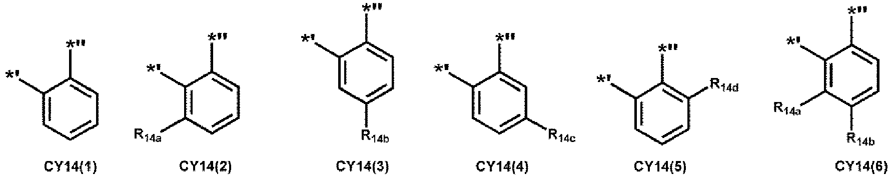 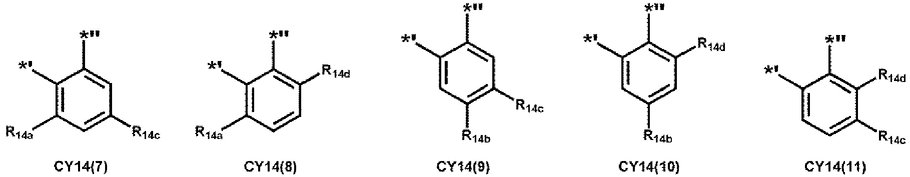 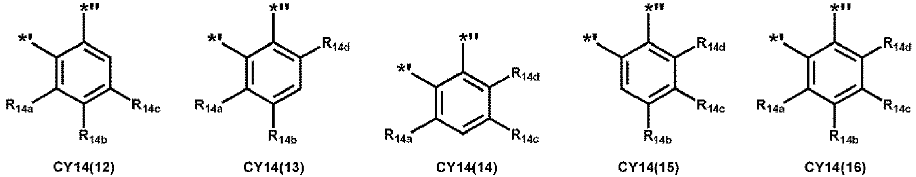 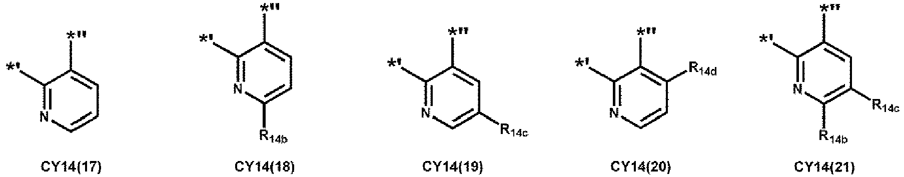 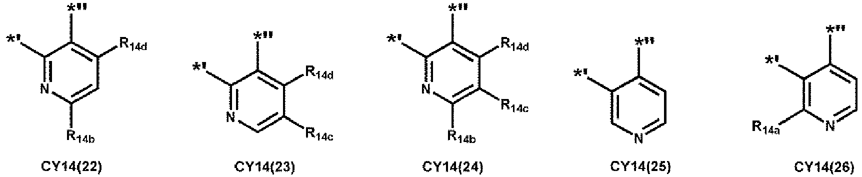 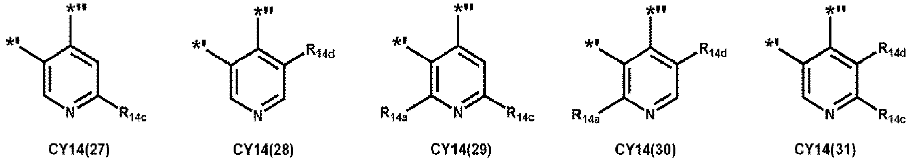 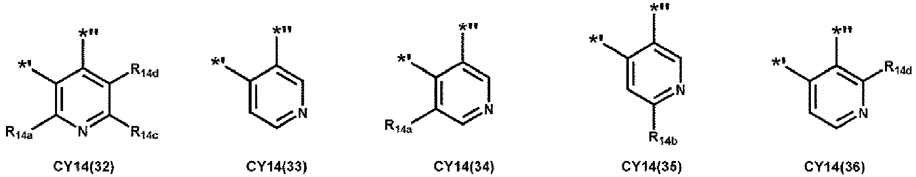 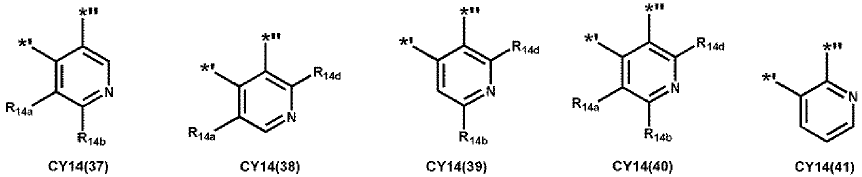 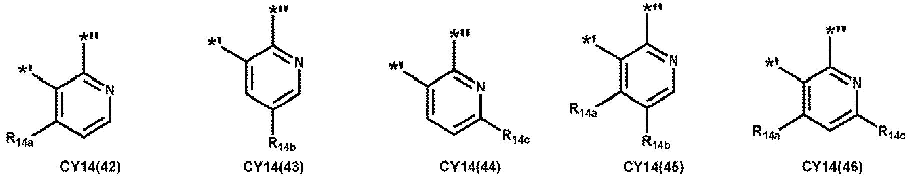 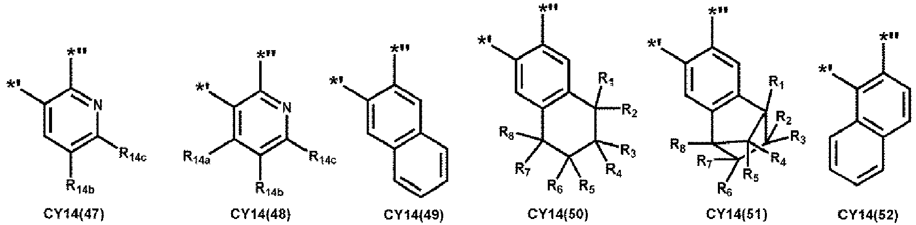 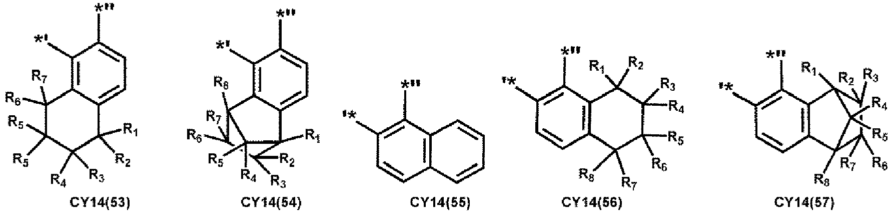 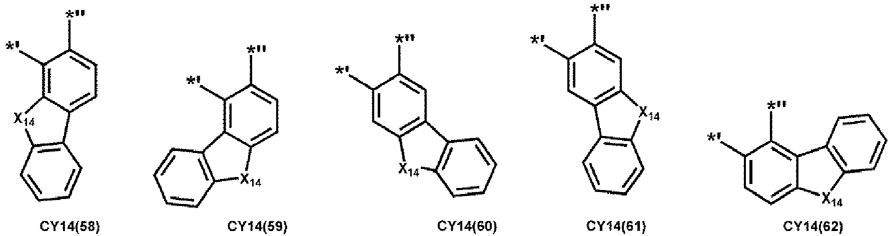 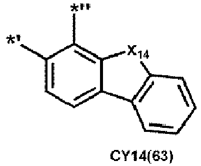
wherein, in Formulae CY14(1) to CY14(63),
R₁₄ₐ to R_{14d} are as defined in connection with R₁₄ in claim 1, provided that each of R₁₄ₐ to R_{14d} is not hydrogen,
X₁₄ is C(R₁)(R₂), N(R₁), O, S, or Si(R₁)(R₂),
R₁ to R₈ are as defined in connection with R₁₄ in claim 1,
*" indicates a binding site to a carbon atom of a neighboring pyridine ring in Formula 2-2, and
*' indicates a binding site to M in Formula 1.

12. An organic light-emitting device, comprising:
a first electrode;
a second electrode; and
an organic layer located between the first electrode and the second electrode and comprising an emission layer, and
wherein the organic layer comprises at least one organometallic compound of any of claims 1-11.

13. The organic light-emitting device of claim 12, wherein
the first electrode is an anode,
the second electrode is a cathode,
the organic layer further comprises a hole transport region located between the first electrode and the emission layer, and an electron transport region located between the emission layer and the second electrode, wherein
the hole transport region comprises a hole injection layer, a hole transport layer, an electron-blocking layer, a buffer layer, or a combination thereof, and
the electron transport region comprises a hole-blocking layer, an electron transport layer, an electron injection layer, or a combination thereof.

14. The organic light-emitting device of claims 12 or 13, wherein the emission layer comprises the at least one organometallic compound;
preferably wherein
the emission layer further comprises a host, and
an amount of the host in the emission layer is greater than an amount of the organometallic compound in the emission layer.

15. An electronic apparatus, comprising the organic light-emitting device of any of claims 12-14.
